(19) Europäisches Patentamt
European Patent Office
Office européen des brevets

(11) **EP 3 496 147 A1**

(12) # EUROPEAN PATENT APPLICATION
published in accordance with Art. 153(4) EPC


(43) Date of publication:
**12.06.2019 Bulletin 2019/24**

(21) Application number: **17836647.2**

(22) Date of filing: **27.06.2017**

(51) Int Cl.:
***H01L 27/146*** *(2006.01)* ***H01L 27/30*** *(2006.01)*
***H01L 51/42*** *(2006.01)* ***H04N 5/369*** *(2011.01)*

(86) International application number:
**PCT/JP2017/023628**

(87) International publication number:
**WO 2018/025540 (08.02.2018 Gazette 2018/06)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **03.08.2016 JP 2016152523**



(71) Applicant: **Sony Corporation**
**Tokyo 108-0075 (JP)**

(72) Inventors:
- **BANDO Masashi**
  **Tokyo 108-0075 (JP)**
- **MOGI Hideaki**
  **Tokyo 108-0075 (JP)**
- **YAGI Iwao**
  **Tokyo 108-0075 (JP)**
- **HIRATA Shintarou**
  **Tokyo 108-0075 (JP)**
- **YAMAGUCHI Tetsuji**
  **Tokyo 108-0075 (JP)**

(74) Representative: **MFG Patentanwälte**
**Meyer-Wildhagen Meggle-Freund**
**Gerhard PartG mbB**
**Amalienstraße 62**
**80799 München (DE)**


(54) **IMAGING ELEMENT, MULTILAYER IMAGING ELEMENT, AND SOLID-STATE IMAGING DEVICE**


(57) An imaging element includes an organic photoelectric conversion layer 13 formed of a mixture of an electron transport material, an organic pigment material, and a hole transport material. The electron transport material has higher electron mobility than the organic pigment material. The hole transport material has higher hole mobility than the organic pigment material. A relation between values of electron affinity of the electron transport material and the organic pigment material, a relation between values of ionization potentials of the hole transport material and the organic pigment material, and a relation between a value of the electron affinity of the electron transport material and a value of an ionization potential of the hole transport material have predetermined relations.


FIG. 1

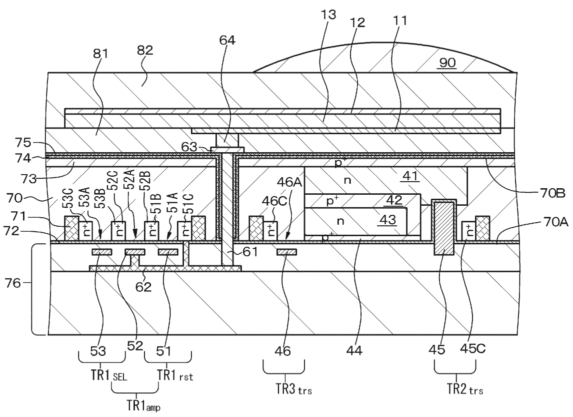


EP 3 496 147 A1

## Description

### Technical Field

The present disclosure relates to an imaging element, a stacked-type imaging element and a solid-state imaging apparatus.

### Background Art

In the related art, semiconductor elements with charge coupled device (CCD) or complementary metal oxide semiconductor (CMOS) structures were mainly used as imaging elements (image sensors). In addition, imaging elements in which photoelectric conversion layers are formed of organic semiconductor materials have recently also been proposed. Imaging elements in which photoelectric conversion layers are formed of organic semiconductor materials, that is, imaging elements including the organic photoelectric conversion layers, can photoelectrically convert specific colors (wavelength bands). In this case, the imaging elements have characteristics. Consequently, in a case in which the imaging elements are used in solid-state imaging apparatuses, subpixels are formed by combinations of on-chip color filters (OCCFs) and the imaging elements and structures in which the subpixels are stacked (stacked-type imaging elements) and which are not realized in solid-state imaging elements of the related art in which subpixels are arrayed 2-dimensionally can be obtained (for example, see JP 2006-100766A). In addition, since demosaic processes are not necessary, there is an advantage that false color is not generated and a dramatic improvement in resolution can be achieved.

In the following description, an imaging element that includes a photoelectric conversion unit provided on or above a semiconductor substrate is referred to as a "first type imaging element" for convenience, a photoelectric conversion unit included in the first type imaging element is referred to as a "first type photoelectric conversion unit" for convenience, an imaging element provided in a semiconductor substrate is referred to as a "second type imaging element" for convenience, and a photoelectric conversion unit included in the second type imaging element is referred to as a "second type photoelectric conversion unit" for convenience in some cases. Here, the first type imaging element includes a stacked structure of a first electrode, an organic photoelectric conversion layer, and a second electrode. For example, the first electrode is formed on an interlayer insulating layer formed on a semiconductor substrate.

### Citation List

### Patent Literature

Patent Literature 1: JP 2006-100766A

### Disclosure of Invention

### Technical Problem

Incidentally, in an imaging element disclosed in the foregoing JP 2006-100766A, it is difficult to obtain an excellent color image in a case in which both spectral characteristics and electric characteristics (specifically, quantum efficiency, dark current, optical response characteristics, and the like) of an organic semiconductor material of the organic photoelectric conversion layer are not desired characteristics. However, it is very difficult to develop organic semiconductor materials satisfying both spectral characteristics and electric characteristics and it is also very difficult to design materials.

Accordingly, an object of the present disclosure is to provide an imaging element configured to enable an improvement in both spectral characteristics and electric characteristics to be achieved and a stacked-type imaging element and a solid-state imaging apparatus including the imaging element.

### Solution to Problem

An imaging element (photoelectric conversion element) of the present disclosure for achieving the foregoing object includes:

a photoelectric conversion unit including a stacked structure of a first electrode, an organic photoelectric conversion layer, and a second electrode,
in which the organic photoelectric conversion layer includes a mixture of an electron transport material, an organic

pigment material, and a hole transport material,
the electron transport material has higher electron mobility than the organic pigment material,
the hole transport material has higher hole mobility than the organic pigment material,
a value $EA_{ET}$ of electron affinity of the electron transport material and a value $EA_{AB}$ of electron affinity of the organic pigment material have a relation expressed in Expression (1-1) below,
a value $IP_{HT}$ of an ionization potential of the hole transport material and a value $IP_{AB}$ of an ionization potential of the organic pigment material have a relation expressed in Expression (1-2) below, and
the value $EA_{ET}$ of electron affinity of the electron transport material and the value $IP_{HT}$ of the ionization potential of the hole transport material have a relation expressed in Expression (1-3) below:

$$EA_{ET} \geq EA_{AB} \quad (1\text{-}1);$$

$$IP_{AB} \geq IP_{HT} \quad (1\text{-}2);$$

and

$$IP_{HT} - EA_{ET} \geq 1.0\ \mathrm{eV} \quad (1\text{-}3).$$

Further, the value of the electron affinity and the value of the ionization potential are set as positive values.
The stacked-type imaging element of the present disclosure for achieving the foregoing object includes at least one imaging element (the photoelectric conversion element) of the present disclosure.
The solid-state imaging apparatus according to the first aspect of the present disclosure for achieving the foregoing object includes a plurality of the imaging elements (photoelectric conversion elements) of the present disclosure. In addition, the solid-state imaging apparatus according to the second aspect of the present disclosure for achieving the foregoing object includes a plurality of the stacked-type imaging elements of the present disclosure.

Advantageous Effects of Invention

In the imaging element (the photoelectric conversion element) of the present disclosure, the imaging element of the present disclosure included in the stacked-type imaging element of the present disclosure, and the imaging element of the present disclosure included in the solid-state imaging apparatus according to the first aspect and the second aspect of the present disclosure (these imaging elements are collectively referred to as an "imaging element or the like of the present disclosure" in some cases below), the organic photoelectric conversion layer is formed of the mixture of the electron transport material, the organic pigment material, and the hole transport material. That is, the organic photoelectric conversion layer has a so-called bulk heterostructure. Therefore, to configure the organic photoelectric conversion layer of each of a blue imaging element, a green imaging element, and a red imaging element, only the organic pigment material may be changed using the same material as the electron transport material and the hole transport material. That is, the material of the organic photoelectric conversion layer is functionally separated. Moreover, the electron transport material may have higher electron mobility than the organic pigment material, the hole transport material may have higher hole mobility than the organic pigment material, and Expression (1-1), Expression (1-2), and Expression (1-3) may be satisfied. Consequently, the material of the organic photoelectric conversion layer satisfying both the spectral characteristics and the electric characteristics can be designed with a high degree of freedom. Further, the advantageous effects described in the present specification are merely exemplary and are not limiting, and additional advantageous may be obtained.

Brief Description of Drawings

FIG. 1 is schematic partial sectional view of an imaging element and stacked-type imaging element of Embodiment 1.
FIG. 2 is an equivalent circuit diagram of the imaging element and stacked-type imaging element of Embodiment 1.
FIG. 3 is an equivalent circuit diagram of the imaging element and stacked-type imaging element of Embodiment 1.
FIG. 4 is a schematic arrangement view of a first electrode forming the imaging element of Embodiment 1 and a transistor forming a control unit.

FIG. 5 is a conceptual diagram of a solid-state imaging apparatus of Embodiment 1.

FIG. 6 is a conceptual diagram of an energy timetable of an electron transport material, an organic pigment material, and a hole transport material of an organic photoelectric conversion layer of Embodiment 1.

FIGS. 7A, 7B, and 7C are conceptual diagrams of relations between exciton dissociation surfaces and energy timetables of the electron transport material, the organic pigment material, and the hole transport material of the organic photoelectric conversion layer of Embodiment 1.

FIG. 8 is an equivalent circuit diagram of a modified example of the imaging element and stacked-type imaging element of Embodiment 1.

FIG. 9 is a schematic arrangement view of the first electrode forming the modified example of the imaging element of Embodiment 1 shown in FIG. 8, and a transistor forming a control unit.

FIG. 10 is schematic partial sectional view of an imaging element and stacked-type imaging element of Embodiment 2.

FIG. 11 is a schematic partial sectional view of an imaging element and a stacked-type imaging element of Embodiment 3.

FIG. 12 is a schematic partial sectional view of a modified example of an imaging element and a stacked-type imaging element of Embodiment 3.

FIG. 13 is a schematic partial sectional view of a modified example of an imaging element of Embodiment 3.

FIG. 14 is a schematic partial sectional view of a modified example of an imaging element of Embodiment 3.

FIG. 15 is a schematic partial sectional view of a modified example of an imaging element and a stacked-type imaging element of Embodiment 1.

FIG. 16 is a conceptual diagram of an example in which a solid-state imaging apparatus formed of the imaging element and stacked-type imaging element according to an embodiment of the present disclosure is used in an electronic device (camera) 200.

FIG. 17 is a block diagram depicting an example of schematic configuration of a vehicle control system.

FIG. 18 is a diagram of assistance in explaining an example of installation positions of an outside-vehicle information detecting section and an imaging section.

FIG. 19 is a view depicting an example of a schematic configuration of an endoscopic surgery system.

FIG. 20 is a block diagram depicting an example of a functional configuration of a camera head and a camera control unit (CCU).

FIG. 21 is a block diagram depicting an example of a schematic configuration of an in-vivo information acquisition system.

Mode(s) for Carrying Out the Invention

Hereinafter, the present disclosure will be described with reference to the drawings according to embodiments. However, the present disclosure is not limited to the embodiments and various numerical values or materials in the embodiments are exemplary. Further, the description will be made in the following order.

1. General description of imaging element of present disclosure, stacked-type imaging element of present disclosure, and solid-state imaging apparatus according to first aspect and second aspect of present disclosure
2. Embodiment 1 (imaging element of present disclosure, stacked-type imaging element of present disclosure, and solid-state imaging apparatus according to second aspect of present disclosure)
3. Embodiment 2 (modification of Embodiment 1)
4. Embodiment 3 (modification of Embodiment 1 and Embodiment 2, solid-state imaging apparatus according to first aspect of present disclosure)
5. Embodiment 4 (application example to mobile body)
6. Embodiment 5 (application example to mobile body)
7. Embodiment 6 (application example to in-vivo information acquisition system)
8. Others

<General description of imaging element of present disclosure, stacked-type imaging element of present disclosure, and solid-state imaging apparatus according to first aspect and second aspect of present disclosure>

In an imaging element or the like of the present disclosure, an organic pigment material may be configured from one type of material or may be configured from two or more types of materials, a plurality of types of materials. In addition, an electron transport material for transporting electrons may be configured from one type of material or may be configured from a plurality of two or more types of materials. Moreover, a hole transport material for transporting holes may be configured from one type of material or may be configured from a plurality of two or more types of materials. In a case in which the organic pigment material, the electron transport material, and the hole transport material are

configured from a plurality of two or more types of materials, various regulations to be described below are required to be satisfied for all the organic pigment materials configured from the plurality of types of materials, all the electron transport materials configured from the plurality of types of materials, and all the hole transport materials configured from the plurality of types of materials.

In the imaging element or the like of the present disclosure, the following may be satisfied:

$$EA_{HT} \leq EA_{ET} \text{ and } IP_{HT} \leq IP_{ET}.$$

In the imaging element or the like of the present disclosure including the foregoing preferred mode, the following may be satisfied,

$$0.5\ eV \leq IP_{ET} - IP_{HT} \leq 0.7\ eV \quad (2\text{-}1),$$

further, in this case, the following can be satisfied,

$$0.3\ eV \leq IP_{AB} - IP_{HT} \leq 1.1\ eV \quad (2\text{-}2\text{-}A),$$

or

$$0.3\ eV \leq EA_{ET} - EA_{AB} \leq 1.1\ eV\ (2\text{-}2\text{-}B).$$

Moreover, in the imaging element or the like of the present disclosure including the above-described various preferred modes, in wavelengths of 450 mm to 700 mm, a maximum value of an optical absorption coefficient of the organic pigment material may be greater than a value of an optical absorption coefficient of the electron transport material, greater than a value of an optical absorption coefficient of the hole transport material, or greater than the values of the optical absorption coefficients of the electron transport material and the hole transport material.

Moreover, in the imaging element or the like of the present disclosure including the above-described various preferred modes, a first charge injection block layer may be provided between a first electrode and an organic photoelectric conversion layer. Moreover, a first intermediate layer (a first carrier transport layer) may be provided between the first charge injection block layer and the organic photoelectric conversion layer. Moreover, the first intermediate layer (the first carrier transport layer) may include an electron transport material.

Moreover, in the imaging element or the like of the present disclosure including the above-described various preferred modes and configurations, a second charge injection block layer may be provided between a second electrode and the organic photoelectric conversion layer. Moreover, a second intermediate layer (a second carrier transport layer) may be provided between the second charge injection block layer and the organic photoelectric conversion layer. Moreover, the second intermediate layer (the second carrier transport layer) may include a hole transport material.

Moreover, in the imaging element or the like of the present disclosure including the above-described various preferred modes and configurations, when $\mu_{max}$ is carrier mobility of a material with the fastest carrier mobility among the materials of the organic photoelectric conversion layer, the following may be satisfied:

$$1\times10^{-5}cm^2/V\cdot s \leq \mu_{max} \leq 1\times10^{-1}cm^2/V\cdot s \quad (3).$$

Moreover, in the imaging element or the like of the present disclosure including the above-described various preferred modes and configurations, the organic pigment material preferably contains a subphthalocyanine derivative expressed in the following structure Formula (10).

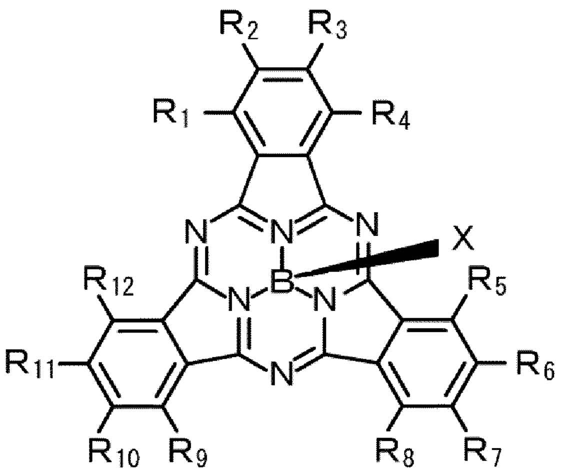

(10)

Here, X and R1 to R12 are each independently at least one type of group selected from a group composed of a hydrogen atom; and a halogen atom including chlorine and fluorine; or a linear, branched or cyclic alkyl group or phenyl group; a linear or condensed aromatic ring; a partial fluoroalkyl group; a perfluoroalkyl group; a silylalkyl group; a silylalkoxy group; an arylsilyl group; a thioalkyl group; a thioaryl group; an arylsulfonyl group; an alkylsulfonyl group; an amino group; an alkylamino group; an arylamino group; a hydroxy group; an alkoxy group; an acylamino group; an acyloxy group; a phenyl group; a carboxy group, a carboxamide group, a carboalkoxy group, an acyl group; a sulfonyl group; a cyano group; and a nitro group. A bivalent or trivalent metal may also be used instead of B (boron).

Moreover, in the imaging element or the like of the present disclosure including the above-described various preferred modes and configurations, the photoelectric conversion unit may be disposed above a semiconductor substrate. The first electrode included in the imaging element may be connected to a charge storage portion (a floating diffusion layer) formed in the semiconductor substrate to store a charge generated in the organic photoelectric conversion layer and a gate portion of an amplification transistor formed in the semiconductor substrate. Further, an amplification transistor is included in a control unit provided in the semiconductor substrate. In this configuration, a reset transistor and a select transistor included in the control unit are further provided in the semiconductor substrate. The charge storage portion may be connected to one of source and drain regions of the reset transistor. One of source and drain regions of the amplification transistor may be connected to one of source and drain regions of the select transistor and the other of the source and drain regions of the select transistor may be connected to a signal line.

Incidentally, as a method of reducing dark current in the imaging element, a scheme of suppressing carrier injection from an electrode by disposing the charge injection block layer (a buffer layer) between the electrode and the organic photoelectric conversion layer is generally used. For example, when electrons are extracted, a difference between a work function of an electrode (cathode) and an ionization potential of the charge injection block layer is increased to suppress injection of holes. When holes are extracted, a difference between a work function of an electrode (anode) and electron affinity of the charge injection block layer is increased to suppress injection of electrons. However, when this difference is equal to or greater than a certain value, the dark current tends to remain and is not reduced. This is because a dominant factor of the dark current is switched from carrier injection from an electrode to carrier generation in the organic photoelectric conversion layer interposed between electrodes. That is, in the organic photoelectric conversion layer, excitons generated due to light irradiation are not dissociated with the degree of energy of room temperature but are dissociated using an energy difference of an interface between a p-type semiconductor and an n-type semiconductor. Therefore, from the viewpoint of improving sensitivity, a bulk heterostructure that includes a p-type semiconductor and an n-type semiconductor is generally used in order to increase the interface. However, since the pn interface may be a carrier generation source, suppressing generation of carriers in the organic photoelectric conversion layer occupying a relatively large volume in the imaging element is considered to be indispensable for suppressing dark current. In the organic photoelectric conversion layer formed of the organic pigment material, the hole transport material, and the electron transport material, free carriers are generated at the interface between a material with the smallest ionization potential and a material with the largest electron affinity. That is, the generation of the dark current is suppressed in accordance with the magnitude of an effective band gap energy defined by a difference between an ionization potential of a hole transport material and electron affinity of an electron transport material. Accordingly, by increasing the effective band gap energy, it is possible to reduce the dark current.

That is, in the imaging element or the like of the present disclosure, the foregoing Expression (1-3), that is, the following expression, has been provided as a regulation:

$$IP_{HT}-EA_{ET} \geq 1.0 \text{ eV} \quad (1\text{-}3),$$

consequently, the dark current can be efficiently reduced.

Further, the foregoing Expression (1-1) and Expression (1-2), that is, the following expressions, have been provided as regulations:

$$EA_{ET} \geq EA_{AB} \quad (1\text{-}1);$$

and

$$IP_{AB} \geq IP_{HT} \quad (1\text{-}2).$$

Consequently, an influence of a transfer barrier is rarely given when holes generated in the organic pigment material transition to the hole transport material and an influence of a transfer barrier is rarely given when electrons generated in the organic pigment material transition to the electron transport material. In addition, at least one exciton dissociation surface (separation surface) can be reliably formed.

Examples of factors that have an influence on a carrier generation rate in the organic photoelectric conversion layer include carrier mobility in the organic photoelectric conversion layer. The carrier generation rate depends on the carrier mobility $\mu_{max}$ of the material with the fastest carrier mobility among the materials of the organic photoelectric conversion layer. In this case, as described above, it is preferable to satisfy Expression (3) from the viewpoint of improving photoresponsivity.

In contrast, the increase in the effective band gap energy becomes a tradeoff factor against an improvement in photoelectric conversion efficiency in some cases. This is because excitons generated due to light irradiation are dissociated at the interface between the hole transport material and the organic pigment material, the interface between the organic pigment material and the electron transport material, or the interface between the hole transport material and the electron transport material (a case in which energy of excitons generated in the organic pigment material moves to the hole transport material or the electron transport material), photoelectric conversion efficiency is changed with a widened width of the effective band gap energy in some cases. Accordingly, as described above, the following is preferably satisfied,

$$0.5 \text{ eV} \leq IP_{ET}-IP_{HT} \leq 0.7 \text{ eV} \quad (2\text{-}1),$$

and

$$0.3 \text{ eV} \leq IP_{AB}-IP_{HT} \leq 1.1 \text{ eV} \quad (2\text{-}2\text{-}A),$$

or

$$0.3 \text{ eV} \leq EA_{ET}-EA_{AB} \leq 1.1 \text{ eV} \quad (2\text{-}2\text{-}B).$$

In addition, in a case in which the organic pigment material with an absorption peak with respect to a wavelength of incident light absorbs light, molecules react with remaining oxygen or water in the organic photoelectric conversion layer in an excited state (a chemically activated state) by optical absorption or decomposition of the organic pigment material by the energy of the light, and thus degeneration (impurities) of the materials of the organic photoelectric conversion layer occurs in some cases. In addition, since the impurities generated in this way act as a charge trap in some cases, the carrier mobility of the organic pigment material decreases due to light irradiation in a structure in which the organic pigment material simultaneously takes charge of optical absorption and carrier transport, and thus deterioration in photoelectric conversion efficiency and optical response characteristics is considered to be caused. In contrast, in the imaging element or the like of the present disclosure, the transparent hole transport material and electron transport material with no absorption peak with respect to the wavelength of incident light are used. Thus, since a function such as optical absorption of the organic pigment material and a function such as carrier conduction of the hole transport

material and the electron transport material are separated and the hole transport material and the electron transport material do not absorb light, degeneration is difficult and the deterioration in photoelectric conversion efficiency and optical response characteristics caused due to the light irradiation can be considerably improved.

The second electrode located on a light incidence side may be common to the plurality of imaging elements. That is, the second electrode can be used as a so-called solid electrode. The first electrode is provided for each imaging element. The organic photoelectric conversion layer may be common to the plurality of imaging elements or may be provided for each imaging element.

In the imaging element or the like of the present disclosure including the above-described various preferred modes and configurations, light may be incident from the second electrode side and a light shielding layer may be formed on the light incidence side in the second electrode. Examples of materials of the light shielding layer include chrome (Cr), copper (Cu), aluminum (Al), and tungsten (W).

Specific examples of the imaging element according to an embodiment of the present disclosure include an imaging element (for convenience, referred to as a "first-type blue imaging element") having an organic photoelectric conversion layer which absorbs blue light (light of 425 nm to 495 nm) (for convenience, referred to as a "first-type blue organic photoelectric conversion layer") and having sensitivity to blue, an imaging element (for convenience, referred to as a "first-type green imaging element") having an organic photoelectric conversion layer which absorbs green light (light of 495 nm to 570 nm) (for convenience, referred to as a "first-type green organic photoelectric conversion layer") and having sensitivity to green, and an imaging element (for convenience, referred to as a "first-type red imaging element") having an organic photoelectric conversion layer which absorbs red light (light of 620 nm to 750 nm) (for convenience, referred to as a "first-type red organic photoelectric conversion layer") and having sensitivity to red. Further, in the conventional imaging element, an imaging element sensitive to blue is, for convenience, referred to as "second type blue imaging element", and an imaging element sensitive to green is, for convenience, referred to as "second type green imaging element", an imaging element sensitive to red is, for convenience, referred to as "second type red imaging element", a photoelectric conversion layer forming the second type blue imaging element is, for convenience, referred to as "second type blue photoelectric conversion layer", a photoelectric conversion layer forming the second type green imaging element is, for convenience, referred to as "second type green photoelectric conversion layer", and a photoelectric conversion layer forming the second type red imaging element is, for convenience, referred to as "second type red photoelectric conversion layer."

The stacked-type imaging element according to an embodiment of the present disclosure includes at least one imaging element (photoelectric conversion element) according to an embodiment of the present disclosure, and specific examples thereof include:

[A] the configuration and structure in which the first type blue organic photoelectric conversion unit, the first type green organic photoelectric conversion unit and the first type red organic photoelectric conversion unit are stacked in the vertical direction, and
each of the control units of the first type blue imaging element, the first type green imaging element, and the first type red imaging element is provided on the semiconductor substrate;
[B] the configuration and structure in which the first type blue organic photoelectric conversion unit and the first type green organic photoelectric conversion unit are stacked in the vertical direction,
the second-type red photoelectric conversion layer is disposed below these two layers of the first type organic photoelectric conversion units,
and each of the control units of the first type blue imaging element, the first type green imaging element, and the second type red imaging element is provided on the semiconductor substrate;
[C] the configuration and structure in which the second-type blue photoelectric conversion unit and the second-type red photoelectric conversion unit are disposed below the first-type green organic photoelectric conversion unit,
and each of the control units of the first type green imaging element, the second type blue imaging element, and the second type red imaging element is provided on the semiconductor substrate; and
[D] the configuration and structure in which the second-type green photoelectric conversion unit and the second-type red photoelectric conversion unit are disposed below the first-type blue organic photoelectric conversion unit,
and each of the control units of the first type blue imaging element, the second type green imaging element, and the second type red imaging element is provided on the semiconductor substrate.

One pixel is formed by the stacked structure of these imaging elements. Furthermore, the first-type infrared organic photoelectric conversion unit may be provided. Here, it is preferable that the organic photoelectric conversion layer of the first-type infrared photoelectric conversion unit may be formed of an organic material, and is the lowermost layer of the stacked structure of the first-type imaging element, and is disposed above the second-type imaging element. Alternatively, the second-type infrared photoelectric conversion unit may be provided below the first-type organic photoelectric conversion unit.

In the first type imaging element, for example, the first electrode is formed on the interlayer insulating layer provided on the semiconductor substrate. The imaging element formed on the semiconductor substrate may be of a back surface illuminated type or of a front surface illuminated type. As described above, the organic photoelectric conversion layer has a bulk heterostructure. With the solid-state imaging apparatus according to the first to second aspects of the present disclosure, a single-plate type color solid-state imaging apparatus may be formed.

The hole transport material has higher hole mobility than the organic pigment material and preferably has highest hole mobility among the materials of the organic photoelectric conversion layer. Specific examples of the hole transport material include thiophene derivatives, benzothieno-benzothiophene derivatives, ferrocene derivatives, paraphenylenevinylene derivatives, carbazole derivatives, pyrrole derivatives, aniline derivatives, diamine derivatives, phthalocyanine derivatives, subphthalocyanine derivatives, hydrozone derivatives, naphthalene derivatives, anthracene derivatives, phenanthrene derivatives, pyrene derivatives, perylene derivatives, tetracene derivatives, pentacene derivatives, quinacridone derivatives, thienothiophene derivatives, benzothiophene derivatives, triallylamine derivatives, perylene derivatives, picene derivatives, chrysene derivatives, fluoranthene derivatives, subporphyrazine derivatives, a metallic complex having a heteocyclic compound as a ligand, polythiophene derivatives, polybenzothiadiazole derivatives, polyfluorene derivatives. These materials have advantages of relatively high mobility and easy design of a hole transport property. Moreover, specific examples of materials of the second charge injection block layer or the second intermediate layer can include the above-described hole transport materials.

The electron transport material has higher electron mobility than the organic pigment material and preferably has the highest electron mobility among the materials of the organic photoelectric conversion layer. Examples of electron transport materials include, for example, fullerenes (higher fullerene) such as $C_{60}$, $C_{70}$, $C_{74}$ fullerenes or the like, endohedral fullerene or the like, fullerene derivatives (e.g., fullerene fluoride, PCBM fullerene compound, fullerene polymer, etc.)), oxazole derivatives, oxadiazole derivatives, or triazole derivatives. Further, it includes a heterocyclic compound containing a nitrogen atom, an oxygen atom and a sulfur atom, for example, organic molecules and organometallic complexes having pyridine derivatives, pyrazine derivatives, pyrimidine derivatives, triazine derivatives, quinoline derivatives, quinoxaline derivatives, isoquinoline derivatives, acridine derivatives, phenazine derivatives, phenanthroline derivatives, tetrazole derivatives, pyrazole derivatives, imidazole derivatives, thiazole derivatives, imidazole derivatives, benzimidazole derivatives, benzotriazole derivatives, benzoxazole derivatives, benzoxazole derivatives, carbazole derivatives, benzofuran derivatives, dibenzofuran derivatives, subporphyrazine derivative, polyphenylene vinylene derivatives, polybenzothiadiazole derivatives, polyfluorene derivatives and the like a part of the molecular skeleton, and subphthalocyanine derivatives, and such materials are recognized to be advantageous to have a relatively high mobility and to be easy to design electron transport properties. Examples of a functional group or the like included in fullerene derivatives include a halogen atom; a linear, branched or cyclic alkyl group or phenyl group; a functional group having a linear or condensed aromatic compound; a functional group having a halide; a partial fluoroalkyl group; a perfluoroalkyl group; a silylalkyl group; a silylalkoxy group; an arylsilyl group; an arylsulfanyl group; an alkylsulfanyl group; an arylsulfonyl group; an alkylsulfonyl group; an arylsulfide group; an alkylsulfide group; an amino group; an alkylamino group; an arylamino group; a hydroxy group; an alkoxy group; an acylamino group; an acyloxy group; a carbonyl group; a carboxy group; a carboxamide group; a carboalkoxy group; an acyl group; a sulfonyl group; a cyano group; a nitro group; a functional group having a chalcogenide; a phosphine group; a phosphonic group; derivatives thereof. Further, as the material of the first charge injection block layer or the first intermediate layer, specifically, the above-described electron transport material can be exemplified.

Since the organic pigment material is photoelectrically converted in a desired color gamut, an absorption spectrum is important. In order to match an absorption end to the desired color gamut, for example, it is necessary to set a band gap energy to about 1.9 eV in the case of red, about 2.0 eV in the case of green, and about 2.5 eV in the case of blue. Here, specific examples of the organic pigment material include phthalocyanine derivatives, subphthalocyanine derivatives, quinacridone-based derivatives, naphthalocyanine derivatives, squarylium derivatives, etc. In the first-type blue organic photoelectric conversion layer, the first-type green organic photoelectric conversion layer, and the first-type red organic photoelectric conversion layer, the same material may be used as the electron transport material and the hole transport material and only the organic pigment material may be changed. Here, examples of the material forming an organic photoelectric conversion layer that photoelectrically converts light of green wavelength include rhodamine-based pigment, melacyanine-based pigment, quinacridone-based derivative, subphthalocyanine-based pigment (subphthalocyanine derivative), etc. Examples of the material forming an organic photoelectric conversion layer that photoelectrically converts light of blue wavelength include coumarinic acid pigment, tris-8-hydricoxyquinoline aluminum (Alq3), melacyanin-based pigment, etc. Examples of the material forming an organic photoelectric conversion layer that photoelectrically converts light of red wavelength include phthalocyanine-based pigment and subphthalocyanine-based pigment (subphthalocyanine derivative). Further, the "organic pigment material" in the present specification contains an organic pigment material and widely contains an organic optical absorption material.

A mixture ratio of the electron transport material, the organic pigment material, and the hole transport material in the organic photoelectric conversion layer can be exemplified as follows:

the organic pigment material: 30 volume % to 80 volume %;
the electron transport material: 10 volume % to 35 volume %; and
the hole transport material: 10 volume % to 60 volume %,
(here, a total of 100 volume %).

A thickness of the organic photoelectric conversion layer is not limited and is, for example, $1\times10^{-8}$m to $5\times10^{-7}$m and preferably $2.5\times10^{-8}$m to $3\times10^{-7}$m.

In the solid-state imaging apparatus according to the second aspect of the present disclosure including the stacked-type imaging element, unlike the solid-state imaging apparatus including the Bayer-array imaging element (i.e., spectroscopy for blue, green, and red is not performed using a color filter), elements having sensitivity to light of plural types of wavelengths are stacked in the light incidence direction in the same pixel to form one pixel, and thus improvement of sensitivity and pixel density per unit volume can be achieve. Furthermore, since an organic material has a high absorption coefficient, a film thickness of a photoelectric conversion layer can be thinner as compared to a conventional Si-based photoelectric conversion layer, and light leakage from adjacent pixels and restriction on the light incidence angle can be alleviated. Moreover, since the conventional Si-based imaging element produces color signals by performing interpolation processing among three-color pixels, false color is generated, but false color can be suppressed in the solid-state imaging apparatus according to the second aspect of the present disclosure including the stacked-type imaging element. Further, since the organic photoelectric conversion layer itself functions as a color filter, color separation can be performed without disposing a color filter.

On the other hand, in the solid-state imaging apparatus according to the first aspect of the present disclosure, due to using a color filter, the request for spectral characteristics of blue, green and red can be alleviated, and moreover, mass productivity is high. Examples of the arrangement of the imaging element in the solid-state imaging apparatus according to the first aspect of the present disclosure include an interline arrangement, a G stripe-RB checkered array, a G stripe-RB full-checkered array, a checkered complementary color array, a stripe array, a diagonal stripe array, a primary color difference array, a field color difference sequential array, a flame color difference sequential array, an MOS-type array, a modified MOS-type array, a flame interleave array and a field interleave array in addition to a Bayer array. Here, one pixel (or subpixel) is formed by one imaging element.

A pixel region in which a plurality of the imaging elements according to an embodiment of the present disclosure or the stacked-type imaging elements according to an embodiment of the present disclosure are arrayed is formed of a plurality of pixels regularly arranged in a two-dimensional array. Generally, the pixel region includes an effective pixel region which actually receives light, amplifies the signal charges generated by photoelectric conversion and reads it out to the drive circuit, and a black reference pixel region for outputting optical black serving as a reference of a black level. The black reference pixel region is generally disposed at the outer peripheral portion of the effective pixel region.

In the imaging element or the like according to an embodiment of the present disclosure including various preferred modes and configurations described above, light is radiated, photoelectric conversion is generated on the organic photoelectric conversion layer, carriers including holes and electrons are separated. Further, an electrode from which holes are extracted is referred to as an anode, and an electrode from which electrons are extracted is defined as a cathode. The first electrode may form an anode, and the second electrode may form a cathode, or reversely, the first electrode may form a cathode, and the second electrode may form an anode.

In the case of forming a stacked-type imaging element, the first electrode and the second electrode can be formed of a transparent conductive material. Alternatively, in a case where the image imaging element or the like according to an embodiment of the present disclosure is arranged on a plane, for example, as in a Bayer array, the second electrode may be formed of a transparent conductive material and the first electrode or the like may be formed of a metal material. In this case, specifically, the second electrode located on the light incident side may be formed of a transparent conductive material and the first electrode or the like may be formed of, for example, Al-Nd (alloy of aluminum and neodymium) or ASC (alloy of aluminum, silicon and copper). Further, an electrode formed of a transparent conductive material may be referred to as a "transparent electrode." Here, the band gap energy of the transparent conductive material is 2.5 eV or more, and preferably, 3.1 eV or more. Examples of a transparent conductive material forming an transparent electrode include conductive metal oxides, and specific examples thereof include indium oxide, indium-tin oxide (ITO including Sn-doped $In_2O_3$, crystalline ITO and amorphous ITO), indium-zinc oxide (IZO) in which indium is added to zinc oxide as a dopant, indium-gallium oxide (IGO) in which indium is added to gallium oxide as a dopant, indium-gallium-zinc oxide (IGZO, $In\text{-}GaZnO_4$) in which indium and gallium are added to zinc oxide as a dopant, IFO (F-doped $In_2O_3$), tin oxide ($SnO_2$), ATO (Sb-doped $SnO_2$), FTO (F-doped $SnO_2$), zinc oxide (including ZnO doped with other elements), aluminum-zinc oxide (AZO) in which aluminum is added to zinc oxide as a dopant, gallium-zinc oxide (GZO) in which gallium is added to zinc oxide as a dopant, titanium oxide ($TiO_2$), antimony oxide, spinel type oxide, an oxide having a $YbFe_2O_4$ structure. Alternatively, a transparent electrode having a base layer of gallium oxide, titanium oxide, niobium oxide, nickel oxide or the like may be given as an example. The thickness of the transparent electrode may be $2\times10^{-8}$ m to $2\times10^{-7}$ m, preferably $3\times10^{-8}$ m to $1\times10^{-7}$ m.

Alternatively, in a case where transparency is unnecessary, a conductive material forming an anode having a function as an electrode for extracting holes is preferably a conductive material having a high work function (e.g., φ=4.5 eV to 5.5 eV), and specific examples thereof include gold (Au), silver (Ag), chromium (Cr), nickel (Ni), palladium (Pd), platinum (Pt), iron (Fe), iridium (Ir), germanium (Ge), osmium (Os), rhenium (Re), tellurium (Te). On the other hand, a conductive material forming an cathode having a function as an electrode for extracting electrons is preferably a conductive material having a low work function (e.g., φ=3.5 eV to 4.5 eV), and specific examples thereof include alkali metals (e.g., Li, Na, K, etc.) and the fluorides or oxides thereof, alkaline earth metals (e.g., Mg, Ca, etc.) and the fluorides or oxides thereof, aluminum (Al), zinc (Zn), tin (Sn), thallium (Tl), a sodium-potassium alloy, an aluminum-lithium alloy, a magnesium-silver alloy, indium and rare earth metals such as ytterbium, or alloys thereof. Alternatively, examples of the material forming an anode or cathode include metals such as platinum (Pt), gold (Au), palladium (Pd), chromium (Cr), nickel (Ni), aluminum (Al), silver (Ag), tantalum (Ta), tungsten (W), copper (Cu), titanium (Ti), indium (In), tin (Sn), iron (Fe), cobalt (Co), molybdenum (Mo) or the like, or alloys including these metal elements, as conductive particles formed of these metals, conductive particles of alloys containing these metals, polysilicon containing impurities, carbon-based materials, oxide semiconductors, conductive materials such carbon nanotubes, graphene and the like, and a laminated structure of layers containing these elements. Furthermore, examples of the material forming an anode or cathode include organic materials (conductive polymers) such as poly(3,4-ethylenedioxythiophene)/polystyrenesulfonic acid [PEDOT/PSS]. Further, a paste or ink prepared by mixing these conductive materials into a binder (polymer) may be cured to be used as an electrode.

A dry method or wet method may be used as a film-forming method of the first electrode or the like (anode) and the second electrode (cathode). Examples of the dry method include a physical vapor deposition method (PVD method) and a chemical vapor deposition method (CVD) method. Examples of the film-forming method using the principle of PVD method include a vacuum evaporation method using resistance heating or high frequency heating, an electron beam (EB) evaporation method, various sputtering methods (magnetron sputtering method, RF-DC coupled bias sputtering method, ECR sputtering method, facing-target sputtering method and high frequency sputtering method), an ion plating method, a laser ablation method, a molecular beam epitaxy method, and a laser transfer method. Furthermore, examples of the CVD method include a plasma CVD method, a thermal CVD method, an organic metal (MO) CVD method, and a photo CVD method. On the other hand, examples of the wet method include an electrolytic plating method and an electroless plating method, a spin coating method, an ink jet method, a spray coating method, a stamping method, a micro contact printing method, a flexographic printing method, an offset printing method, a gravure printing method, a dipping method, etc. As for patterning, chemical etching such as shadow mask, laser transfer, photolithography and the like, physical etching by ultraviolet light, laser and the like may be used. Examples of a planarization technique for the first electrode and second electrode include a laser planarization method, a reflow method, a chemical mechanical polishing (CMP) method, etc.

The configuration and structure of the amplification transistor, reset transistor and select transistor forming the control unit may be the same as the conventional amplification transistor, reset transistor and select transistor. The charge storage portion (the floating diffusion layer) can be configured from a high-concentration impurity region provided in the semiconductor substrate. Also, the drive circuit may have well-known configuration and structure.

Examples of materials forming the interlayer insulating layer or the insulating layer include inorganic insulating materials exemplified by silicon oxide-based materials; silicon nitride (SiNy); a metal oxide high-dielectric constant insulating film such as aluminum oxide ($Al_2O_3$) or the like as well as organic insulating materials (organic polymers) exemplified by polymethyl methacrylate (PMMA); polyvinyl phenol (PVP); polyvinyl alcohol ($PV_A$); polyimide, polycarbonate (PC); polyethylene terephthalate (PET); polystyrene; silanol derivatives (silane coupling agents) such as N-2(aminoethyl)3-aminopropyltrimethoxysilane (AEAPTMS), 3-mercaptopropyltrimethoxysilane (MPTMS), octadecyltrichlorosilane (OTS) or the like; straight-chain hydrocarbons having a functional group capable of bonding to the control electrode at one end such as octadecanethiol, dodecyl isocyanate and the like, and combinations thereof. In addition, examples of the silicon oxide-based materials include silicon oxide (SiOx), BPSG, PSG, BSG, AsSG, PbSG, silicon oxynitride (SiON), spin-on-glass (SOG), and low dielectric constant materials (e.g., polyaryl ether, cycloperfluorocarbon polymers and benzocyclobutene, cyclic fluoro resins, polytetrafluoroethylene, fluoroaryl ether, fluorinated polyimide, amorphous carbon and organic SOG).

The first electrode is connected to the charge storage portion (the floating diffusion layer) and the gate section of the amplification transistor, and a contact hole portion may be formed to connect the first electrode to the charge storage portion and the gate section of the amplification transistor. Examples of a material forming the contact hole portion include a high melting point metal such as tungsten, Ti, Pt, Pd, Cu, TiW, TiN, TiNW, $WSi_2$, $MoSi_2$ or the like, metal silicide, or a stacked structure of layers formed of these materials (e.g., Ti/TiN/W).

A dry film formation method and a wet film formation method may be given as examples of a film-forming method for various organic layers including an organic photoelectric conversion layer. Examples of the dry film formation method include a vacuum deposition method using resistance heating, high frequency or electron beam heating, a flash deposition method, a plasma deposition method, an EB deposition method, various sputtering method (bipolar sputtering

method, direct current sputtering method, DC magnetron sputtering method, RF-DC coupled bias sputtering method, ECR sputtering method, facing-target sputtering method, high frequency sputtering method and ion beam sputtering method), a DC (direct current) method, an RF method, a multi-cathode method, an activation reaction method, an electric field vapor deposition method, a high-frequency ion plating method and a reactive ion plating method, a laser ablation method, a molecular beam epitaxy method, a laser transfer method, and a molecular beam epitaxy (MBE) method. Furthermore, examples of a chemical vapor deposition (CVD) method include a plasma CVD method, a thermal CVD method, an MOCVD method, and a photo CVD method. On the other hand, as a coating method, a spin coating method; a dipping method; a casting method; a micro contact printing method; a drop casting method; various printing methods such as a screen printing method, an ink jet printing method, an offset printing method, a gravure printing method and a flexographic printing method; a stamping method; a spray coating method; various coating methods such as an air doctor coater method, a blade coater method, a rod coater method, a knife coater method, a squeeze coater method, a reverse roll coater method, a transfer roll coater method, a gravure coater method, a kiss coater method, a cast coater method, a spray coater method, a slit orifice coater method and a calendar coater method. Further, examples of a solvent in the coating method include a nonpolar or low polar organic solvents such as toluene, chloroform, hexane, and ethanol. As for patterning, chemical etching such as shadow mask, laser transfer, photolithography and the like, physical etching by ultraviolet light, laser and the like may be used. Examples of a planarization technique for various organic layers include a laser planarization method, a reflow method, etc.

In the imaging element or the solid-state imaging apparatus, other than the above, as necessary, an on-chip microlens or a light shielding layer may be provided, or a drive circuit and wiring for driving the imaging element are provided. A shutter for controlling the incidence of light to the imaging element may be provided as necessary, or an optical cut filter may be provided according to the purpose of the solid-state imaging apparatus.

For example, in a case where the solid-state imaging apparatus is stacked with a readout integrated circuit (ROIC), the stacking may be performed by overlaying a drive substrate on which a readout integrated circuit and a connection portion formed of copper (Cu) are formed and an imaging element on which a connection portion is formed such that the connection portions are in contact with each other, and joining the connection portions, and it is also possible to join the connection portions using a solder bump or the like.

[Embodiment 1]

Embodiment 1 relates to an imaging element of the present disclosure, a stacked-type imaging element of the present disclosure, and a solid-state imaging apparatus according to the second aspect of the present disclosure.

FIG. 1 is schematic partial sectional view of an imaging element and stacked-type imaging element of Embodiment 1. FIGS. 2 and 3 are equivalent circuit diagrams of the imaging element and the stacked-type imaging element of Embodiment 1. FIG. 4 is a schematic arrangement view of a first electrode forming the imaging element of Embodiment 1 and a transistor forming a control unit. FIG. 5 is a conceptual diagram of a solid-state imaging apparatus of Embodiment 1.

The imaging element (the photoelectric conversion element and specifically, for example, a green image element to be described below) of Embodiment 1 includes a photoelectric conversion unit that has a stacked structure of a first electrode 11, an organic photoelectric conversion layer 13, and a second electrode 12. In addition, the organic photoelectric conversion layer 13 is formed of a mixture of an electron transport material, an organic pigment material, and a hole transport material. The electron transport material has higher electron mobility than the organic pigment material. The hole transport material has higher hole mobility than the organic pigment material,

Moreover, a value $EA_{ET}$ of electron affinity of the electron transport material and a value $EA_{AB}$ of electron affinity of the organic pigment material have Expression (1-1) below, a value $IP_{HT}$ of an ionization potential of the hole transport material and a value $IP_{AB}$ of an ionization potential of the organic pigment material have Expression (1-2) below, the value $EA_{ET}$ of electron affinity of the electron transport material and the value $IP_{HT}$ of the ionization potential of the hole transport material have Expression (1-3) below:

$$EA_{ET} \geq EA_{AB} \quad (1\text{-}1);$$

$$IP_{AB} \geq IP_{HT} \quad (1\text{-}2);$$

and

$$IP_{HT} - EA_{ET} \geq 1.0 \text{ eV} \quad (1\text{-}3).$$

In addition, in the imaging element of Embodiment 1, $EA_{HT} \leq EA_{ET}$ and $IP_{HT} \leq IP_{ET}$ are satisfied.

In addition, the following is satisfied:

$$0.5\ eV \leq IP_{ET} - IP_{HT} \leq 0.7\ eV \quad (2\text{-}1).$$

Moreover, the following is satisfied:

$$0.3\ eV \leq IP_{AB} - IP_{HT} \leq 1.1\ eV \quad (2\text{-}2\text{-}A),$$

or

$$0.3\ eV \leq EA_{ET} - EA_{AB} \leq 1.1\ eV \quad (2\text{-}2\text{-}B).$$

In Embodiment 1, the organic photoelectric conversion layer 13 has a bulk heterostructure. As a mixture ratio of the electron transport material, the organic pigment material, and the hole transport material, the electron transport material: the organic pigment material: the hole transport material = 30 volume %: 40 volume %: and 30 volume % can be exemplified, but the present disclosure is not limited to this value. Values of the electron affinity EA and the ionization potential IP of the materials are shown in Table 1 below. In addition, FIG. 6 is a conceptual diagram of an energy timetable of the electron transport material, the organic pigment material, and the hole transport material of the organic photoelectric conversion layer of Embodiment 1. FIGS. 7A, 7B, and 7C are conceptual diagrams of relations between exciton dissociation surfaces (separation surfaces) and energy timetables of the electron transport material, the organic pigment material, and the hole transport material of the organic photoelectric conversion layer of Embodiment 1. Moreover, fullerene (C60) was used as the electron transport material and a subphthalocyanine derivative (F6-SubPc-F) shown in structure Formula (11) was used as the organic pigment material.

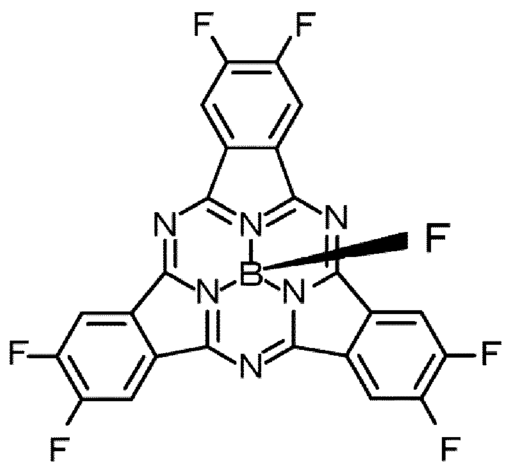

(11)

<Table 1>

| | EA (eV) | IP (eV) |
|---|---|---|
| Electron transport material | 4.5 | 6.3 |
| Organic pigment material | 4.3 | 6.4 |
| Hole transport material | 2.9 | 5.6 |

$$EA_{ET} - EA_{AB} = 4.5 - 4.3 > 0$$

$$IP_{AB} - IP_{HT} = 6.4 - 5.6 > 0$$

$$IP_{HT}-EA_{ET}=5.6-4.5>1.0$$

In addition, the stacked-type imaging element of Embodiment 1 includes at least one imaging element of Embodiment 1. Moreover, the solid-state imaging apparatus of Embodiment 1 includes the plurality of stacked-type imaging element of Embodiment 1.
In addition, in wavelengths of 450 nm to 700 nm, a maximum value of an optical absorption coefficient of the organic pigment material is greater than a value of an optical absorption coefficient of the electron transport material, greater than a value of an optical absorption coefficient of the hole transport material, or greater than the values of the optical absorption coefficients of the electron transport material and the hole transport material. Specifically, the values of the optical absorption coefficients of these materials are shown in Table 2 below. The electron transport material and the hole transport material have no optical absorption peak with respect to the visible light.

<Table 2>

Maximum value of optical absorption coefficient of organic pigment material: $2.2\times10^5cm^{-1}$
Value of optical absorption coefficient of electron transport material: $1.0\times10^5cm^{-1}$
Value of optical absorption coefficient of hole transport material: $8.6\times10^4cm^1$

Moreover, when $\mu_{max}$ is carrier mobility of a material with fastest carrier mobility among the materials of the organic photoelectric conversion layer 13, The following is satisfied:

$$1\times10^{-5}cm^2/V\cdot s\leq\mu_{max}\leq1\times10^{-1}cm^2/V\cdot s.$$

Dark current and conversion efficiency of the imaging element were evaluated at a field intensity in which a value obtained by removing an applied voltage at an inter-electrode distance was $1\times10^5$ volts/cm. In addition, the conversion efficiency was evaluated with monochromatic light with a wavelength of 560 nm. Ionization potentials of the materials of the organic photoelectric conversion layer were evaluated using an ultraviolet photoelectron spectroscopy and electron affinity was decided using optical band gaps obtained from absorption edge wavelengths of the materials and the values of the obtained ionization potentials.
The dark current in various evaluation imaging elements was measured and it was understood that the dark current was reduced with an increase in effective band gap energy defined as a difference between the ionization potential $IP_{HT}$ of the hole transport material and the electron affinity $EA_{ET}$ of the electron transport material. That is, when Expression (1-3) was satisfied, it was understood that the reduction in the dark current was achieved. In addition, it was understood that the conversion efficiency had maximum values with respect to the ionization potential $IP_{ET}$ of the electron transport material and the ionization potential $IP_{HT}$ of the hole transport material and the ionization potential $IP_{AB}$ of the organic pigment material and the ionization potential $IP_{HT}$ of the hole transport material, a difference in the ionization potential between the materials was each suitable to be set to 0.5 eV to 0.7 eV as in Expression (2-1), 0.3 eV to 1.1 eV as in Expression (2-2-A), or 0.3 eV to 1.1 eV as in Expression (2-2-B), and a difference in the electron affinity between the materials was suitable to be set to 0.3 eV to 1.1 eV.
Moreover, the following first to fourth configurations can be adopted.
<First configuration>

the second electrode 12
the second charge injection block layer
the organic photoelectric conversion layer 13
the first charge injection block layer
the first electrode 11

<Second configuration>

the second electrode 12

the second charge injection block layer (the electron injection block layer)
the second intermediate layer (for example, the hole transport layer)

the organic photoelectric conversion layer 13
the first charge injection block layer (the hole injection block layer)
the first electrode 11

<Third configuration>

the second electrode 12
the second charge injection block layer (the electron injection block layer)
the organic photoelectric conversion layer 13

the first intermediate layer (for example, the electron transport layer)
the first charge injection block layer (the hole injection block layer)

the first electrode 11

<Fourth configuration>

the second electrode 12

the second charge injection block layer (the electron injection block layer)
the second intermediate layer (for example, the hole transport layer)

the organic photoelectric conversion layer 13

the first intermediate layer (for example, the electron transport layer)
the first charge injection block layer (the hole injection block layer)

the first electrode 11

By providing an intermediate layer (a carrier transport layer) including the hole transport material or the electron transport material of the organic photoelectric conversion layer between the charge injection block layer and the organic photoelectric conversion layer in contact with each electrode, it is possible to suppress dark current generated at the interface between the charge injection block layer and the organic photoelectric conversion layer. As a result obtained by measuring the dark current, it was confirmed that the dark current was reduced by providing the electron transport layer including the electron transport material between the organic photoelectric conversion layer and the hole injection block layer as in the third configuration, compared to an imaging element including no electron transport layer. Similarly, the dark current reduction effect was also confirmed by providing the hole transport layer including the hole transport material between the electron injection block layer and the organic photoelectric conversion layer as in the second configuration, compared to an imaging element including no hole transport layer. Further, as in the fourth configuration, an imaging element that has a structure in which both the electron transport layer and the hole transport layer are disposed in the electrode and the organic photoelectric conversion layer is more suitable from the viewpoint of reducing the dark current.

From the viewpoint of photoelectric conversion efficiency, the electron affinity EA of the hole injection block layer is preferably equal to or greater than the electron affinity EA of the electron transport material and the ionization potential IP of the electron injection block layer is preferably equal to or less than the ionization potential IP of the hole transport material so that a transfer barrier of carriers generated in the organic photoelectric conversion layer is not formed. However, in this structure, an interface involved in the carrier generation is less than in the organic photoelectric conversion layer, but there is a possibility of an effective band gap energy at the interface being less than the effective band gap energy in the organic photoelectric conversion layer and having a magnitude which is not negligible for the dark current generated in the organic photoelectric conversion layer. An effect obtained by disposing the carrier transport layer can be ascertained as a result obtained by suppressing generation of the dark current at the interface between the organic photoelectric conversion layer and the charge injection block layer by causing the effective band gap energy at the interface between the organic photoelectric conversion layer and the charge injection block layer to be equal to the effective band gap energy in the organic photoelectric conversion layer.

For an imaging element that has the second configuration, imaging elements in which volume ratios of the hole transport material, the organic pigment material, and the electron transport material of the organic photoelectric conversion layer were different were each manufactured. Then, dark current was measured and optical response characteristics were obtained. Here, the optical response characteristics were defined as a time until an optical current generated at

the time of light irradiation is optically blocked and then is attenuated up to 10%. In addition, mobility of carrier type of faster one between hole and electron in the imaging element was measured on the basis of the Photo-CELIV method.

As a result, it was confirmed that an optical response time decreases and the dark current increases with an increase in the carrier mobility. In light of the fact that a recombination model of the imaging element is of the Langevin type, it is considered that generation of the dark current in the organic photoelectric conversion layer is accelerated due to an increase in the carrier mobility since a generation rate of the generation of the dark current in the organic photoelectric conversion layer increases in accordance with a speed of the carrier mobility. From this result, it was understood that the increased carrier mobility $\mu_{max}$ in the organic photoelectric conversion layer preferably compatible between the dark current and the optical response characteristics preferably satisfies Expression (3).

A reliability test of the imaging element of Embodiment 1 was carried out. In the reliability test, after an white LED with the imaging element was irradiated at power of 1 milliwatt/cm$^2$ with a light emission spectrum of 400 nm to 700 nm for 10 hours, change rates from the conversion efficiency and an initial stage of the optical response time were evaluated at a field intensity in which a value obtained by removing an applied voltage at an inter-electrode distance was $1\times10^5$ volts/cm.

As a result, in the imaging element of Embodiment 1, a suppression effect of deterioration in the photoelectric conversion efficiency and the optical response characteristics after the light irradiation was confirmed irrespective of the organic pigment material, the hole transport material, and the electron transport material. In a case in which the organic pigment material with an absorption peak with respect to a wavelength of incident light absorbs light, molecules react with remaining oxygen or water in the organic photoelectric conversion layer in an excited state (a chemically activated state) by optical absorption or decomposition of the material by the energy of the light, and thus degeneration occurs and impurities are generated. Since the impurities generated in this way operate as a charge trap in some cases, the carrier mobility of the organic pigment material decreases due to light irradiation in a structure in which the organic pigment material simultaneously takes charge of optical absorption and carrier transport, and thus deterioration in photoelectric conversion efficiency and optical response characteristics is considered to be caused. In contrast, in the imaging element of Embodiment 1, the transparent hole transport material and electron transport material with no absorption peak with respect to the wavelength of incident light are used. Thus, the functions of the optical absorption and the carrier conduction are separated and it is possible to considerably suppress the deterioration in the photoelectric conversion efficiency and optical response characteristics with the light irradiation. Moreover, the absorption coefficients of the hole transport material and the electron transport material are preferably less than the absorption coefficient of the organic pigment material in the wavelength of 450 nm to 700 nm and the larger one between the absorption coefficients of the hole transport material and the electron transport material in the wavelength of 450 nm to 700 nm is more preferably equal to or less than 0.46 multiples of the absorption coefficient of the organic pigment material.

In the imaging element of Embodiment 1, a control unit which is provided on the semiconductor substrate (more specifically, a silicon semiconductor layer) 70 and to which the first electrode 11 is connected is further included, and the photoelectric conversion unit is disposed above the semiconductor substrate 70. Here, the light incidence surface of the semiconductor substrate 70 is defined as an above side, and the opposite side of the semiconductor substrate 70 is defined as a below side. A wiring layer 62 formed of a plurality of wirings is disposed below the semiconductor substrate 70. Furthermore, the semiconductor substrate 70 further includes at least a charge storage portion (a floating diffusion layer $FD_1$) and an amplification transistor $TR1_{amp}$ forming the control unit, and the first electrode 11 is connected to the gate section of the floating diffusion layer $FD_1$ and the amplification transistor $TR1_{amp}$. The charge storage portion (the floating diffusion layer $FD_1$) stores the charges generated in the organic photoelectric conversion layer 13. The semiconductor substrate 70 further includes a reset transistor $TR1_{rst}$ and select transistor $TR1_{sel}$ forming the control unit. Furthermore, the floating diffusion layer $FD_1$ is connected to a source/drain region of one side of the reset transistor $TR1_{rst}$, and a source/drain region of one side of the amplification transistor $TR1_{amp}$ is connected to a source/drain region of one side of the select transistor $TR1_{sel}$, and a source/drain region of another side of the select transistor $TR1_{sel}$ is connected to the signal line $VSL_1$.

Specifically, the imaging element and stacked-type imaging element of Embodiment 1 are back surface illuminated type imaging element and stacked-type imaging element, and have a structure in which a first-type green imaging element of Embodiment 1 (hereinafter, referred to as "first imaging element") having a first-type green organic photoelectric conversion layer which absorbs green light and having sensitivity to green, a second-type conventional blue imaging element (hereinafter, referred to as "second imaging element") having a second-type photoelectric conversion layer which absorbs blue light and having sensitivity to blue, and a second-type conventional red imaging element (hereinafter, referred to as "third imaging element") having a second-type photoelectric conversion layer which absorbs red light and having sensitivity to red are stacked. Here, the red imaging element (third imaging element) and the blue imaging element (second imaging element) are provided in the semiconductor substrate 70, and the second imaging element is located more closer to the light incident side as compared to the third imaging element. Furthermore, the green imaging element (first imaging element) is provided above the blue imaging element (second imaging element). One pixel is formed by the stacked structure of the first imaging element, the second imaging element, and the third

imaging element. No color filter is provided.

In the first imaging element, the first electrode 11 is formed on an interlayer insulating layer 81. The organic photoelectric conversion layer 13 is formed on the first electrode 11 and the second electrode 12 is formed on the organic photoelectric conversion layer 13. A protective layer 82 is formed on the entire surface including the second electrode 12 and an on-chip microlens 90 is provided on the protective layer 82. The first electrode 11 and the second electrode 12 are configured as, for example, transparent electrodes formed of ITO. The interlayer insulating layer 81 and the protective layer 82 are formed of a known insulating material (for example, $SiO_2$ or SiN).

An element separation region 71 is formed on the side of the first surface (front surface) 70 A of the semiconductor substrate 70, and an oxide film 72 is formed on the first surface 70A of the semiconductor substrate 70. Moreover, a reset transistor $TR1_{rst}$, an amplification transistor $TR1_{amp}$ and select transistor $TR1_{sel}$ forming the control unit of the first imaging element are provided on the side of the first surface of the semiconductor substrate 70, and a first floating diffusion layer $FD_1$ is further provided.

The reset transistor $TR1_{rst}$ is formed of a gate section 51, a channel forming region 51A and source/drain regions 51B and 51C. The gate section 51 of the reset transistor $TR1_{rst}$ is connected to the reset line $RST_1$, and the source/drain region 51C of one side of the reset transistor $TR1_{rst}$ also functions as the first floating diffusion layer $FD_1$, and the source / drain region 51B of another side is connected to the power supply $V_{DD}$.

The first electrode 11 is connected to a source/drain region 51C (first floating diffusion layer $FD_1$) of one side of the reset transistor $TR1_{rst}$ via a connection hole 64 and a pad portion 63 provided in the interlayer insulating layer 81, a contact hole portion 61 formed in the semiconductor substrate 70 and the interlayer insulating layer 76, and the wiring layer 62 formed in the interlayer insulating layer 76.

The amplification transistor $TR1_{amp}$ is formed of the gate section 52, the channel forming region 52A and the source/drain regions 52B and 52C. The gate section 52 is connected to the first electrode 11 and the source/drain region 51C (first floating diffusion layer $FD_1$) of one side of the reset transistor $TR1_{rst}$ through the wiring layer 62. Furthermore, the source/drain region 52B of one side shares a region with the source/drain region 51B of another side forming the reset transistor $TR1_{rst}$, and is connected to power supply $V_{DD}$.

The select transistor $TR1_{sel}$ is formed of the gate section 53, the channel forming region 53A and the source/drain regions 53B and 53C. The gate section 53 is connected to the select line $SEL_1$. Furthermore, the source/drain region 53B of one side shares a region with the source/drain region 52C of another side forming the amplification transistor $TR1_{amp}$, and the source/drain region 53C is connected to the signal line (data output line) $VSL_1$ 117.

The second imaging element includes an n-type semiconductor region 41 provided in the semiconductor substrate 70 as a photoelectric conversion layer. The gate section 45 of the transfer transistor $TR2_{trs}$ formed of the vertical transistor extends to the n-type semiconductor region 41 and is connected to the transfer gate line $TG_2$. Furthermore, a second floating diffusion layer $FD_2$ is provided in a region 45C of the semiconductor substrate 70 near the gate section 45 of the transfer transistor $TR2_{trs}$. Charges stored in the n-type semiconductor region 41 are read out to the second floating diffusion layer $FD_2$ via a transfer channel formed along the gate section 45.

In the second imaging element, the reset transistor $TR2_{trs}$, the amplification transistor $TR2_{amp}$ p and the select transistor $TR2_{sel}$ forming the control unit of the second imaging element are further provided on the first surface side of the semiconductor substrate 70.

The reset transistor $TR2_{trs}$ is formed of the gate section, the channel forming region and the source/drain region. The gate section of the reset transistor $TR2_{trs}$ is connected to the reset line $RST_2$, and a source/drain region of one side of the reset transistor $TR2_{trs}$ is connected to the power supply $V_{DD}$, and a source/drain region of another side also functions as a second a floating diffusion layer $FD_2$.

The amplification transistor $TR2_{amp}$ is formed of the gate section, the channel forming region and the source/drain region. The gate section is connected to a source/drain region (second floating diffusion layer $FD_2$) of another side of the reset transistor $TR2_{trs}$. Furthermore, a source/drain region of one side shares a region with a source/drain region of one side forming the reset transistor $TR2_{trs}$, and is connected to the power supply $V_{DD}$.

The select transistor $TR2_{sel}$ is formed of the gate section, the channel forming region and the source/drain region. The gate section is connected to the select line $SEL_2$. Furthermore, a source/drain region of one side shares a region with a source/drain region of another side forming the amplification transistor $TR2_{amp}$, and a source/drain region of another side is connected to the signal line (data output line) $VSL_2$.

The third imaging element has an n-type semiconductor region 43 provided in the semiconductor substrate 70 as a photoelectric conversion layer. The gate section 46 of the transfer transistor $TR3_{trs}$ is connected to the transfer gate line $TG_3$. Furthermore, a third floating diffusion layer $FD_3$ is provided in a region 46C of the semiconductor substrate 70 near the gate section 46 of the transfer transistor $TR3_{trs}$. Charges stored in the n-type semiconductor region 43 are read out to the third floating diffusion layer $FD_3$ via a transfer channel 46A formed along the gate section 46.

In the third imaging element, the reset transistor $TR3_{rst}$, the amplification transistor $TR3_{amp}$ and the select transistor $TR3_{SEL}$ forming the control unit of the third imaging element are further provided on the first surface side of the semiconductor substrate 70.

The reset transistor $TR3_{rst}$ is formed of the gate section, the channel forming region and the source/drain region. The gate section of the reset transistor $TR3_{rst}$ is connected to the reset line $RST_3$, and a source/drain region of one side of the reset transistor $TR3_{rst}$ is connected to the power supply $V_{DD}$, and a source/drain region of another side also functions as the third floating diffusion layer $FD_3$.

The amplification transistor $TR3_{amp}$ is formed of the gate section, the channel forming region and the source/drain region. The gate section is connected to the source/drain region (third floating diffusion layer $FD_3$) of another side of the reset transistor $TR3_{rst}$. Furthermore, a source/drain region of one side shares a region with a source/drain region of one side forming the reset transistor $TR3_{rst}$, and is connected to the power supply $V_{DD}$.

The select transistor $TR3_{SEL}$ is formed of the gate section, the channel forming region and the source/drain region. The gate section is connected to the select line $SEL_3$. Furthermore, a source/drain region of one side shares a region with a source/drain region of another side forming the amplification transistor $TR3_{amp}$, and a source/drain region of another side is connected to the signal line (data output line) $VSL_3$.

Reset lines $RST_1$, $RST_2$ and $RST_3$, select lines $SEL_1$, $SEL_2$ and $SEL_3$, and transfer gate lines $TG_2$ and $TG_3$ are connected to the vertical drive circuit 112 forming the drive circuit, and signal lines (data output lines) $VSL_1$, $VSL_2$ and $VSL_3$ are connected to a column signal processing circuit 113 forming the drive circuit.

A $p^+$ layer 44 is provided between the n-type semiconductor region 43 and the surface 70A of the semiconductor substrate 70 to suppress generation of dark current. A $p^+$ layer 42 is formed between the n-type semiconductor region 41 and the n-type semiconductor region 43, and a part of the side surface of the n-type semiconductor region 43 is surrounded by the $p^+$ layer 42. A $p^+$ layer 73 is formed on the side of the back surface 70B of the semiconductor substrate 70, and an $HfO_2$ film 74 and an insulating film 75 are formed in a portion of the semiconductor substrate 70 where the contact hole portion 61 is to be formed from the $p^+$ layer 73. In the interlayer insulating layer 76, wirings are formed over a plurality of layers, but are omitted from illustration.

The $HfO_2$ film 74 is a film having a negative fixed charge, and generation of dark current can be suppressed by providing such a film. Further, instead of the $HfO_2$ film, an aluminum oxide ($Al_2O_3$) film, a zirconium oxide ($ZrO_2$) film, a tantalum oxide ($Ta_2O_5$) film, a titanium oxide ($TiO_2$) film, a lanthanum oxide ($La_2O_3$) film, a praseodymium oxide ($Pr_2O_3$) film, a cerium oxide ($CeO_2$) film, a neodymium oxide ($Nd_2O_3$) film, a promethium oxide ($Pm_2O_3$) film, a samarium oxide ($Sm_2O_3$) film, a europium oxide ($Eu_2O_3$) film, a gadolinium oxide ($Gd_2O_3$) film, a terbium oxide ($TB_2O_3$) film, a dysprosium oxide ($Dy_2O_3$) film, a holmium oxide ($Ho_2O_3$) film, a thulium oxide ($Tm_2O_3$) film, a ytterbium oxide ($YB_2O_3$) film, a lutetium oxide ($Lu_2O_3$) film, a yttrium oxide ($Y_2O_3$) film, a hafnium nitride film, an aluminum nitride film, a hafnium oxynitride film and an aluminum oxynitride film may be used. Examples of the film forming method of these films include a CVD method, a PVD method and an ALD method.

Hereinafter, the operation of the imaging element (first imaging element), of Embodiment 1 will be described. Here, the potential of the first electrode 11 is higher than the potential of the second electrode. That is, for example, the first electrode 11 is set to a positive potential and the second electrode is set to a negative potential, and photoelectric conversion is performed in the organic photoelectric conversion layer 13, and electrons are read out to the floating diffusion layer. This also applies to other embodiments. Further, in a mode in which the first electrode 11 is set to a negative potential and the second electrode is set to a positive potential and holes generated based on photoelectric conversion in the organic photoelectric conversion layer 13 are read out to the floating diffusion layer, it is only necessary to invert the height of the potential described below.

First, a reset operation is performed. Thus, the potential of the first floating diffusion layer FD1 is reset and the potential of the first floating diffusion layer $FD_1$ becomes the potential $V_{DD}$ of the power supply. Then, during a subsequent charge storage and charge reading period, photoelectric conversion occurs in the organic photoelectric conversion layer 13 by light incident on the organic photoelectric conversion layer 13. Here, a voltage is applied from the drive circuit to the first electrode 11 and the second electrode 12. The holes generated by the photoelectric conversion are sent from the second electrode 12 to the drive circuit via a wiring $V_{OU}$. On the other hand, since the potential of the first electrode 11 is set to be higher than the potential of the second electrode 12, that is, for example, a positive potential is applied to the first electrode 11 and a negative potential is applied to the second electrode 12, electrons generated by the photoelectric conversion are read to the first floating diffusion layer $FD_1$ via the first electrode 11. That is, the charges generated in the organic photoelectric conversion layer 13 are read to the control unit. As described, the series of operations, the reset operation, the charge storage, and the charge transfer are completed.

The operation of the amplification transistor $TR1_{amp}$ and the select transistor $TR1_{sel}$ after the electrons are read out to the first floating diffusion layer $FD_1$ are the same as that of the conventional transistors. A series of operations such as charge storage, reset operation, and charge transfer of the second imaging element and the third imaging element are the same as a series of conventional operations such as charge storage, reset operation, and charge transfer. Furthermore, the reset noise of the first floating diffusion layer $FD_1$ can be removed by a correlated double sampling (CDS) process as in the related art.

FIG. 5 shows a conceptual diagram of a solid-state imaging apparatus of Embodiment 1. The solid-state imaging apparatus 100 of Embodiment 1 is formed of an imaging area 111 in which the stacked-type imaging elements 101 are

arranged in a two-dimensional array, a vertical drive circuit 112 as a drive circuit (peripheral circuit), a column signal processing circuit 113, a horizontal drive circuit 114, an output circuit 115, a drive control circuit 116, etc. These circuits may be formed by well-known circuits, and moreover, may be formed by using other circuit configurations (e.g., various circuits used in a conventional CCD imaging apparatus or CMOS imaging apparatus). Further, in FIG. 5, the reference number "101" of the stacked-type imaging element 101 is only shown in one row.

The drive control circuit 116 generates a clock signal and a control signal which are the basis of the operations of the vertical drive circuit 112, the column signal processing circuit 113, and the horizontal drive circuit 114 based on a vertical synchronization signal, a horizontal synchronization signal, and a master clock. Further, the generated clock signal and control signal are input to the vertical drive circuit 112, the column signal processing circuit 113, and the horizontal drive circuit 114.

The vertical drive circuit 112 is formed of, for example, a shift register, and selectively scans each stacked-type imaging element 101 in the imaging area 111 in the vertical direction in units of rows. Further, a pixel signal (image signal) based on the current (signal) generated according to the amount of light received by each stacked-type imaging element 101 is sent to the column signal processing circuit 113 via the signal lines (data output lines) 117, VSL.

For example, the column signal processing circuit 113 is arranged for each column of the stacked-type imaging element 101, and signal processing for noise removal and signal amplification is performed on image signal output from the stacked-type imaging element 101 for one row in each stacked-type imaging element 101 by a signal from a black reference pixel (not shown, but formed around the effective pixel area). A horizontal selection switch (not shown) is provided in the output stage of the column signal processing circuit 113 so as to be connected to the horizontal signal line 118.

The horizontal drive circuit 114 is formed of, for example, a shift register, and sequentially selects each of the column signal processing circuits 113 by sequentially outputting horizontal scanning pulses, and outputs signals from each of the column signal processing circuits 113 to the horizontal signal line 118.

The output circuit 115 is output by performing signal processing on the signals sequentially supplied from each of the column signal processing circuits 113 via the horizontal signal line 118.

As shown in FIG. 8 showing an equivalent circuit diagram of a modified example of the imaging element and stacked-type imaging element of Embodiment 1 and in FIG. 9 showing the schematic arrangement of the first electrode and the transistor forming the control unit forming a modified example of the imaging element according to Embodiment 1, and the source/drain region 51B of another side of the reset transistor $TR1_{rst}$ may be grounded instead of being connected to the power supply $V_{DD}$.

The imaging element and stacked-type imaging element of Embodiment 1 may be manufactured by, for example, the following method. That is, first, an SOI substrate is prepared. Then, a first silicon layer is formed on the surface of the SOI substrate by an epitaxial growth method, and a $p^+$ layer 73 and an n-type semiconductor region 41 are formed in the first silicon layer. Next, a second silicon layer is formed on the first silicon layer by an epitaxial growth method, and the element separation region 71, the oxide film 72, the $p^+$ layer 42, the n-type semiconductor region 43, and the $p^+$ layer 44 are formed on the second silicon layer. Furthermore, various transistors and the like forming the control unit of the imaging element are formed on the second silicon layer, and the wiring layer 62, an interlayer insulating layer 76, and various wirings are further formed thereon, and then the interlayer insulating layer 76 and the supporting substrate (not shown) are bonded to each other. Thereafter, the SOI substrate is removed to expose the first silicon layer. Further, the surface of the second silicon layer corresponds to the surface 70A of the semiconductor substrate 70, and the surface of the first silicon layer corresponds to the back surface 70B of the semiconductor substrate 70. Furthermore, the first silicon layer and the second silicon layer are collectively referred to as the semiconductor substrate 70. Next, an opening for forming the contact hole portion 61 is formed on the side of the back surface 70B of the semiconductor substrate 70, and the $HfO_2$ film 74, the insulating film 75 and the contact hole portion 61 are formed, and the pad portions 63, the interlayer insulating layer 81, the connection holes 64, and the first electrode 11 are further formed. Next, the organic photoelectric conversion layer 13 is formed on the basis of a coevaporation method, and further, the second electrode 12, the protective layer 82, and the on-chip microlens 90 are formed. Accordingly, the imaging element and the stacked-type imaging element of Embodiment 1 may be obtained.

For example, the phthalocyanine derivative has excellent spectral characteristics of green, but electron mobility which is an index indicating magnitude of electron transport properties is about $10^{-9}cm^2/V{\cdot}s$ to about $10^{-6}cm^2/V{\cdot}s$ in many cases. In addition, even in a case in which a material with high mobility is used as the organic pigment material, high photoelectric conversion efficiency may not be obtained unless an appropriate heterojunction state is not realized between energy levels of the electron transport material and the hole transport material to be used. That is, in order obtain the organic photoelectric conversion layer with good characteristics, the energy junction, the transport properties (mobility), and the spectral characteristics have to be simultaneously in an optimum state.

In an imaging element of the related art, with regard to a material of the organic photoelectric conversion layer, two functions of carrier transport properties and spectral characteristics are requested to satisfy desired characteristics. On the other hand, in the imaging element of Embodiment 1, functions of the carrier transport properties (the electron

transport properties and the hole transport properties) and light absorption characteristics are allocated to other materials. That is, by configuring the organic photoelectric conversion layer that has the bulk heterostructure in which a plurality of types (specifically, a minimum of 3 types) of materials are mixed, it is possible to provide the imaging element in which the electric characteristics and the spectral characteristics are compatible. That is, it is possible to obtain the organic photoelectric conversion layer that has high efficiency and good spectral characteristics. Then, in this way, material design can be optimized for each function of the carrier transport characteristics and the spectral characteristics. Consequently, it is possible to achieve the degree of high material design freedom. Further, to configure each of a blue imaging element, a green imaging element, and a red imaging element, the same material may be used as the electron transport material and the hole transport material and only the organic pigment material may be changed.

In general, in the organic photoelectric conversion layer, a film thickness for ensuring an optical absorption amount is decided depending on an absorption coefficient of a material to be used. In a case in which the organic photoelectric conversion layer is formed of only an organic pigment material, the optical absorption coefficient of the organic photoelectric conversion layer tends to be high. Therefore, when the thickness of the organic photoelectric conversion layer is excessively thick, a wavelength with a wide range may be absorbed and spectral characteristics of a desired color may not be obtained. On the other hand, in the imaging element of Embodiment 1, for example, the organic photoelectric conversion layer is formed of a mixture of the electron transport material that has no optical absorption peak with respect to the visible light (that is, the transparent electron transport material), the hole transport material that has no optical absorption peak with respect to the visible light (that is, the transparent hole transport material), and the organic pigment material. Consequently, the optical absorption coefficient of the entire organic photoelectric conversion layer can be set to a low value, and it is easy to increase the thickness of the organic photoelectric conversion layer.

Therefore, the thickness of the organic photoelectric conversion layer can be thicker than in the imaging element of the related art, and thus it is possible to achieve low capacity of the organic photoelectric conversion layer. Thus, in an imaging element of a direct-connection type of floating diffusion layer (FD layer) (an imaging element that has a structure with no transfer gate portion), conversion efficiency can be improved. Here, the imaging element of the direct-connection type of floating diffusion layer in Embodiment 1 has a structure in which the organic photoelectric conversion layer is interposed between the first electrode and the second electrode, and a capacity in this structure has an influence on random noise characteristics or conversion efficiency. Therefore, in order to obtain more excellent imaging characteristics, it is necessary to decrease a capacity component of the organic photoelectric conversion layer. In the imaging element of Embodiment 1, as described above, since it is easy to increase the thickness of the organic photoelectric conversion layer in the state in which the organic photoelectric conversion layer has the excellent spectral characteristics, it is possible to obtain the good random noise characteristics or conversion efficiency.

As described above, in the imaging element (the photoelectric conversion element) of Embodiment 1, the organic photoelectric conversion layer is formed of the mixture of the electron transport material, the organic pigment material, and the hole transport material. That is, the organic photoelectric conversion layer has the bulk heterostructure. Therefore, in order to form the organic photoelectric conversion layer of each of the blue imaging element, the green imaging element, and the red imaging element, the same material may be used in the electron transport material and the hole transport material and only the organic pigment material may be changed. That is, the function of the material of the organic photoelectric conversion layer is separated. Further, the electron transport material has the higher electron mobility than the organic pigment material and the hole transport material has the higher hole mobility than the organic pigment material. Further, Expression (1-1), Expression

(1-2), and Expression (1-3) may be satisfied. Consequently, the material design of the organic photoelectric conversion layer satisfying both the spectral characteristics and the electric characteristics can be performed with the degree of high freedom. In addition, the imaging element of Embodiment 1 has a high S/N ratio. Further, it is possible to improve the photoelectric conversion efficiency with light irradiation and suppress deterioration in the optical response characteristics.

[Embodiment 2]

Embodiment 2 is the modification of Embodiment 1. The imaging element and stacked-type imaging element of Embodiment 2 schematically shown in FIG. 10 are front-surface illuminated type imaging element and stacked-type imaging element, and have a structure in which a first-type green imaging element of Embodiment 1 (first imaging element) having a first-type green organic photoelectric conversion layer which absorbs green light and having sensitivity to green, a second-type conventional blue imaging element (second imaging element) having a second-type photoelectric conversion layer which absorbs blue light and having sensitivity to blue, and a second-type conventional red imaging element (third imaging element) having a second-type photoelectric conversion layer which absorbs red light and having sensitivity to red are stacked. Here, the red imaging element (third imaging element) and the blue imaging element (second imaging element) are provided in the semiconductor substrate 70, and the second imaging element is located more closer to the

light incident side as compared to the third imaging element. Furthermore, the green imaging element (first imaging element) is provided above the blue imaging element (second imaging element).

Various transistors forming the control unit are provided on the surface 70 A of the semiconductor substrate 70, as in Embodiment 1. These transistors may have the substantially same configuration and structure of transistors described in Embodiment 1. Furthermore, the second imaging element and the third imaging element are provided on the semiconductor substrate 70, and these imaging elements also may have the substantially same configuration and structure of the second imaging element and the third imaging element described in Embodiment 1.

The interlayer insulating layers 77 and 78 are formed on the surface 70 A of the semiconductor substrate 70, and the photoelectric conversion unit (first electrode 11, organic photoelectric conversion layer 13 and second electrode 12) and the like forming the imaging element of Embodiment 1 are formed on the interlayer insulating layer 78.

As described above, the configuration and structure of the imaging element and the stacked-type imaging element of Embodiment 2 are the same as those of the imaging element and the stacked-type imaging element of Example 1 except for being the front-surface illuminated type imaging element and stacked-type imaging element, and thus detailed description will be omitted.

[Embodiment 3]

Embodiment 3 is the modification of Embodiments 1 and 2.

The imaging element and stacked-type imaging element of Embodiment 3 schematically shown in FIG. 11 are back-surface illuminated type imaging element and stacked-type imaging element, and have a structure in which the first imaging element of the first type of Embodiment 1 and two second imaging elements of the second type are stacked. Further, modified examples of the imaging element of Embodiment 3 and stacked-type imaging element of which partial cross sectional views are shown in FIG. 12 are front-surface illuminated type imaging element and stacked-type imaging element, and have a structure in which the first imaging element of the first type of Embodiment 1 and two second imaging elements of the second type are stacked. Here, the first imaging element absorbs primary color of light, and the second imaging element absorbs complementary color of light. Alternatively, the first imaging element absorbs white light and the second imaging element absorbs infrared light.

A modified example of the imaging element of Embodiment 3 of which a schematic partial sectional view is shown in FIG. 13 is a back-surface illuminated type imaging element, and is formed of the first imaging element of the first type of Embodiment 1. Furthermore, a modified example of the imaging element of Embodiment 3 of which a schematic partial sectional view is shown in FIG. 14 is a front-surface illuminated type imaging element, and is formed of the first imaging element of the first type of Embodiment 1. Here, the first imaging element is formed of three types of imaging elements including an imaging element absorbing red light, an imaging element absorbing green light and an imaging element absorbing blue light. Moreover, the solid-state imaging apparatus according to the first aspect of the present disclosure is formed of a plurality of these imaging elements. An example of the arrangement of a plurality of the imaging elements includes a Bayer array. Color filters for performing spectral division of blue, green, and red are provided as necessary at the light incident side of each imaging element.

Further, the form in which two first-type imaging element of Embodiment 1 are stacked (i.e., form in which two photoelectric conversion units are stacked and control units of two imaging elements are provided on semiconductor substrate), or, the form in which three first-type imaging element are stacked (i.e., form in which three photoelectric conversion units are stacked and control units of three imaging elements are provided on semiconductor substrate) may be adopted instead of providing one imaging first-type element. An example of a stacked structure of the first-type imaging element and the second-type imaging element is exemplified in the following table.

| | First type | Second type | Reference drawing |
|---|---|---|---|
| | 1<br>Green | 2<br>Blue + red | FIG. 1<br>FIG. 10 |
| | 1<br>Primary color | 1<br>Complementary color | FIG. 11<br>FIG. 12 |
| | 1<br>White | 1<br>Infrared ray | |
| | 1 | 0 | FIG. 13 |

(continued)

| | First type | Second type | Reference drawing |
|---|---|---|---|
| Back surface illuminated type and front surface illuminated type | Blue or green or red | | FIG. 14 |
| | 2<br>Green + infrared light | 2<br>Blue + red | |
| | 2<br>Green + blue | 1<br>Red | |
| | 2 White + infrared light | 0 | |
| | 3<br>Green + blue + red | 2<br>Blue-green (emerald color) + infrared light | |
| | 3<br>Green + blue + red | 1<br>Infrared light | |
| | 3<br>Blue + green + red | 0 | |

[Embodiment 4]

The technology according to the present disclosure (the present technology) can be applied to various products. For example, the technology according to the present disclosure is implemented as apparatuses mounted on any type of mobile bodies such as automobiles, electric vehicles, hybrid electric vehicles, motorcycles, bicycles, personal mobilities, airplanes, drones, ships, and robots.

FIG. 17 is a block diagram depicting an example of schematic configuration of a vehicle control system as an example of a mobile body control system to which the technology according to an embodiment of the present disclosure can be applied.

The vehicle control system 12000 includes a plurality of electronic control units connected to each other via a communication network 12001. In the example depicted in FIG. 17, the vehicle control system 12000 includes a driving system control unit 12010, a body system control unit 12020, an outside-vehicle information detecting unit 12030, an in-vehicle information detecting unit 12040, and an integrated control unit 12050. In addition, a microcomputer 12051, a sound/image output section 12052, and a vehicle-mounted network interface (I/F) 12053 are illustrated as a functional configuration of the integrated control unit 12050.

The driving system control unit 12010 controls the operation of devices related to the driving system of the vehicle in accordance with various kinds of programs. For example, the driving system control unit 12010 functions as a control device for a driving force generating device for generating the driving force of the vehicle, such as an internal combustion engine, a driving motor, or the like, a driving force transmitting mechanism for transmitting the driving force to wheels, a steering mechanism for adjusting the steering angle of the vehicle, a braking device for generating the braking force of the vehicle, and the like.

The body system control unit 12020 controls the operation of various kinds of devices provided to a vehicle body in accordance with various kinds of programs. For example, the body system control unit 12020 functions as a control device for a keyless entry system, a smart key system, a power window device, or various kinds of lamps such as a headlamp, a backup lamp, a brake lamp, a turn signal, a fog lamp, or the like. In this case, radio waves transmitted from a mobile device as an alternative to a key or signals of various kinds of switches can be input to the body system control unit 12020. The body system control unit 12020 receives these input radio waves or signals, and controls a door lock device, the power window device, the lamps, or the like of the vehicle.

The outside-vehicle information detecting unit 12030 detects information about the outside of the vehicle including the vehicle control system 12000. For example, the outside-vehicle information detecting unit 12030 is connected with an imaging section 12031. The outside-vehicle information detecting unit 12030 makes the imaging section 12031 image an image of the outside of the vehicle, and receives the imaged image. On the basis of the received image, the outside-vehicle information detecting unit 12030 may perform processing of detecting an object such as a human, a

vehicle, an obstacle, a sign, a character on a road surface, or the like, or processing of detecting a distance thereto.

The imaging section 12031 is an optical sensor that receives light, and which outputs an electric signal corresponding to a received light amount of the light. The imaging section 12031 can output the electric signal as an image, or can output the electric signal as information about a measured distance. In addition, the light received by the imaging section 12031 may be visible light, or may be invisible light such as infrared rays or the like.

The in-vehicle information detecting unit 12040 detects information about the inside of the vehicle. The in-vehicle information detecting unit 12040 is, for example, connected with a driver state detecting section 12041 that detects the state of a driver. The driver state detecting section 12041, for example, includes a camera that images the driver. On the basis of detection information input from the driver state detecting section 12041, the in-vehicle information detecting unit 12040 may calculate a degree of fatigue of the driver or a degree of concentration of the driver, or may determine whether the driver is dozing.

The microcomputer 12051 can calculate a control target value for the driving force generating device, the steering mechanism, or the braking device on the basis of the information about the inside or outside of the vehicle which information is obtained by the outside-vehicle information detecting unit 12030 or the in-vehicle information detecting unit 12040, and output a control command to the driving system control unit 12010. For example, the microcomputer 12051 can perform cooperative control intended to implement functions of an advanced driver assistance system (ADAS) which functions include collision avoidance or shock mitigation for the vehicle, following driving based on a following distance, vehicle speed maintaining driving, a warning of collision of the vehicle, a warning of deviation of the vehicle from a lane, or the like.

In addition, the microcomputer 12051 can perform cooperative control intended for automatic driving, which makes the vehicle to travel autonomously without depending on the operation of the driver, or the like, by controlling the driving force generating device, the steering mechanism, the braking device, or the like on the basis of the information about the outside or inside of the vehicle which information is obtained by the outside-vehicle information detecting unit 12030 or the in-vehicle information detecting unit 12040.

In addition, the microcomputer 12051 can output a control command to the body system control unit 12020 on the basis of the information about the outside of the vehicle which information is obtained by the outside-vehicle information detecting unit 12030. For example, the microcomputer 12051 can perform cooperative control intended to prevent a glare by controlling the headlamp so as to change from a high beam to a low beam, for example, in accordance with the position of a preceding vehicle or an oncoming vehicle detected by the outside-vehicle information detecting unit 12030.

The sound/image output section 12052 transmits an output signal of at least one of a sound and an image to an output device capable of visually or auditorily notifying information to an occupant of the vehicle or the outside of the vehicle. In the example of FIG. 17, an audio speaker 12061, a display section 12062, and an instrument panel 12063 are illustrated as the output device. The display section 12062 may, for example, include at least one of an on-board display or a head-up display.

FIG. 18 is a diagram depicting an example of the installation position of the imaging section 12031.

In FIG. 18, as the imaging section 12031, the vehicle 12100 includes imaging sections 12101, 12102, 12103, 12104, and 12105.

The imaging sections 12101, 12102, 12103, 12104, and 12105 are, for example, disposed at positions on a front nose, sideview mirrors, a rear bumper, and a back door of the vehicle 12100 as well as a position on an upper portion of a windshield within the interior of the vehicle. The imaging section 12101 provided to the front nose and the imaging section 12105 provided to the upper portion of the windshield within the interior of the vehicle obtain mainly an image of the front of the vehicle 12100. The imaging sections 12102 and 12103 provided to the sideview mirrors obtain mainly an image of the sides of the vehicle 12100. The imaging section 12104 provided to the rear bumper or the back door obtains mainly an image of the rear of the vehicle 12100. The image of the front obtained by the imaging section 12101 and the imaging section 12105 is used mainly to detect a preceding vehicle, a pedestrian, an obstacle, a signal, a traffic sign, a lane, or the like.

Incidentally, FIG. 18 depicts an example of photographing ranges of the imaging sections 12101 to 12104. An imaging range 12111 represents the imaging range of the imaging section 12101 provided to the front nose. Imaging ranges 12112 and 12113 respectively represent the imaging ranges of the imaging sections 12102 and 12103 provided to the sideview mirrors. An imaging range 12114 represents the imaging range of the imaging section 12104 provided to the rear bumper or the back door. A bird's-eye image of the vehicle 12100 as viewed from above is obtained by superimposing image data imaged by the imaging sections 12101 to 12104, for example.

At least one of the imaging sections 12101 to 12104 may have a function of obtaining distance information. For example, at least one of the imaging sections 12101 to 12104 may be a stereo camera constituted of a plurality of imaging elements, or may be an imaging element having pixels for phase difference detection.

For example, the microcomputer 12051 can determine a distance to each three-dimensional object within the imaging ranges 12111 to 12114 and a temporal change in the distance (relative speed with respect to the vehicle 12100)

on the basis of the distance information obtained from the imaging sections 12101 to 12104, and thereby extract, as a preceding vehicle, a nearest three-dimensional object in particular that is present on a traveling path of the vehicle 12100 and which travels in substantially the same direction as the vehicle 12100 at a predetermined speed (for example, equal to or more than 0 km/hour). Further, the microcomputer 12051 can set a following distance to be maintained in front of a preceding vehicle in advance, and perform automatic brake control (including following stop control), automatic acceleration control (including following start control), or the like. It is thus possible to perform cooperative control intended for automatic driving that makes the vehicle travel autonomously without depending on the operation of the driver or the like.

For example, the microcomputer 12051 can classify three-dimensional object data on three-dimensional objects into three-dimensional object data of a two-wheeled vehicle, a standard-sized vehicle, a large-sized vehicle, a pedestrian, a utility pole, and other three-dimensional objects on the basis of the distance information obtained from the imaging sections 12101 to 12104, extract the classified three-dimensional object data, and use the extracted three-dimensional object data for automatic avoidance of an obstacle. For example, the microcomputer 12051 identifies obstacles around the vehicle 12100 as obstacles that the driver of the vehicle 12100 can recognize visually and obstacles that are difficult for the driver of the vehicle 12100 to recognize visually. Then, the microcomputer 12051 determines a collision risk indicating a risk of collision with each obstacle. In a situation in which the collision risk is equal to or higher than a set value and there is thus a possibility of collision, the microcomputer 12051 outputs a warning to the driver via the audio speaker 12061 or the display section 12062, and performs forced deceleration or avoidance steering via the driving system control unit 12010. The microcomputer 12051 can thereby assist in driving to avoid collision.

At least one of the imaging sections 12101 to 12104 may be an infrared camera that detects infrared rays. The microcomputer 12051 can, for example, recognize a pedestrian by determining whether or not there is a pedestrian in imaged images of the imaging sections 12101 to 12104. Such recognition of a pedestrian is, for example, performed by a procedure of extracting characteristic points in the imaged images of the imaging sections 12101 to 12104 as infrared cameras and a procedure of determining whether or not it is the pedestrian by performing pattern matching processing on a series of characteristic points representing the contour of the object. When the microcomputer 12051 determines that there is a pedestrian in the imaged images of the imaging sections 12101 to 12104, and thus recognizes the pedestrian, the sound/image output section 12052 controls the display section 12062 so that a square contour line for emphasis is displayed so as to be superimposed on the recognized pedestrian. The sound/image output section 12052 may also control the display section 12062 so that an icon or the like representing the pedestrian is displayed at a desired position.

[Embodiment 5]

In addition, the present disclosure technology (this technology) can be applied to various products. For example, the present disclosure technology may be applied to the endoscopic surgery system.

FIG. 19 is a view depicting an example of a schematic configuration of an endoscopic surgery system to which the technology according to an embodiment of the present disclosure (present technology) can be applied.

In FIG. 19, a state is illustrated in which a surgeon (medical doctor) 11131 is using an endoscopic surgery system 11000 to perform surgery for a patient 11132 on a patient bed 11133. As depicted, the endoscopic surgery system 11000 includes an endoscope 11100, other surgical tools 11110 such as a pneumoperitoneum tube 11111 and an energy device 11112, a supporting arm apparatus 11120 which supports the endoscope 11100 thereon, and a cart 11200 on which various apparatus for endoscopic surgery are mounted.

The endoscope 11100 includes a lens barrel 11101 having a region of a predetermined length from a distal end thereof to be inserted into a body cavity of the patient 11132, and a camera head 11102 connected to a proximal end of the lens barrel 11101. In the example depicted, the endoscope 11100 is depicted which includes as a rigid endoscope having the lens barrel 11101 of the hard type. However, the endoscope 11100 may otherwise be included as a flexible endoscope having the lens barrel 11101 of the flexible type.

The lens barrel 11101 has, at a distal end thereof, an opening in which an objective lens is fitted. A light source apparatus 11203 is connected to the endoscope 11100 such that light generated by the light source apparatus 11203 is introduced to a distal end of the lens barrel 11101 by a light guide extending in the inside of the lens barrel 11101 and is irradiated toward an observation target in a body cavity of the patient 11132 through the objective lens. It is to be noted that the endoscope 11100 may be a forward-viewing endoscope or may be an oblique-viewing endoscope or a side-viewing endoscope.

An optical system and an image pickup element are provided in the inside of the camera head 11102 such that reflected light (observation light) from the observation target is condensed on the image pickup element by the optical system. The observation light is photo-electrically converted by the image pickup element to generate an electric signal corresponding to the observation light, namely, an image signal corresponding to an observation image. The image signal is transmitted as RAW data to a CCU 11201.

The CCU 11201 includes a central processing unit (CPU), a graphics processing unit (GPU) or the like and integrally controls operation of the endoscope 11100 and a display apparatus 11202. Further, the CCU 11201 receives an image signal from the camera head 11102 and performs, for the image signal, various image processes for displaying an image based on the image signal such as, for example, a development process (demosaic process).

The display apparatus 11202 displays thereon an image based on an image signal, for which the image processes have been performed by the CCU 11201, under the control of the CCU 11201.

The light source apparatus 11203 includes a light source such as, for example, a light emitting diode (LED) and supplies irradiation light upon imaging of a surgical region to the endoscope 11100.

An inputting apparatus 11204 is an input interface for the endoscopic surgery system 11000. A user can perform inputting of various kinds of information or instruction inputting to the endoscopic surgery system 11000 through the inputting apparatus 11204. For example, the user would input an instruction or a like to change an image pickup condition (type of irradiation light, magnification, focal distance or the like) by the endoscope 11100.

A treatment tool controlling apparatus 11205 controls driving of the energy device 11112 for cautery or incision of a tissue, sealing of a blood vessel or the like. A pneumoperitoneum apparatus 11206 feeds gas into a body cavity of the patient 11132 through the pneumoperitoneum tube 11111 to inflate the body cavity in order to secure the field of view of the endoscope 11100 and secure the working space for the surgeon. A recorder 11207 is an apparatus capable of recording various kinds of information relating to surgery. A printer 11208 is an apparatus capable of printing various kinds of information relating to surgery in various forms such as a text, an image or a graph.

It is to be noted that the light source apparatus 11203 which supplies irradiation light when a surgical region is to be imaged to the endoscope 11100 may include a white light source which includes, for example, an LED, a laser light source or a combination of them. Where a white light source includes a combination of red, green, and blue (RGB) laser light sources, since the output intensity and the output timing can be controlled with a high degree of accuracy for each color (each wavelength), adjustment of the white balance of a picked up image can be performed by the light source apparatus 11203. Further, in this case, if laser beams from the respective RGB laser light sources are irradiated time-divisionally on an observation target and driving of the image pickup elements of the camera head 11102 are controlled in synchronism with the irradiation timings. Then images individually corresponding to the R, G and B colors can be also picked up time-divisionally. According to this method, a color image can be obtained even if color filters are not provided for the image pickup element.

Further, the light source apparatus 11203 may be controlled such that the intensity of light to be outputted is changed for each predetermined time. By controlling driving of the image pickup element of the camera head 11102 in synchronism with the timing of the change of the intensity of light to acquire images time-divisionally and synthesizing the images, an image of a high dynamic range free from underexposed blocked up shadows and overexposed highlights can be created.

Further, the light source apparatus 11203 may be configured to supply light of a predetermined wavelength band ready for special light observation. In special light observation, for example, by utilizing the wavelength dependency of absorption of light in a body tissue to irradiate light of a narrow band in comparison with irradiation light upon ordinary observation (namely, white light), narrow band observation (narrow band imaging) of imaging a predetermined tissue such as a blood vessel of a superficial portion of the mucous membrane or the like in a high contrast is performed. Alternatively, in special light observation, fluorescent observation for obtaining an image from fluorescent light generated by irradiation of excitation light may be performed. In fluorescent observation, it is possible to perform observation of fluorescent light from a body tissue by irradiating excitation light on the body tissue (autofluorescence observation) or to obtain a fluorescent light image by locally injecting a reagent such as indocyanine green (ICG) into a body tissue and irradiating excitation light corresponding to a fluorescent light wavelength of the reagent upon the body tissue. The light source apparatus 11203 can be configured to supply such narrow-band light and/or excitation light suitable for special light observation as described above.

FIG. 20 is a block diagram depicting an example of a functional configuration of the camera head 11102 and the CCU 11201 depicted in FIG. 19.

The camera head 11102 includes a lens unit 11401, an image pickup unit 11402, a driving unit 11403, a communication unit 11404 and a camera head controlling unit 11405. The CCU 11201 includes a communication unit 11411, an image processing unit 11412 and a control unit 11413. The camera head 11102 and the CCU 11201 are connected for communication to each other by a transmission cable 11400.

The lens unit 11401 is an optical system, provided at a connecting location to the lens barrel 11101. Observation light taken in from a distal end of the lens barrel 11101 is guided to the camera head 11102 and introduced into the lens unit 11401. The lens unit 11401 includes a combination of a plurality of lenses including a zoom lens and a focusing lens.

The image pickup unit 11402 includes image pickup elements. The number of image pickup elements which is included by the image pickup unit 11402 may be one (single-plate type) or a plural number (multi-plate type). Where the image pickup unit 11402 is configured as that of the multi-plate type, for example, image signals corresponding to respective R, G and B are generated by the image pickup elements, and the image signals may be synthesized to obtain

a color image. The image pickup unit 11402 may also be configured so as to have a pair of image pickup elements for acquiring respective image signals for the right eye and the left eye ready for three dimensional (3D) display. If 3D display is performed, then the depth of a living body tissue in a surgical region can be comprehended more accurately by the surgeon 11131. It is to be noted that, where the image pickup unit 11402 is configured as that of stereoscopic type, a plurality of systems of lens units 11401 are provided corresponding to the individual image pickup elements.

Further, the image pickup unit 11402 may not necessarily be provided on the camera head 11102. For example, the image pickup unit 11402 may be provided immediately behind the objective lens in the inside of the lens barrel 11101.

The driving unit 11403 includes an actuator and moves the zoom lens and the focusing lens of the lens unit 11401 by a predetermined distance along an optical axis under the control of the camera head controlling unit 11405. Consequently, the magnification and the focal point of a picked up image by the image pickup unit 11402 can be adjusted suitably.

The communication unit 11404 includes a communication apparatus for transmitting and receiving various kinds of information to and from the CCU 11201. The communication unit 11404 transmits an image signal acquired from the image pickup unit 11402 as RAW data to the CCU 11201 through the transmission cable 11400.

In addition, the communication unit 11404 receives a control signal for controlling driving of the camera head 11102 from the CCU 11201 and supplies the control signal to the camera head controlling unit 11405. The control signal includes information relating to image pickup conditions such as, for example, information that a frame rate of a picked up image is designated, information that an exposure value upon image picking up is designated and/or information that a magnification and a focal point of a picked up image are designated.

It is to be noted that the image pickup conditions such as the frame rate, exposure value, magnification or focal point may be designated by the user or may be set automatically by the control unit 11413 of the CCU 11201 on the basis of an acquired image signal. In the latter case, an auto exposure (AE) function, an auto focus (AF) function and an auto white balance (AWB) function are incorporated in the endoscope 11100.

The camera head controlling unit 11405 controls driving of the camera head 11102 on the basis of a control signal from the CCU 11201 received through the communication unit 11404.

The communication unit 11411 includes a communication apparatus for transmitting and receiving various kinds of information to and from the camera head 11102. The communication unit 11411 receives an image signal transmitted thereto from the camera head 11102 through the transmission cable 11400.

Further, the communication unit 11411 transmits a control signal for controlling driving of the camera head 11102 to the camera head 11102. The image signal and the control signal can be transmitted by electrical communication, optical communication or the like.

The image processing unit 11412 performs various image processes for an image signal in the form of RAW data transmitted thereto from the camera head 11102.

The control unit 11413 performs various kinds of control relating to image picking up of a surgical region or the like by the endoscope 11100 and display of a picked up image obtained by image picking up of the surgical region or the like. For example, the control unit 11413 creates a control signal for controlling driving of the camera head 11102.

Further, the control unit 11413 controls, on the basis of an image signal for which image processes have been performed by the image processing unit 11412, the display apparatus 11202 to display a picked up image in which the surgical region or the like is imaged. Thereupon, the control unit 11413 may recognize various objects in the picked up image using various image recognition technologies. For example, the control unit 11413 can recognize a surgical tool such as forceps, a particular living body region, bleeding, mist when the energy device 11112 is used and so forth by detecting the shape, color and so forth of edges of objects included in a picked up image. The control unit 11413 may cause, when it controls the display apparatus 11202 to display a picked up image, various kinds of surgery supporting information to be displayed in an overlapping manner with an image of the surgical region using a result of the recognition. Where surgery supporting information is displayed in an overlapping manner and presented to the surgeon 11131, the burden on the surgeon 11131 can be reduced and the surgeon 11131 can proceed with the surgery with certainty.

The transmission cable 11400 which connects the camera head 11102 and the CCU 11201 to each other is an electric signal cable ready for communication of an electric signal, an optical fiber ready for optical communication or a composite cable ready for both of electrical and optical communications.

Here, while, in the example depicted, communication is performed by wired communication using the transmission cable 11400, the communication between the camera head 11102 and the CCU 11201 may be performed by wireless communication.

[Embodiment 6]

Further, the present disclosure technology (this technology) can be applied to various products. For example, the present disclosure technology may be applied to the endoscopic surgery system.

FIG. 21 is a block diagram depicting an example of a schematic configuration of an in-vivo information acquisition

system of a patient using a capsule type endoscope, to which the technology according to an embodiment of the present disclosure (present technology) can be applied.

The in-vivo information acquisition system 10001 includes a capsule type endoscope 10100 and an external controlling apparatus 10200.

The capsule type endoscope 10100 is swallowed by a patient at the time of inspection. The capsule type endoscope 10100 has an image pickup function and a wireless communication function and successively picks up an image of the inside of an organ such as the stomach or an intestine (hereinafter referred to as in-vivo image) at predetermined intervals while it moves inside of the organ by peristaltic motion for a period of time until it is naturally discharged from the patient. Then, the capsule type endoscope 10100 successively transmits information of the in-vivo image to the external controlling apparatus 10200 outside the body by wireless transmission.

The external controlling apparatus 10200 integrally controls operation of the in-vivo information acquisition system 10001. Further, the external controlling apparatus 10200 receives information of an in-vivo image transmitted thereto from the capsule type endoscope 10100 and generates image data for displaying the in-vivo image on a display apparatus (not depicted) on the basis of the received information of the in-vivo image.

In the in-vivo information acquisition system 10001, an in-vivo image imaged a state of the inside of the body of a patient can be acquired at any time in this manner for a period of time until the capsule type endoscope 10100 is discharged after it is swallowed.

A configuration and functions of the capsule type endoscope 10100 and the external controlling apparatus 10200 are described in more detail below.

The capsule type endoscope 10100 includes a housing 10101 of the capsule type, in which a light source unit 10111, an image pickup unit 10112, an image processing unit 10113, a wireless communication unit 10114, a power feeding unit 10115, a power supply unit 10116 and a control unit 10117 are accommodated.

The light source unit 10111 includes a light source such as, for example, a light emitting diode (LED) and irradiates light on an image pickup field-of-view of the image pickup unit 10112.

The image pickup unit 10112 includes an image pickup element and an optical system including a plurality of lenses provided at a preceding stage to the image pickup element. Reflected light (hereinafter referred to as observation light) of light irradiated on a body tissue which is an observation target is condensed by the optical system and introduced into the image pickup element. In the image pickup unit 10112, the incident observation light is photoelectrically converted by the image pickup element, by which an image signal corresponding to the observation light is generated. The image signal generated by the image pickup unit 10112 is provided to the image processing unit 10113.

The image processing unit 10113 includes a processor such as a central processing unit (CPU) or a graphics processing unit (GPU) and performs various signal processes for an image signal generated by the image pickup unit 10112. The image processing unit 10113 provides the image signal for which the signal processes have been performed thereby as RAW data to the wireless communication unit 10114.

The wireless communication unit 10114 performs a predetermined process such as a modulation process for the image signal for which the signal processes have been performed by the image processing unit 10113 and transmits the resulting image signal to the external controlling apparatus 10200 through an antenna 10114A. Further, the wireless communication unit 10114 receives a control signal relating to driving control of the capsule type endoscope 10100 from the external controlling apparatus 10200 through the antenna 10114A. The wireless communication unit 10114 provides the control signal received from the external controlling apparatus 10200 to the control unit 10117.

The power feeding unit 10115 includes an antenna coil for power reception, a power regeneration circuit for regenerating electric power from current generated in the antenna coil, a voltage booster circuit and so forth. The power feeding unit 10115 generates electric power using the principle of non-contact charging.

The power supply unit 10116 includes a secondary battery and stores electric power generated by the power feeding unit 10115. In FIG. 21, in order to avoid complicated illustration, an arrow mark indicative of a supply destination of electric power from the power supply unit 10116 and so forth are omitted. However, electric power stored in the power supply unit 10116 is supplied to and can be used to drive the light source unit 10111, the image pickup unit 10112, the image processing unit 10113, the wireless communication unit 10114 and the control unit 10117.

The control unit 10117 includes a processor such as a CPU and suitably controls driving of the light source unit 10111, the image pickup unit 10112, the image processing unit 10113, the wireless communication unit 10114 and the power feeding unit 10115 in accordance with a control signal transmitted thereto from the external controlling apparatus 10200.

The external controlling apparatus 10200 includes a processor such as a CPU or a GPU, a microcomputer, a control board or the like in which a processor and a storage element such as a memory are mixedly incorporated. The external controlling apparatus 10200 transmits a control signal to the control unit 10117 of the capsule type endoscope 10100 through an antenna 10200A to control operation of the capsule type endoscope 10100. In the capsule type endoscope 10100, an irradiation condition of light upon an observation target of the light source unit 10111 can be changed, for example, in accordance with a control signal from the external controlling apparatus 10200. Further, an

image pickup condition (for example, a frame rate, an exposure value or the like of the image pickup unit 10112) can be changed in accordance with a control signal from the external controlling apparatus 10200. Further, the substance of processing by the image processing unit 10113 or a condition for transmitting an image signal from the wireless communication unit 10114 (for example, a transmission interval, a transmission image number or the like) may be changed in accordance with a control signal from the external controlling apparatus 10200.

Further, the external controlling apparatus 10200 performs various image processes for an image signal transmitted thereto from the capsule type endoscope 10100 to generate image data for displaying a picked up in-vivo image on the display apparatus. As the image processes, various signal processes can be performed such as, for example, a development process (demosaic process), an image quality improving process (bandwidth enhancement process, a super-resolution process, a noise reduction (NR) process and/or image stabilization process) and/or an enlargement process (electronic zooming process). The external controlling apparatus 10200 controls driving of the display apparatus to cause the display apparatus to display a picked up in-vivo image on the basis of generated image data. Alternatively, the external controlling apparatus 10200 may also control a recording apparatus (not depicted) to record generated image data or control a printing apparatus (not depicted) to output generated image data by printing.

The present disclosure has been described above according to preferred embodiments, but is not limited to these embodiments. The structures, the configurations, the manufacturing conditions, the manufacturing methods, and the used materials of the imaging element, the stacked-type imaging element, and the solid-state imaging apparatus described in the embodiments are exemplary and can be appropriately changed. Not only may one floating diffusion layer be provided in one imaging element, but one floating diffusion layer may also be provided in a plurality of imaging elements. That is, the plurality of imaging elements can share one floating diffusion layer by appropriately controlling a timing of a charge transfer period. Then, in this case, the plurality of imaging elements can also share one contact hole portion.

In addition, for example, as a modified example of the imaging element and the stacked-type imaging element described in Embodiment 1 illustrated in FIG. 15, a structure in which light is incident from the side of the second electrode 12 and a light shielding layer 91 is formed on a light incidence side in the second electrode 12 can be realized. Moreover, various wirings provided to be closer to the light incidence side than the photoelectric conversion layer can also be caused to function as a light shielding layer.

In the embodiments, electrons are assumed to be signal charges and a conductive type of the photoelectric conversion layer formed in the semiconductor substrate is set to the n type, but holes can also be applied to a solid-state imaging apparatus in which holes are assumed to be signal charges. In this case, each semiconductor region may be configured as a reverse conductive type of semiconductor region and a conductive type of photoelectric conversion layer formed in the semiconductor substrate may be set to the p type.

In addition, in the embodiments, the case of the application to the CMOS solid-state imaging apparatus in which unit pixels detecting a signal charge corresponding to an amount of incident light as a physical quantity are disposed in a matrix form has been described as an example, but the present disclosure is not limited to the application to the CMOS solid-state imaging apparatus and can also be applied to a CCD solid-state imaging apparatus. In the latter case, a pixel signal (image signal) is output by transferring the signal charge in the vertical direction by a vertical transfer register with a CCD structure, transferring the signal charge in the horizontal direction by the horizontal transfer register, and amplifying the signal charge. In addition, the present disclosure is not limited to a column type of general solid-state imaging apparatus in which pixels are formed in a 2-dimensional matrix form and a column signal processing circuit is disposed for each pixel column. Moreover, depending on a case, a select transistor can also be omitted.

Moreover, the imaging element and the stacked-type imaging element of the present disclosure is not limited to the application to the solid-state imaging apparatus that detects a distribution of an incidence light amount of the visible light and captures the distribution as an image, but may be applied to a solid-state imaging apparatus that captures a distribution of infrared light or an X ray or an incident amount of particles or the like as an image. In addition, the imaging element and the stacked-type imaging element can also be applied to a general solid-state imaging apparatus (physical quantity distribution detection apparatus) such as a fingerprint detection sensor that detects a distribution of another physical amount such as a pressure or an electrostatic capacity and captures the distribution as an image.

Moreover, the present disclosure is not limited to a solid-state imaging apparatus that sequentially scans unit pixels of an imaging region in units of rows and reads pixel signals from the unit pixels. The present disclosure can also be applied to an X-Y address type of solid-state imaging apparatus that selects any pixels in units of pixels and reads a pixel signal in the units of pixels from the selected pixels. The solid-state imaging apparatus may be formed as a one-chip or may be formed in a module shape with an imaging function realized by arranging and packaging an imaging region and a drive circuit or an optical system.

In addition, the present disclosure is not limited to the application to the solid-state imaging apparatus and can also be applied to an imaging apparatus. Here, the imaging apparatus refers to an electronic device that has an imaging function of a camera system such as a digital still camera or a video camera or a mobile phone or the like. A form with a module shape mounted on an electronic device, that is, a camera module, is used as an imaging apparatus in some

cases.

FIG. 16 is a conceptual diagram of an example in which a solid-state imaging apparatus 201 formed of the imaging element and stacked-type imaging element of the present disclosure is used in an electronic device (camera) 200. The electronic device 200 includes the solid-state imaging apparatus 201, an optical lens 210, a shutter device 211, a drive circuit 212, and a signal processing circuit 213. The optical lens 210 forms an image light (incident light) from a subject as an image on an imaging surface of the solid-state imaging apparatus 201. Thus, signal charges are accumulated in the solid-state imaging apparatus 201 for a given period. The shutter device 211 controls a light irradiation period and a light shielding period for the solid-state imaging apparatus 201. The drive circuit 212 supplies a drive signal for controlling a transfer operation or the like of the solid-state imaging apparatus 201 and a shutter operation of the shutter device 211. A signal of the solid-state imaging apparatus 201 is transferred in accordance with the drive signal (timing signal) supplied from the drive circuit 212. The signal processing circuit 213 performs various kinds of signal processing. A video signal subjected to the signal processing is stored in a storage medium such as a memory or is output to a monitor. Since miniaturization of a pixel size in the solid-state imaging apparatus 201 and transfer efficiency are improved in the electronic device 200, the electronic device 200 in which an improvement in pixel characteristics is achieved can be obtained. The electronic device 200 to which the solid-state imaging apparatus 201 can be applied is not limited to a camera and can also be applied to an imaging apparatus such as a digital still camera or a camera module for a mobile device such as a mobile phone.

Additionally, the present technology may also be configured as below.

[A01] << imaging element>>
An imaging element including:

a photoelectric conversion unit including a stacked structure of a first electrode, an organic photoelectric conversion layer, and a second electrode,
in which the organic photoelectric conversion layer includes a mixture of an electron transport material, an organic pigment material, and a hole transport material,
the electron transport material has higher electron mobility than the organic pigment material,
the hole transport material has higher hole mobility than the organic pigment material,
a value $EA_{ET}$ of electron affinity of the electron transport material and a value $EA_{AB}$ of electron affinity of the organic pigment material have a relation expressed in Expression (1-1) below,
a value $IP_{HT}$ of an ionization potential of the hole transport material and a value $IP_{AB}$ of an ionization potential of the organic pigment material have a relation expressed in Expression (1-2) below, and
the value $EA_{ET}$ of electron affinity of the electron transport material and the value $IP_{HT}$ of the ionization potential of the hole transport material have a relation expressed in Expression (1-3) below:

$$EA_{ET} \geq EA_{AB} \qquad (1\text{-}1);$$

$$IP_{AB} \geq IP_{HT} \qquad (1\text{-}2);$$

and

$$IP_{HT} - EA_{ET} \geq 1.0\ \text{eV} \quad (1\text{-}3).$$

[A02] The imaging element according to [A01], in which $EA_{HT} \leq EA_{ET}$ and $IP_{HT} \leq IP_{ET}$ are satisfied.
[A03] The imaging element according to [A01] or [A02], in which the following is satisfied:

$$0.5\ \text{eV} \leq IP_{ET} - IP_{HT} \leq 0.7\ \text{eV} \qquad (2\text{-}1).$$

[A04] The imaging element according to any one of [A01] to [A03], in which the following is satisfied:

$$0.3\ \text{eV} \leq IP_{AB} - IP_{HT} \leq 1.1\ \text{eV} \qquad (2\text{-}2\text{-}A),$$

or

$$0.3\ eV \leq EA_{ET}-EA_{AB} \leq 1.1\ eV\quad (2\text{-}2\text{-}B).$$

[A05] The imaging element according to any one of [A01] to [A04], in which, in wavelengths of 450 nm to 700 nm, a maximum value of an optical absorption coefficient of the organic pigment material is greater than a value of an optical absorption coefficient of the electron transport material, greater than a value of an optical absorption coefficient of the hole transport material, or greater than the values of the optical absorption coefficients of the electron transport material and the hole transport material.
[A06] The imaging element according to any one of [A01] to [A05], in which a first charge injection block layer is provided between the first electrode and the organic photoelectric conversion layer.
[A07] The imaging element according to [A06], in which a first intermediate layer is provided between the first charge injection block layer and the organic photoelectric conversion layer.
[A08] The imaging element according to [A07], in which the first intermediate layer contains the electron transport material.
[A09] The imaging element according to [A01], in which a second charge injection block layer is provided between the second electrode and the organic photoelectric conversion layer.
[A10] The imaging element according to [A07], in which a second intermediate layer is provided between the second charge injection block layer and the organic photoelectric conversion layer.
[A11] The imaging element according to [A10], in which the second intermediate layer contains the hole transport material.
[A12] The imaging element according to any one of [A01] to [A11], in which when $\mu_{max}$ is carrier mobility of a material with fastest carrier mobility among the materials of the organic photoelectric conversion layer,
The following is satisfied:

$$1\times10^{-5}cm^2/V\cdot s \leq \mu_{max} \leq 1\times10^{-1}cm^2/V\cdot s.$$

[A13] The imaging element according to any one of [A01] to [A12], in which the organic pigment material preferably contains a subphthalocyanine derivative expressed in the following structure Formula (10).

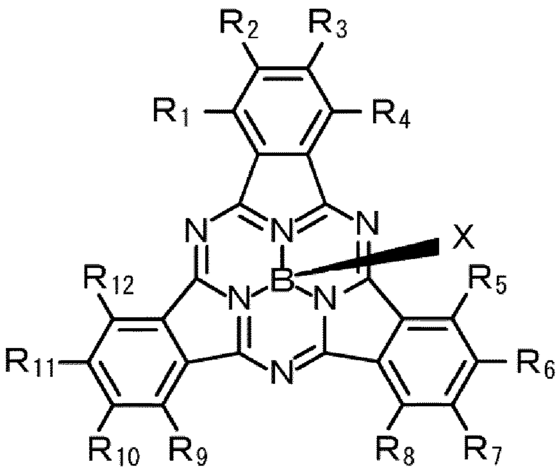

(10)

Here, X and R1 to R12 are each independently at least one type of group selected from a group composed of a hydrogen atom; and a halogen atom including chlorine and fluorine; or a linear, branched or cyclic alkyl group or phenyl group; a linear or condensed aromatic ring; a partial fluoroalkyl group; a perfluoroalkyl group; a silylalkyl group; a silylalkoxy group; an arylsilyl group; a thioalkyl group; a thioaryl group; an arylsulfonyl group; an alkylsulfonyl group; an amino group; an alkylamino group; an arylamino group; a hydroxy group; an alkoxy group; an acylamino group; an acyloxy group; a phenyl group; a carboxy group, a carboxamide group, a carboalkoxy group, an acyl group; a sulfonyl group; a cyano group; and a nitro group. A bivalent or trivalent metal may also be used instead of B (boron).
[A14] The imaging element according to any one of [A01] to [A13],

in which the photoelectric conversion unit is disposed above a semiconductor substrate, and
the first electrode is connected to a charge storage portion formed in the semiconductor substrate to store a charge generated in the organic photoelectric conversion layer and a gate portion of an amplification transistor formed in the semiconductor substrate.
[B01] << stacked-type imaging element>>
A stacked-type imaging element including:
the at least one imaging element according to any one of [A01] to [A14].
[C01] << solid-state imaging apparatus: first aspect>>
A solid-state imaging apparatus including:
a plurality of the imaging elements according to any one of [A01] to [A14].
[C02] « solid-state imaging apparatus: third aspect»
A solid-state imaging apparatus including:
a plurality of the stacked-type imaging elements according to [B01].

Reference Signs List

| | |
|---|---|
| 11 | first electrode |
| 12 | second electrode |
| 13 | organic photoelectric conversion layer |
| 41 | n-type semiconductor region forming second imaging element |
| 43 | n-type semiconductor region forming third imaging element |
| 42, 44, 73p$^+$ | layer |
| 45 | gate portion of transfer transistor |
| 46 | gate portion of transfer transistor |
| $FD_1$, $FD_{21}$, $FD_3$, 45C, 46C | floating diffusion layer |
| $TR1_{amp}$ | amplification transistor |
| $TR1_{rst}$ | reset transistor |
| $TR1_{sel}$ | select transistor |
| $TR2_{trs}$ | transfer transistor |
| $TR2_{trs}$ | reset transistor |
| $TR2_{amp}$ | amplification transistor |
| $TR2_{sel}$ | select transistor |
| $TR3_{trs}$ | transfer transistor |
| $TR3_{rst}$ | reset transistor |
| $TR3_{amp}$ | amplification transistor |
| $TR3_{SEL}$ | select transistor |
| $V_{DD}$ | power supply |
| $RST_1$, $RST_2$, $RST_3$ | reset line |
| $SEL_1$, $SEL_2$, $SEL_3$ | select line |
| 117, $VSL_1$, $VSL_2$, $VSL_3$ | signal line |
| $TG_2$, $TG_3$ | transfer gate line |
| $V_{OU}$ | wiring |
| 51 | gate section of reset transistor $TR1_{rst}$ |
| 51A | channel forming region of reset transistor $TR1_{rst}$ |
| 51B, 51C | source/drain region of reset transistor $TR1_{rst}$ |
| 52 | gate section of amplification transistor $TR1_{amp}$ |
| 52A | channel forming region of amplification transistor $TR1_{amp}$ |
| 52B, 52C | source/drain region of amplification transistor $TR1_{amp}$ |
| 53 | gate section of select transistor $TR1_{sel}$ |
| 53A | channel forming region of select transistor $TR1_{sel}$ |
| 53B, 53C | source/drain region of select transistor $TR1_{sel}$ |
| 61 | contact hole portion |
| 62 | wiring layer |
| 63 | pad portion |
| 64 | connection hole |
| 70 | semiconductor substrate |

| | |
|---|---|
| 70A | first surface (front surface) of semiconductor substrate |
| 70B | second surface (back surface) of semiconductor substrate |
| 71 | element separation region |
| 72 | oxide film |
| 74 | $HfO_2$ film |
| 75 | insulating film |
| 76 | interlayer insulating layer |
| 77, 78, 81 | interlayer insulating layer |
| 82 | protective layer |
| 90 | on-chip microlens |
| 91 | light shielding layer |
| 100 | solid-state imaging apparatus |
| 101 | stacked-type imaging element |
| 111 | imaging area |
| 112 | vertical drive circuit |
| 113 | column signal processing circuit |
| 114 | horizontal drive circuit |
| 115 | output circuit |
| 116 | drive control circuit |
| 118 | horizontal signal line |
| 200 | electronic device (camera) |
| 201 | solid-state imaging apparatus |
| 210 | optical lens |
| 211 | shutter device |
| 212 | drive circuit |
| 213 | signal processing circuit |

**Claims**

**1.** An imaging element comprising:

a photoelectric conversion unit including a stacked structure of a first electrode, an organic photoelectric conversion layer, and a second electrode,
wherein the organic photoelectric conversion layer includes a mixture of an electron transport material, an organic pigment material, and a hole transport material,
the electron transport material has higher electron mobility than the organic pigment material,
the hole transport material has higher hole mobility than the organic pigment material,
a value $EA_{ET}$ of electron affinity of the electron transport material and a value $EA_{AB}$ of electron affinity of the organic pigment material have a relation expressed in Expression (1-1) below,
a value $IP_{HT}$ of an ionization potential of the hole transport material and a value $IP_{AB}$ of an ionization potential of the organic pigment material have a relation expressed in Expression (1-2) below, and
the value $EA_{ET}$ of electron affinity of the electron transport material and the value $IP_{HT}$ of the ionization potential of the hole transport material have a relation expressed in Expression (1-3) below:

$$EA_{ET} \geq EA_{AB} \quad (1\text{-}1);$$

$$IP_{AB} \geq IP_{HT} \quad (1\text{-}2);$$

and

$$IP_{HT} - EA_{ET} \geq 1.0\ eV \quad (1\text{-}3).$$

**2.** The imaging element according to claim 1, wherein $EA_{HT} \leq EA_{ET}$ and $IP_{HT} \leq IP_{ET}$ are satisfied.

**3.** The imaging element according to claim 1, wherein, in wavelengths of 450 nm to 700 nm, a maximum value of an optical absorption coefficient of the organic pigment material is greater than a value of an optical absorption coefficient of the electron transport material, greater than a value of an optical absorption coefficient of the hole transport material, or greater than the values of the optical absorption coefficients of the electron transport material and the hole transport material.

**4.** The imaging element according to claim 1, wherein a first charge injection block layer is provided between the first electrode and the organic photoelectric conversion layer.

**5.** The imaging element according to claim 4, wherein a first intermediate layer is provided between the first charge injection block layer and the organic photoelectric conversion layer.

**6.** The imaging element according to claim 5, wherein the first intermediate layer contains the electron transport material.

**7.** The imaging element according to claim 1, wherein a second charge injection block layer is provided between the second electrode and the organic photoelectric conversion layer.

**8.** The imaging element according to claim 7, wherein a second intermediate layer is provided between the second charge injection block layer and the organic photoelectric conversion layer.

**9.** The imaging element according to claim 8, wherein the second intermediate layer contains the hole transport material.

**10.** The imaging element according to claim 1, wherein the photoelectric conversion unit is disposed above a semiconductor substrate, and the first electrode is connected to a charge storage portion formed in the semiconductor substrate to store a charge generated in the organic photoelectric conversion layer and a gate portion of an amplification transistor formed in the semiconductor substrate.

**11.** A stacked-type imaging element comprising:
the at least one imaging element according to any one of claims 1 to 10.

**12.** A solid-state imaging apparatus comprising:
a plurality of the imaging elements according to any one of claims 1 to 10.

**13.** A solid-state imaging apparatus comprising:
a plurality of the stacked-type imaging elements according to claim 11.

FIG. 1

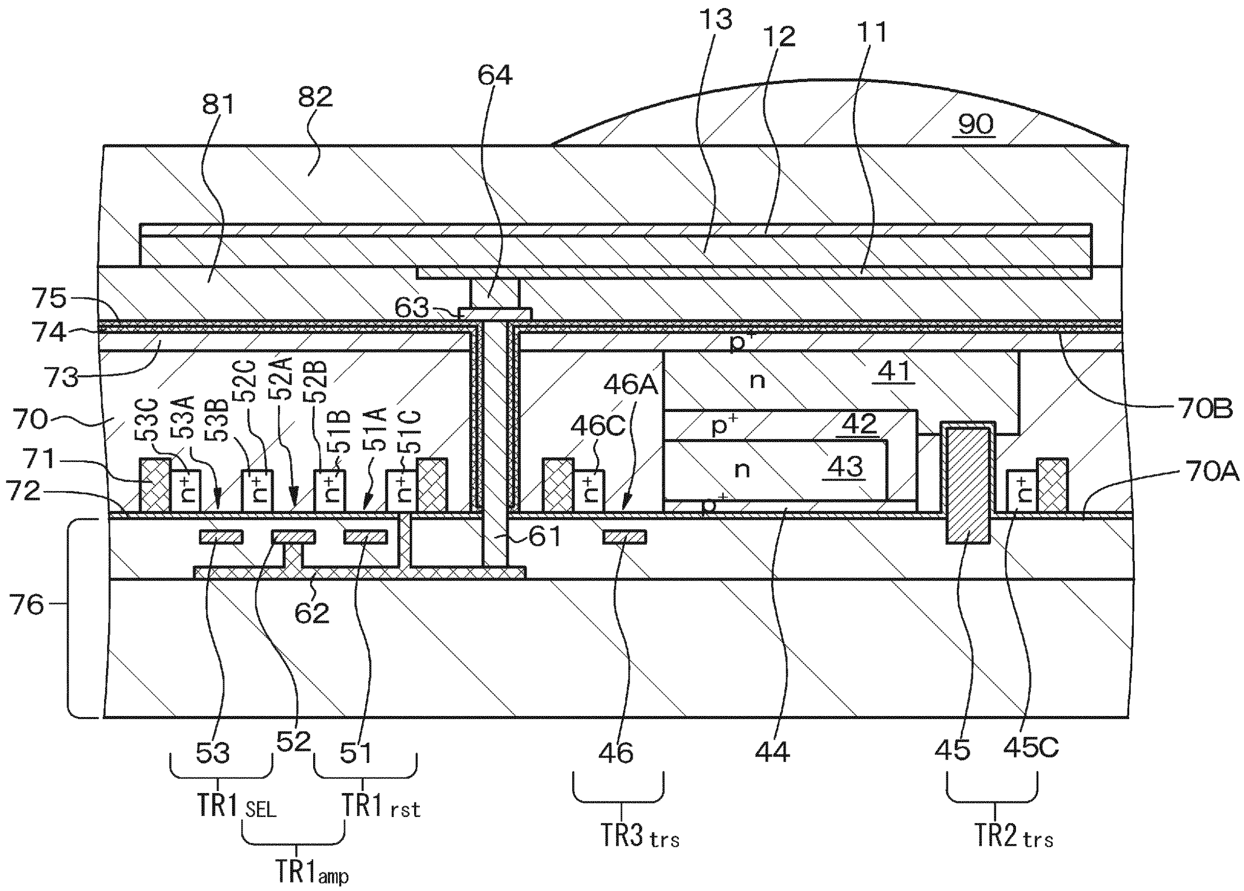
13
12
11
64
81
82
90
75
74
63
73
70
71
72
53C
53A
53B
52C
52A
52B
51B
51A
51C
46A
46C
41
42
43
p+
n
p+
n
p+
n+
70B
70A
61
62
76
53
52
51
46
44
45
45C
TR1SEL
TR1rst
TR1amp
TR3trs
TR2trs

FIG. 2

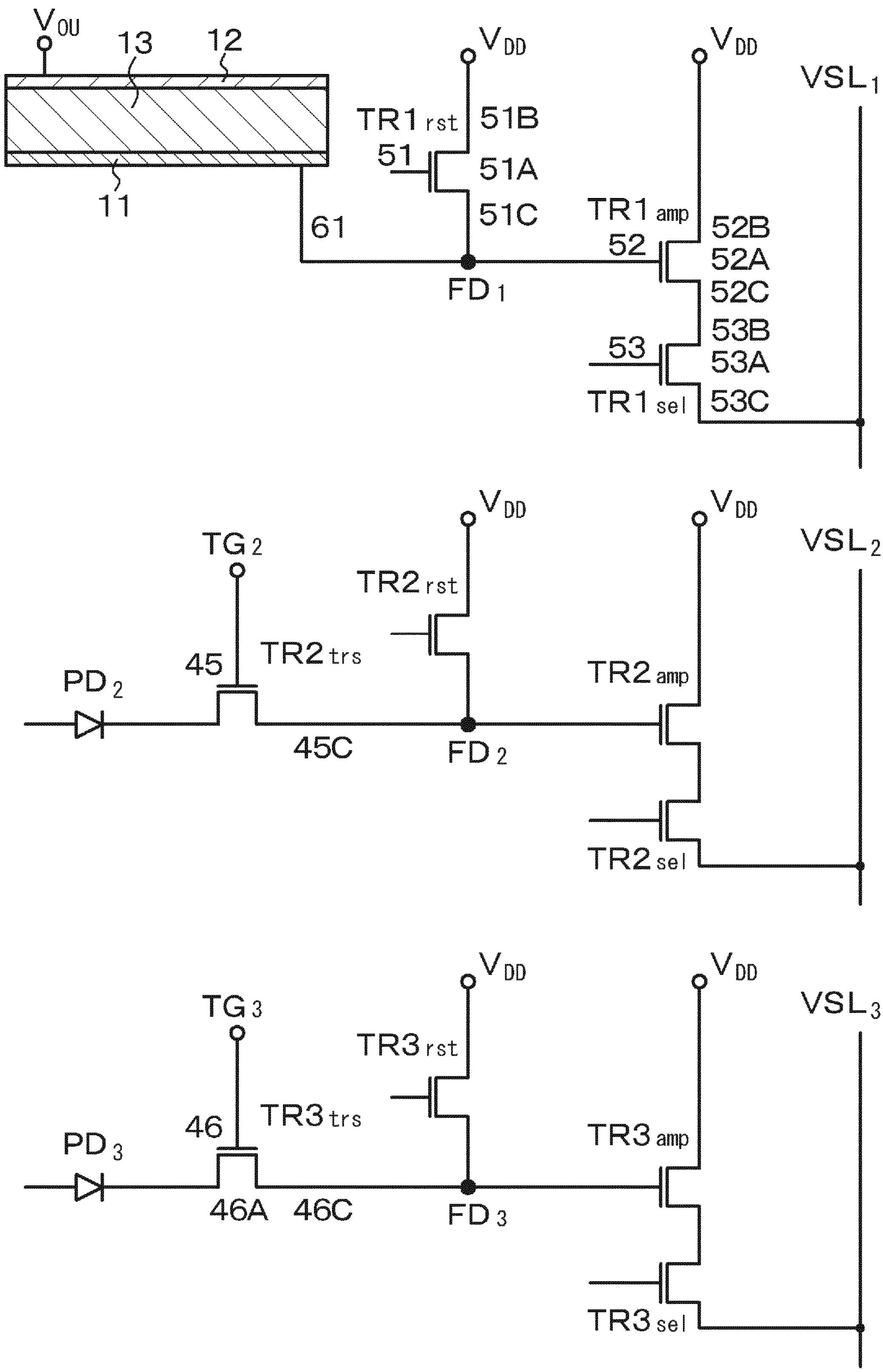

$V_{OU}$
13
12
11
61
$V_{DD}$
TR1 rst
51B
51
51A
51C
FD 1
TR1 amp
52B
52
52A
52C
53B
53
53A
TR1 sel
53C
$VSL_1$
TG 2
PD 2
45
TR2 trs
45C
TR2 rst
FD 2
TR2 amp
TR2 sel
$VSL_2$
TG 3
PD 3
46
TR3 trs
46A
46C
TR3 rst
FD 3
TR3 amp
TR3 sel
$VSL_3$

FIG. 3

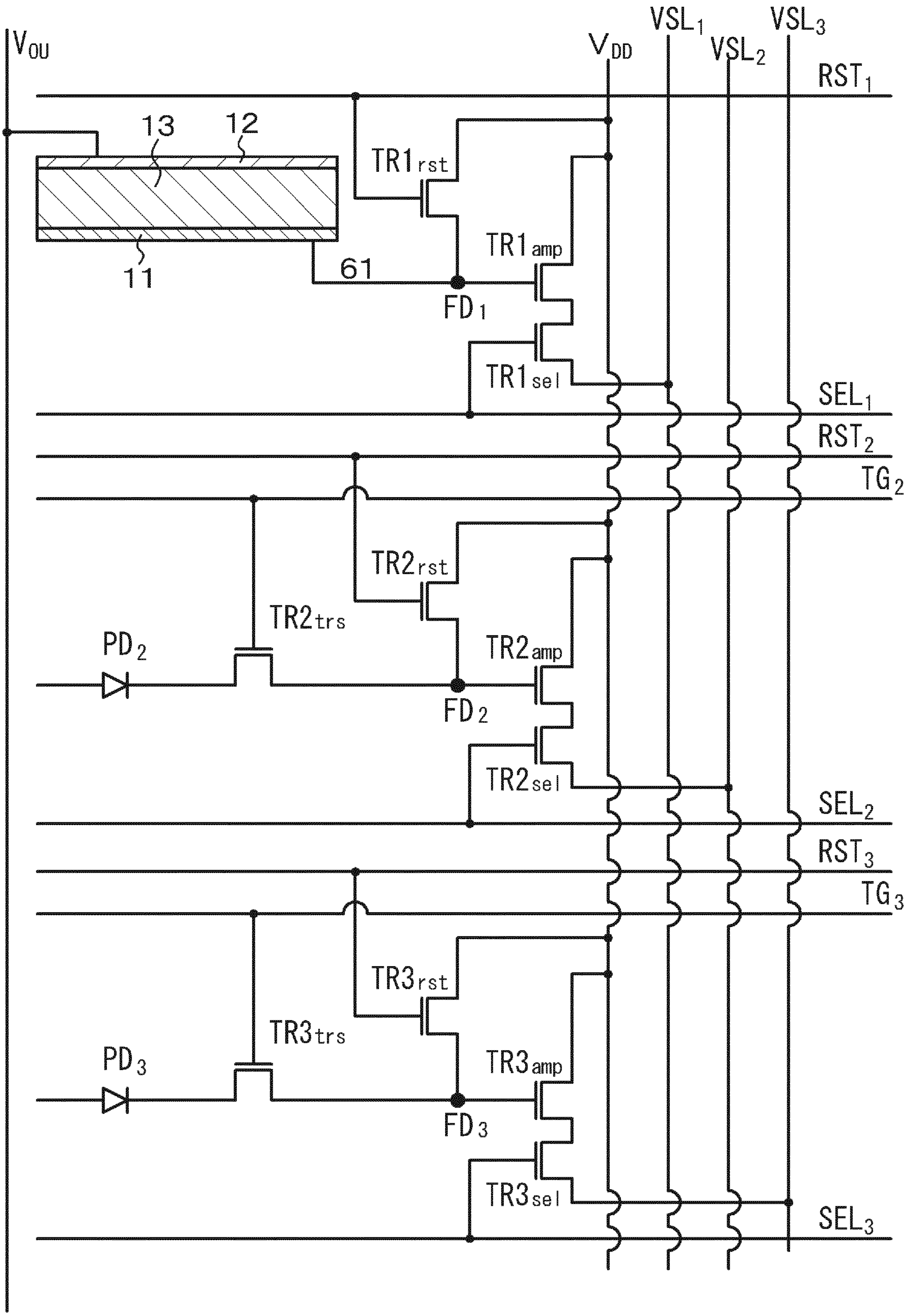

VOU
VDD
VSL1
VSL2
VSL3
RST1
13
12
11
61
TR1rst
TR1amp
FD1
TR1sel
SEL1
RST2
TG2
TR2rst
TR2trs
PD2
TR2amp
FD2
TR2sel
SEL2
RST3
TG3
TR3rst
TR3trs
PD3
TR3amp
FD3
TR3sel
SEL3

FIG. 4

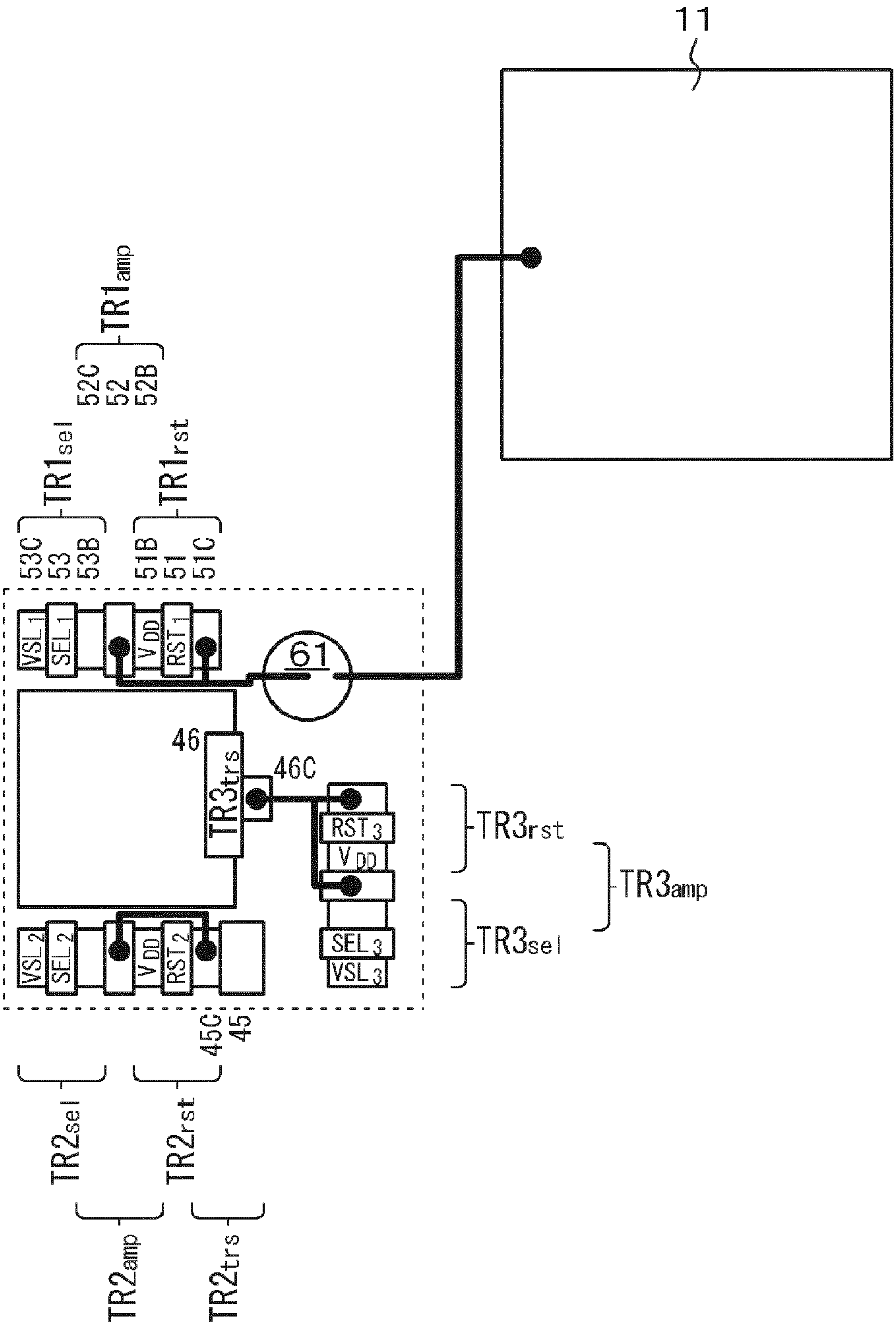
11
TR1amp
52C
52
52B
TR1sel
TR1rst
53C
53
53B
51B
51
51C
VSL1
SEL1
VDD
RST1
61
46
TR3trs
46C
RST3
VDD
TR3rst
TR3amp
TR3sel
SEL3
VSL3
VSL2
SEL2
VDD
RST2
45C
45
TR2sel
TR2rst
TR2amp
TR2trs

FIG. 5

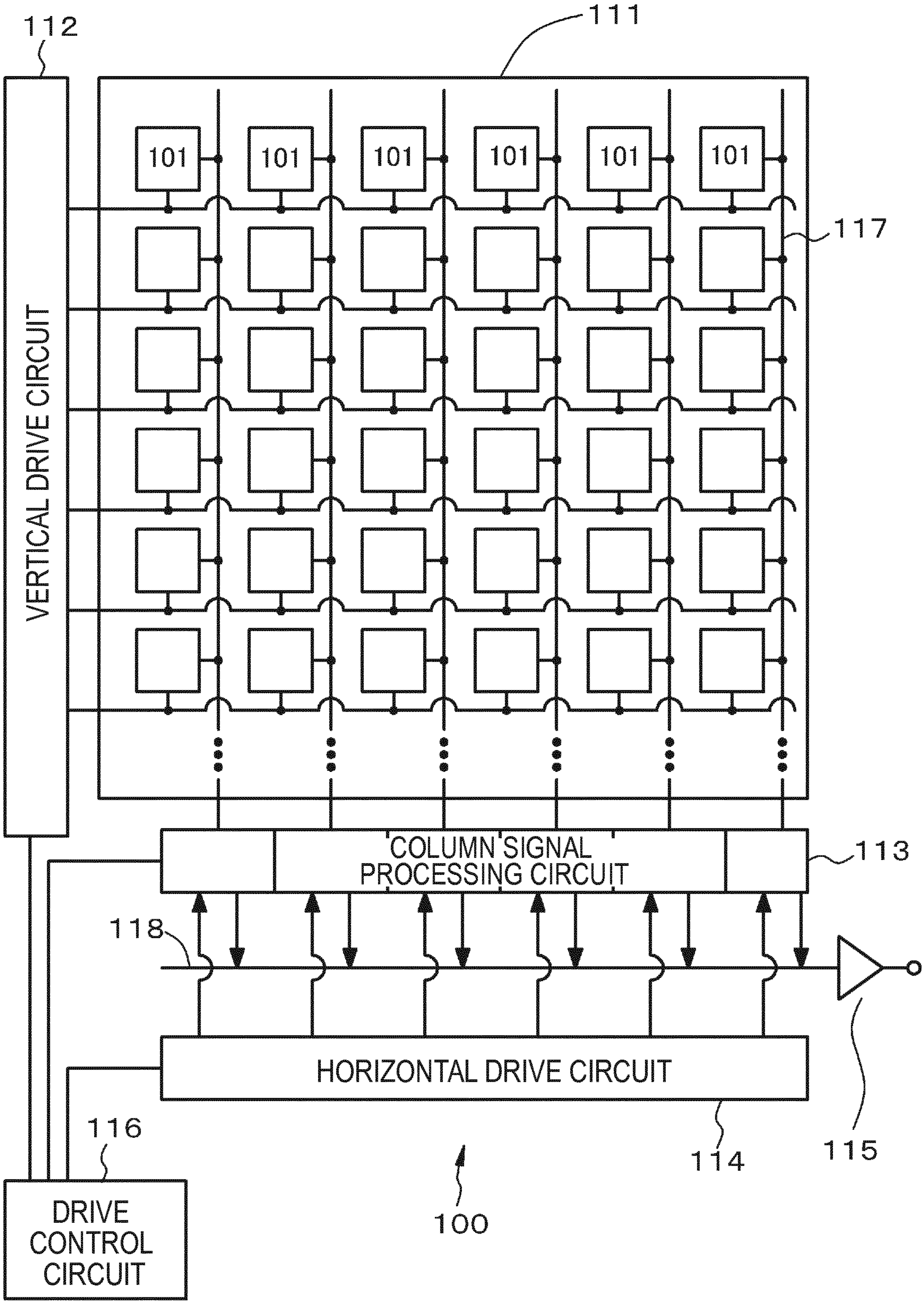
111
112
101
101
101
101
101
101
117
VERTICAL DRIVE CIRCUIT
COLUMN SIGNAL PROCESSING CIRCUIT
113
118
HORIZONTAL DRIVE CIRCUIT
116
DRIVE CONTROL CIRCUIT
114
115
100

FIG. 6

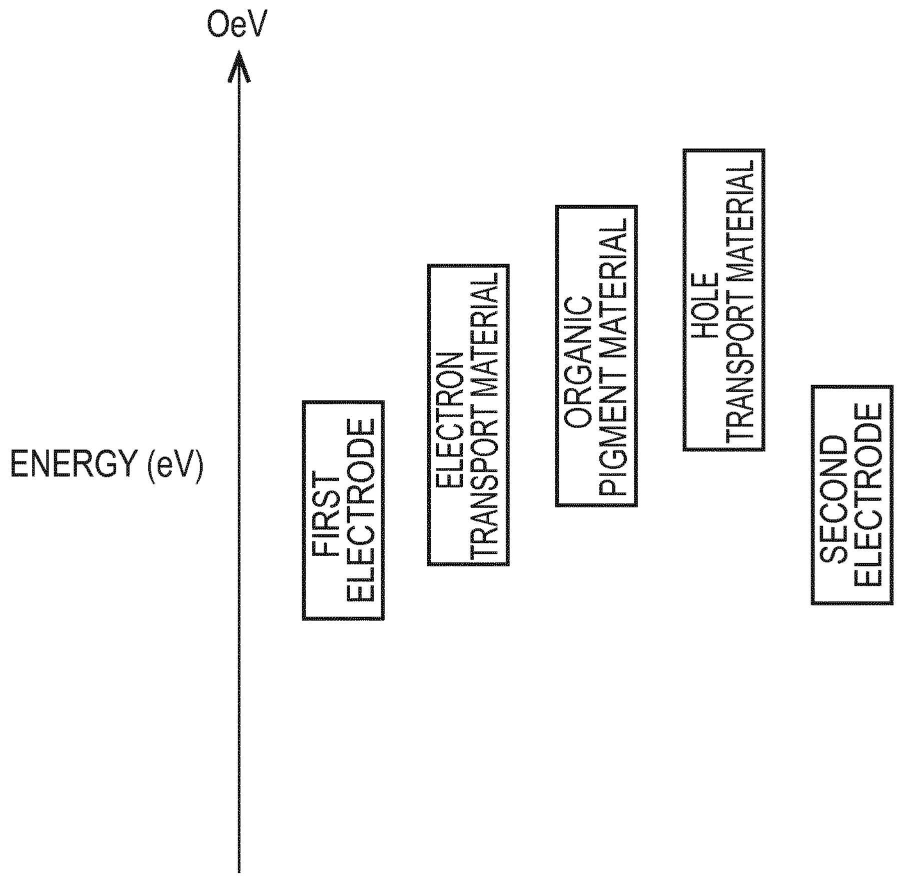
OeV
ENERGY (eV)
FIRST ELECTRODE
ELECTRON TRANSPORT MATERIAL
ORGANIC PIGMENT MATERIAL
HOLE TRANSPORT MATERIAL
SECOND ELECTRODE

FIG. 7

FIG. 7A

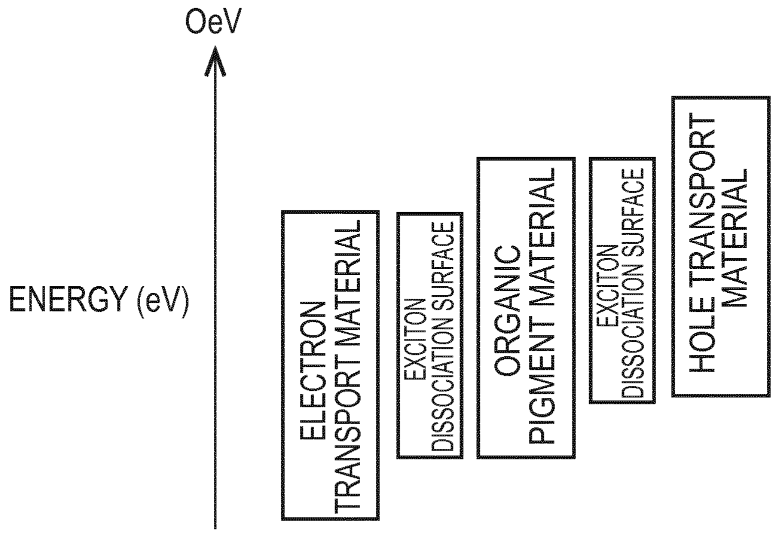


FIG. 7B

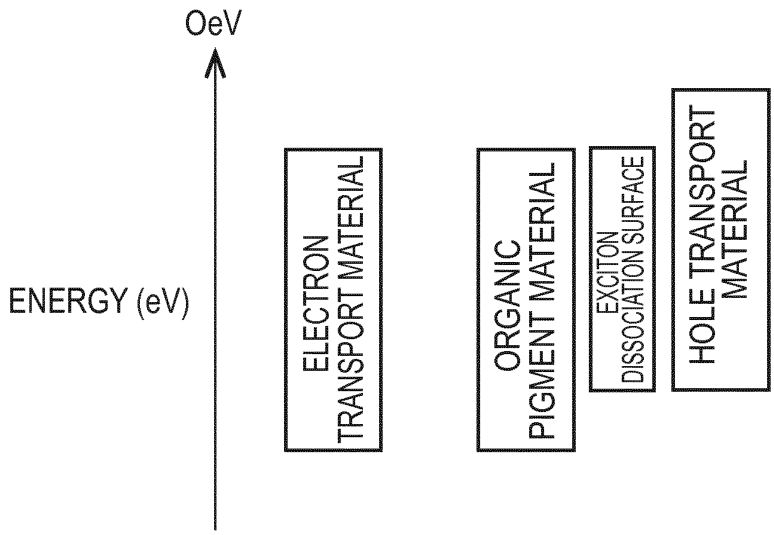


FIG. 7C

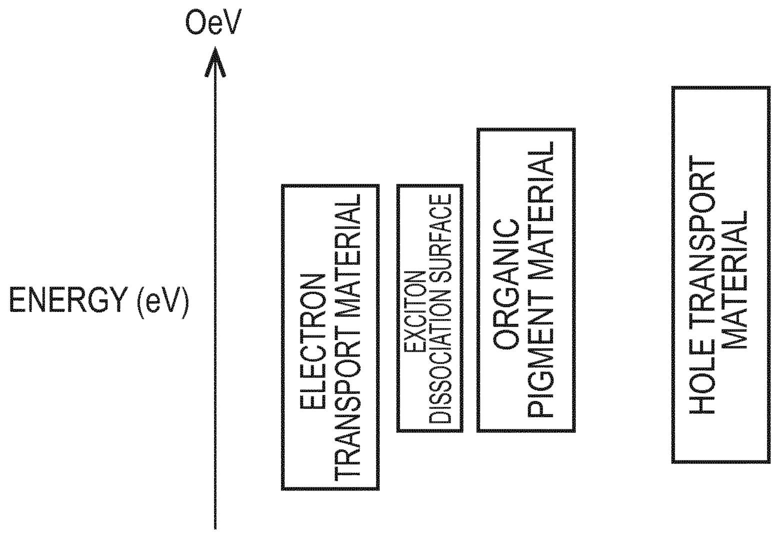

FIG. 8

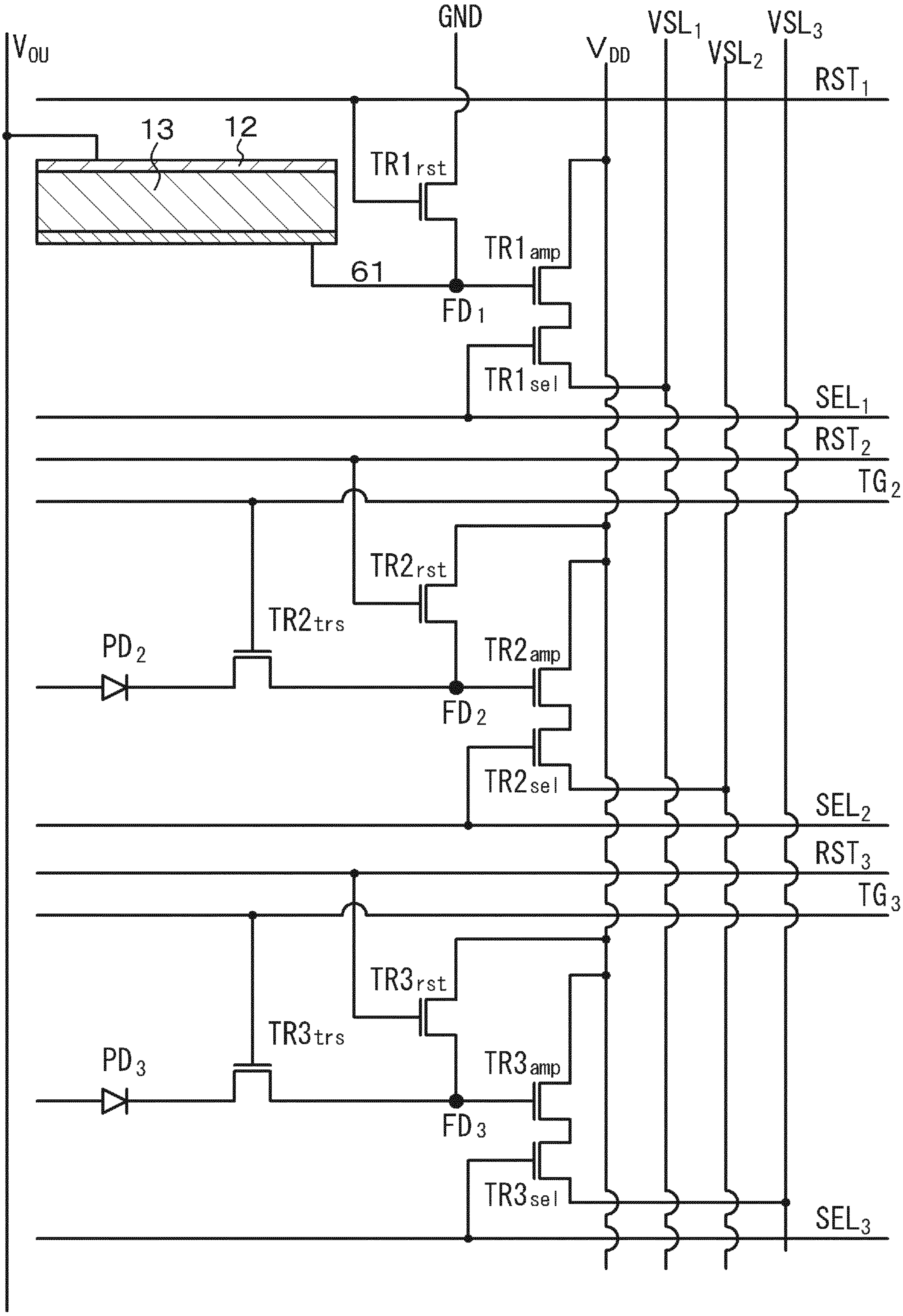
GND
VSL1
VSL3
VOU
VDD
VSL2
RST1
13
12
TR1rst
TR1amp
61
FD1
TR1sel
SEL1
RST2
TG2
TR2rst
TR2trs
PD2
TR2amp
FD2
TR2sel
SEL2
RST3
TG3
TR3rst
TR3trs
PD3
TR3amp
FD3
TR3sel
SEL3

FIG. 9

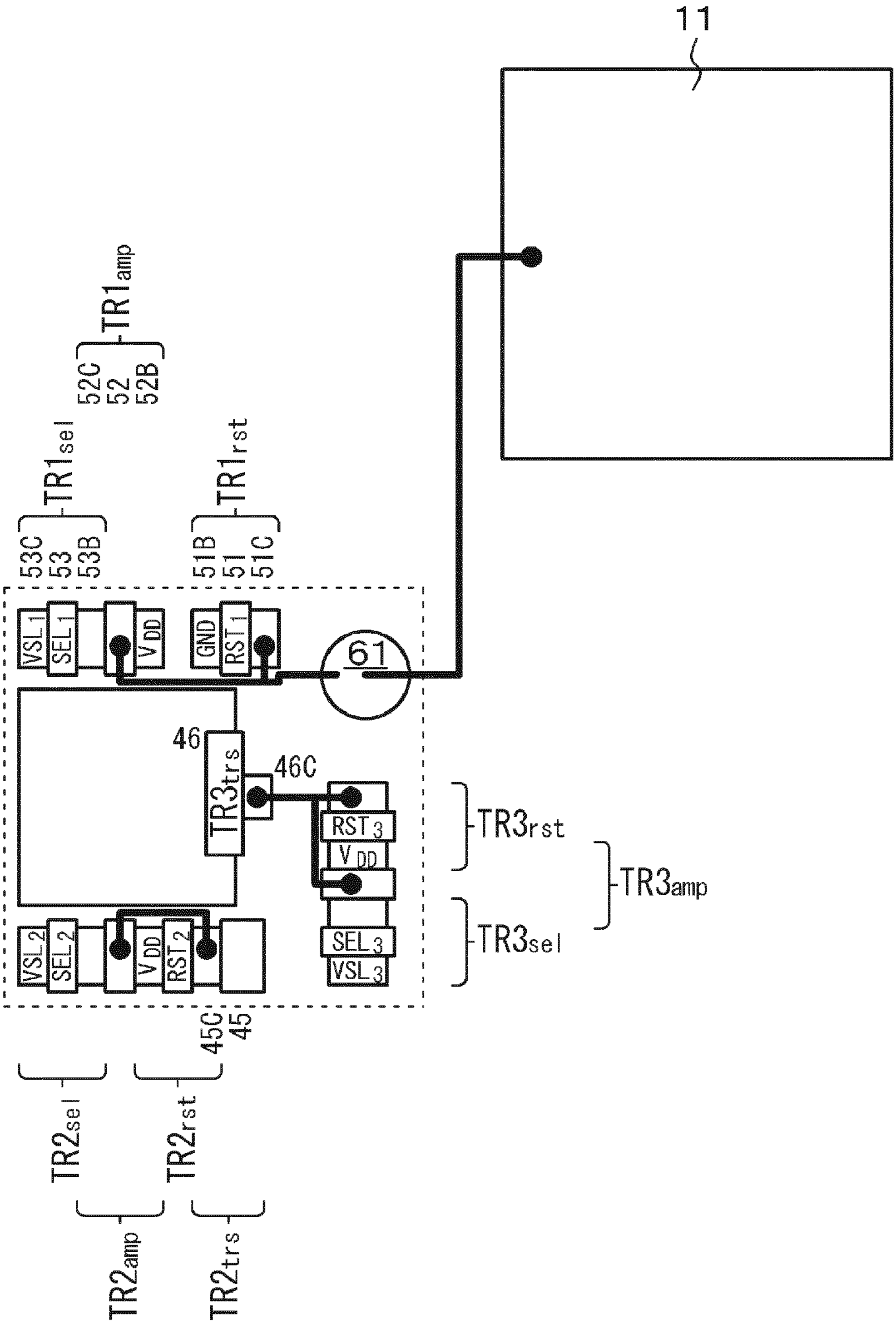
11
TR1amp
52C
52
52B
TR1sel
53C
53
53B
TR1rst
51B
51
51C
VSL1
SEL1
VDD
GND
RST1
61
46
TR3trs
46C
RST3
VDD
SEL3
VSL3
TR3rst
TR3amp
TR3sel
VSL2
SEL2
VDD
RST2
45C
45
TR2sel
TR2rst
TR2amp
TR2trs

FIG. 10

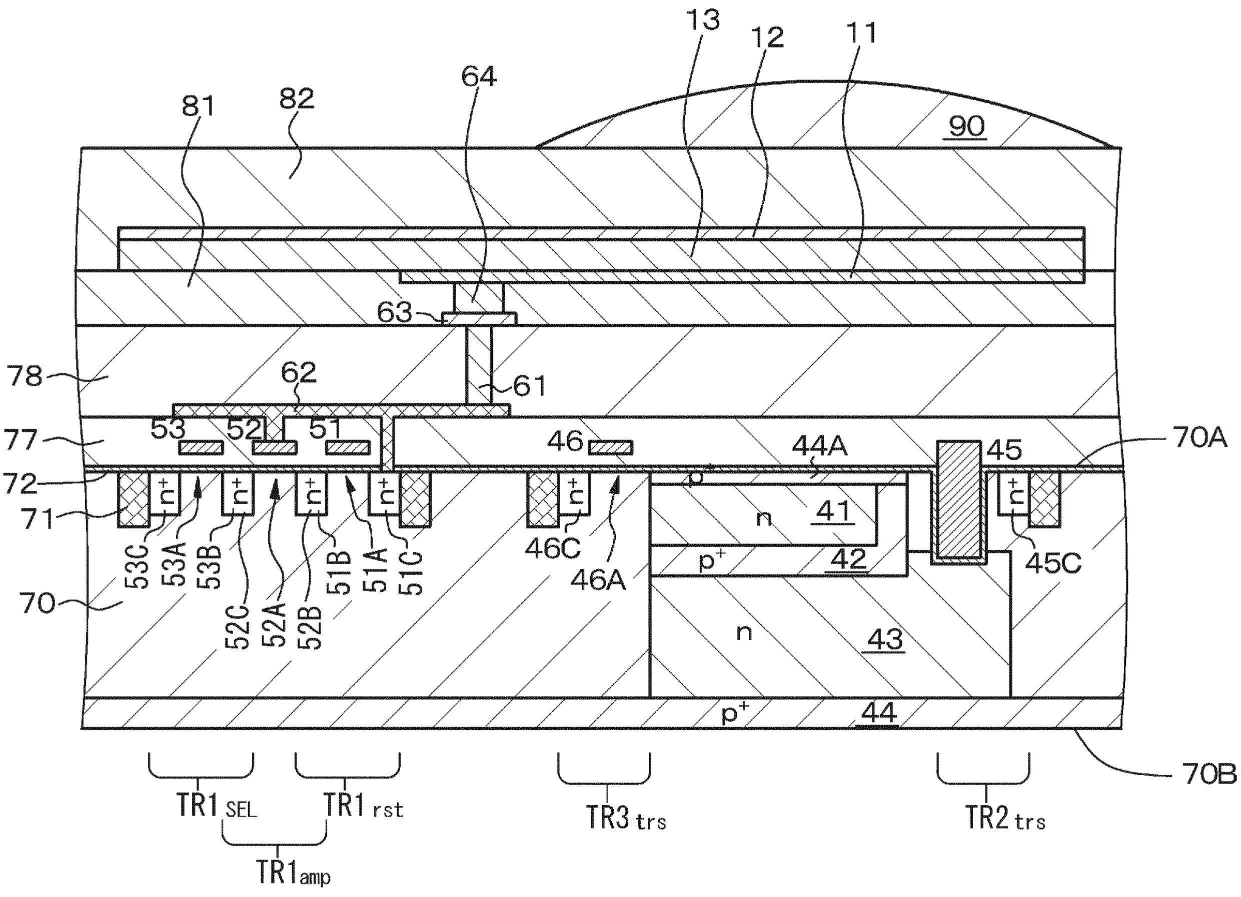
13
12
11
64
81
82
90
63
78
62
61
53
52
51
77
46
44A
45
70A
72
71
n+
p+
n
41
p+
42
53C
53A
53B
52C
52A
52B
51B
51A
51C
46C
46A
45C
70
n
43
p+
44
70B
TR1SEL
TR1rst
TR3trs
TR2trs
TR1amp

FIG. 11

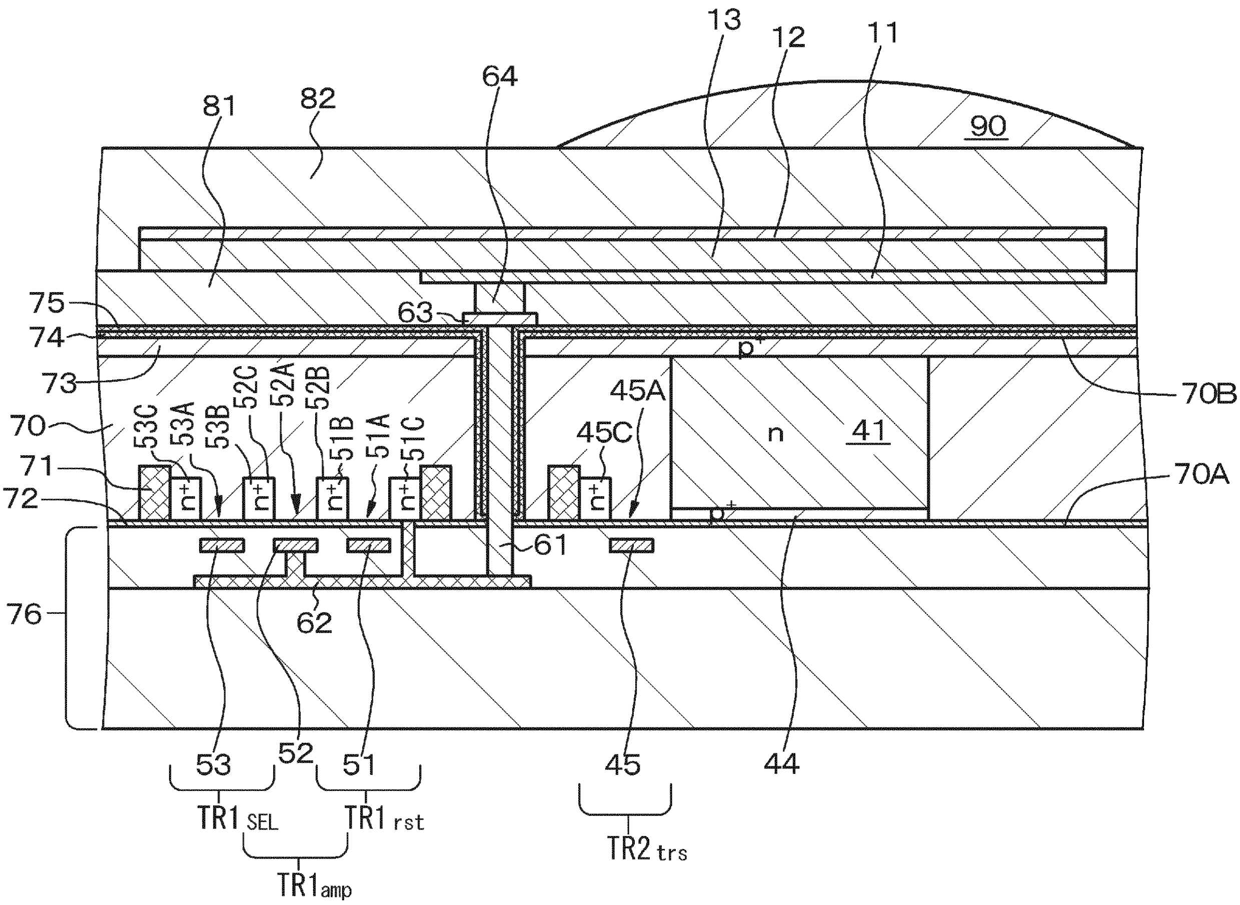
13
12
11
64
81
82
90
75
74
73
63
70B
45A
n
41
70
71
72
53C
53A
53B
52C
52A
52B
51B
51A
51C
45C
p+
n+
70A
61
62
76
53
52
51
45
44
TR1 SEL
TR1 rst
TR1amp
TR2 trs

FIG. 12

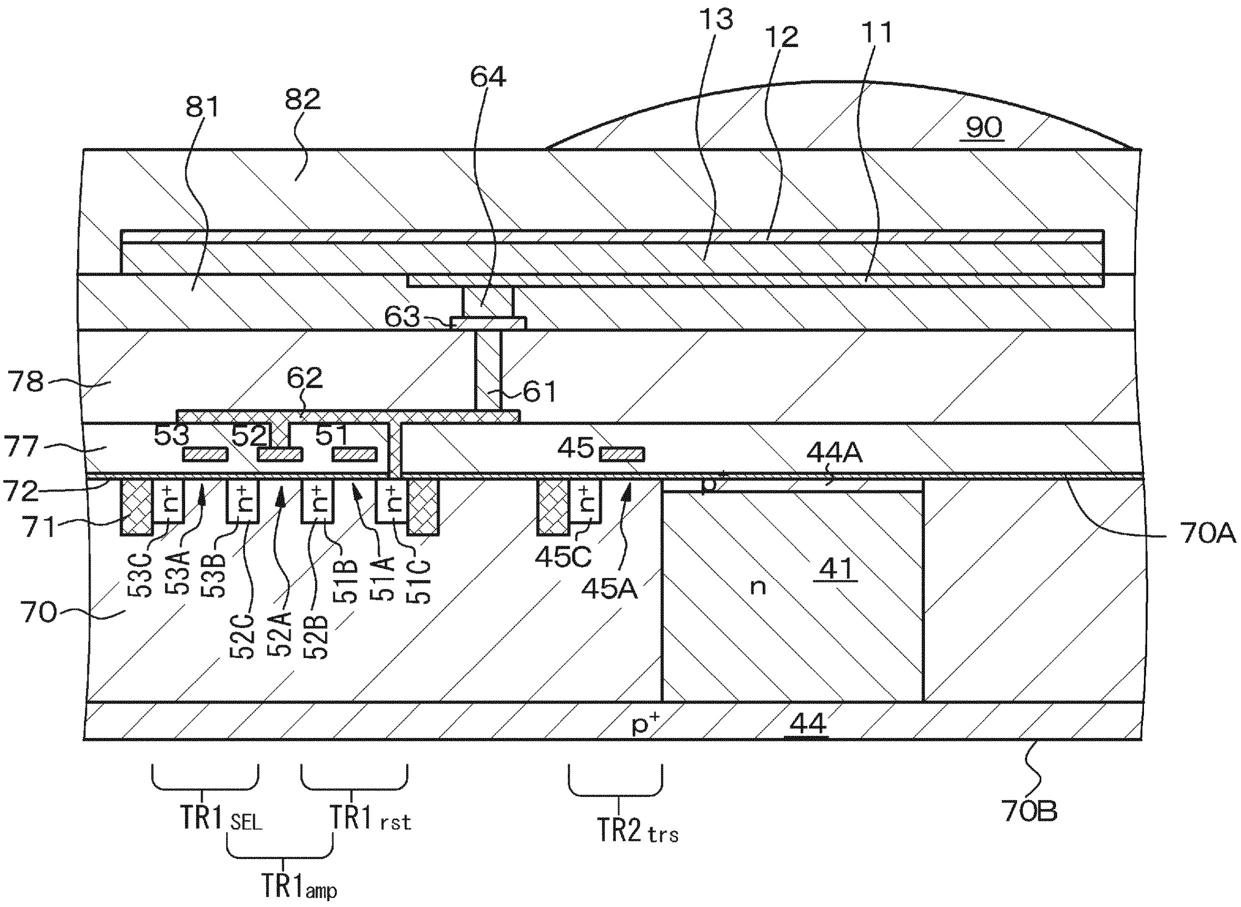
13
12
11
64
81
82
90
63
78
62
61
77
53
52
51
45
44A
72
p+
71
n+
70A
53C
53A
53B
51B
51A
51C
45C
45A
41
n
70
52C
52A
52B
p+
44
TR1 SEL
TR1 rst
TR2 trs
70B
TR1amp

**FIG. 13**

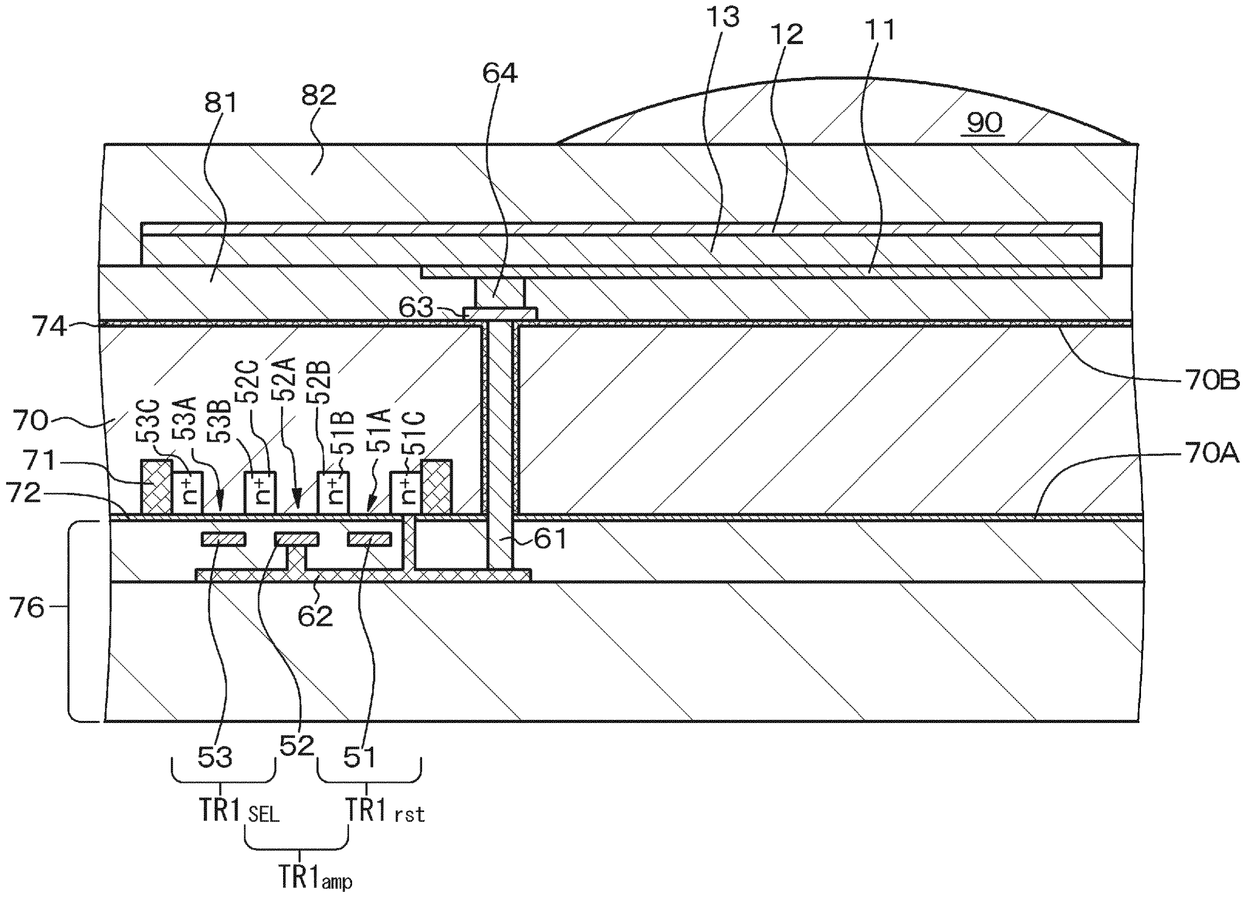
13
12
11
64
81
82
90
63
74
70B
70
53C
53A
53B
52C
52A
52B
51B
51A
51C
71
70A
72
n+
61
76
62
53
52
51
TR1 SEL
TR1 rst
TR1amp

FIG. 14

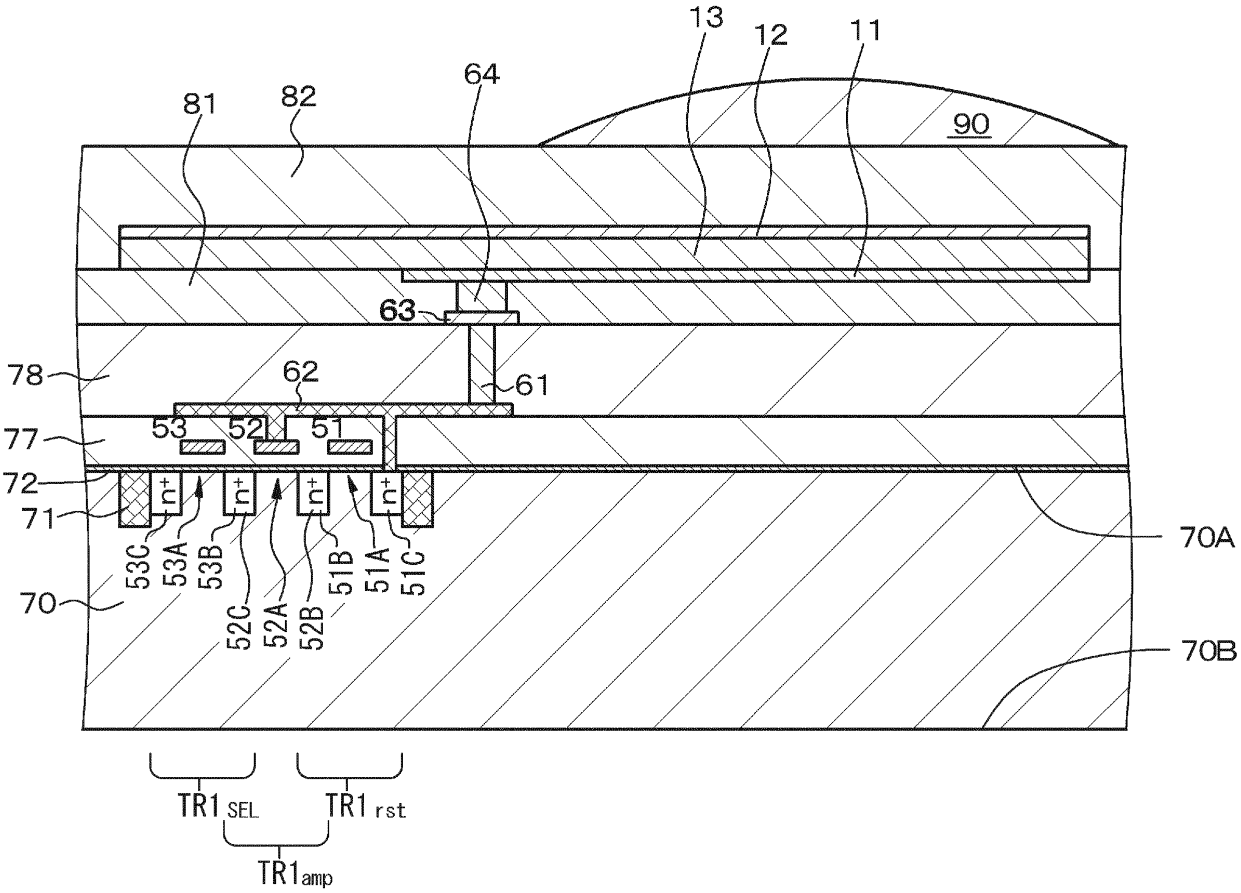

13
12
11
64
81
82
90
63
62
61
78
77
53
52
51
72
71
70
53C
53A
53B
52C
52A
52B
51B
51A
51C
70A
70B
n+
TR1 SEL
TR1 rst
TR1amp

**FIG. 15**

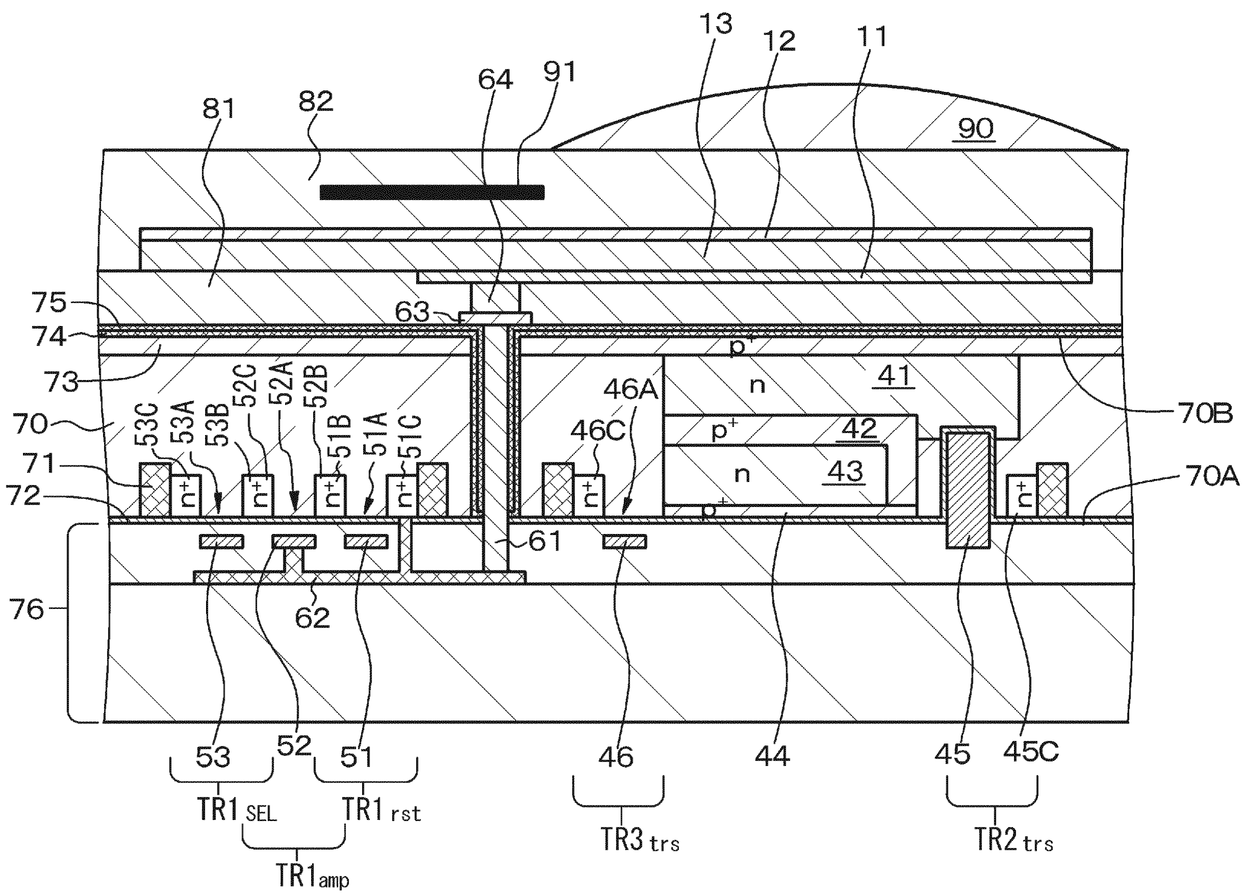

13
12
11
64
91
81
82
90
75
74
63
p+
73
n
41
70B
46A
70
53C
53A
53B
52C
52A
52B
51B
51A
51C
46C
p+
42
71
n+
n
43
70A
72
p+
61
76
62
53
52
51
46
44
45
45C
TR1SEL
TR1rst
TR1amp
TR3trs
TR2trs

FIG. 16

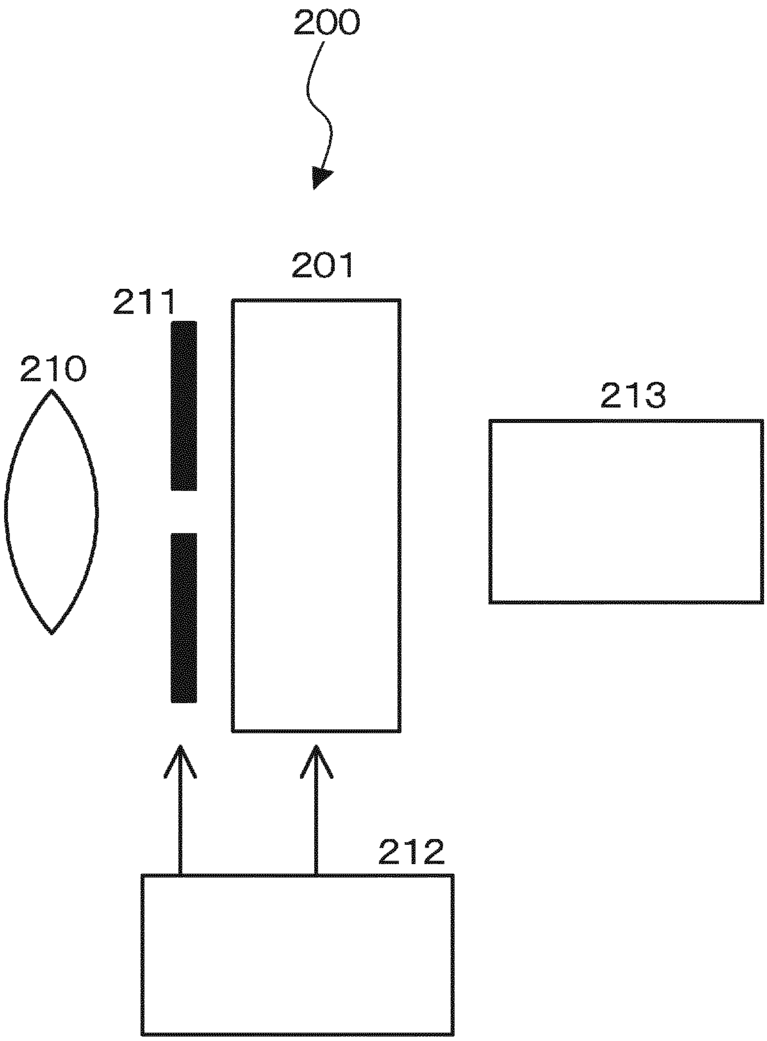

FIG. 17

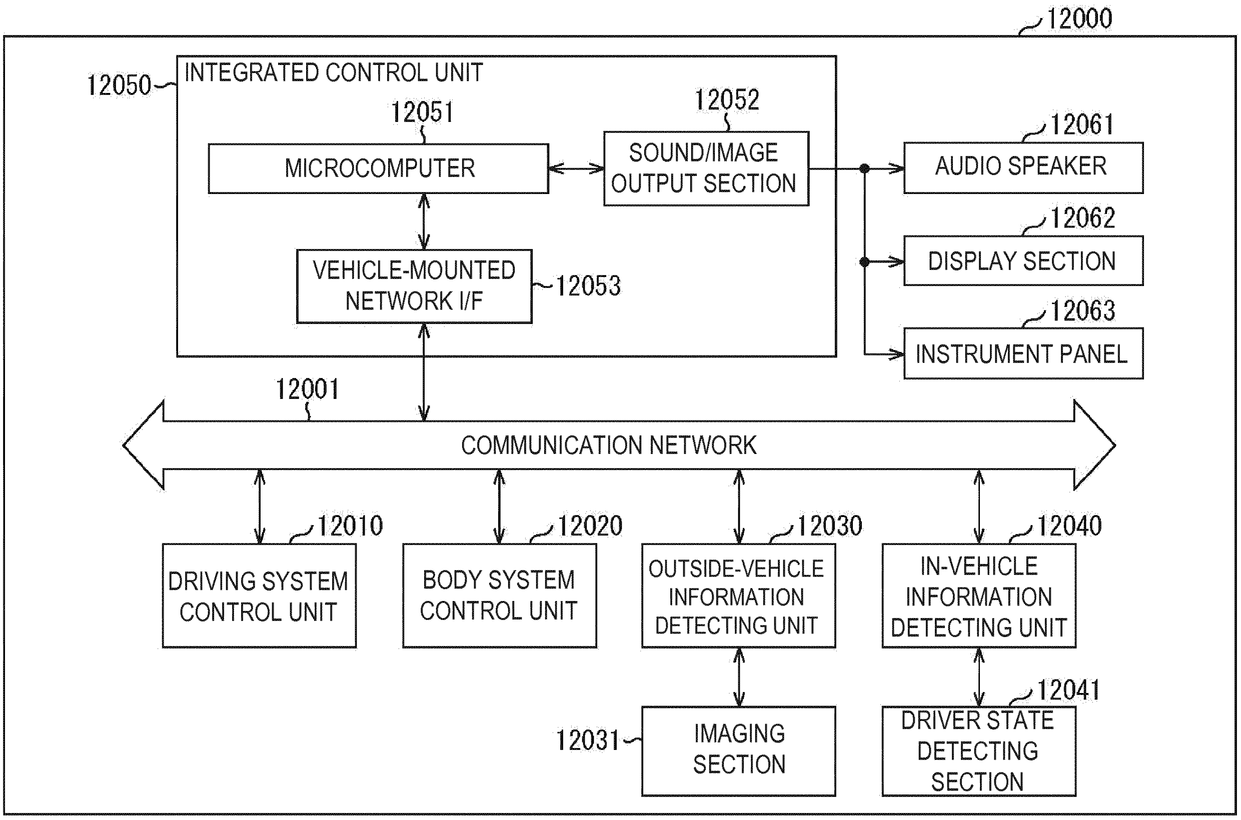
12000
12050
INTEGRATED CONTROL UNIT
12051
MICROCOMPUTER
12052
SOUND/IMAGE OUTPUT SECTION
VEHICLE-MOUNTED NETWORK I/F
12053
12061
AUDIO SPEAKER
12062
DISPLAY SECTION
12063
INSTRUMENT PANEL
12001
COMMUNICATION NETWORK
12010
DRIVING SYSTEM CONTROL UNIT
12020
BODY SYSTEM CONTROL UNIT
12030
OUTSIDE-VEHICLE INFORMATION DETECTING UNIT
12040
IN-VEHICLE INFORMATION DETECTING UNIT
12031
IMAGING SECTION
12041
DRIVER STATE DETECTING SECTION

FIG. 18

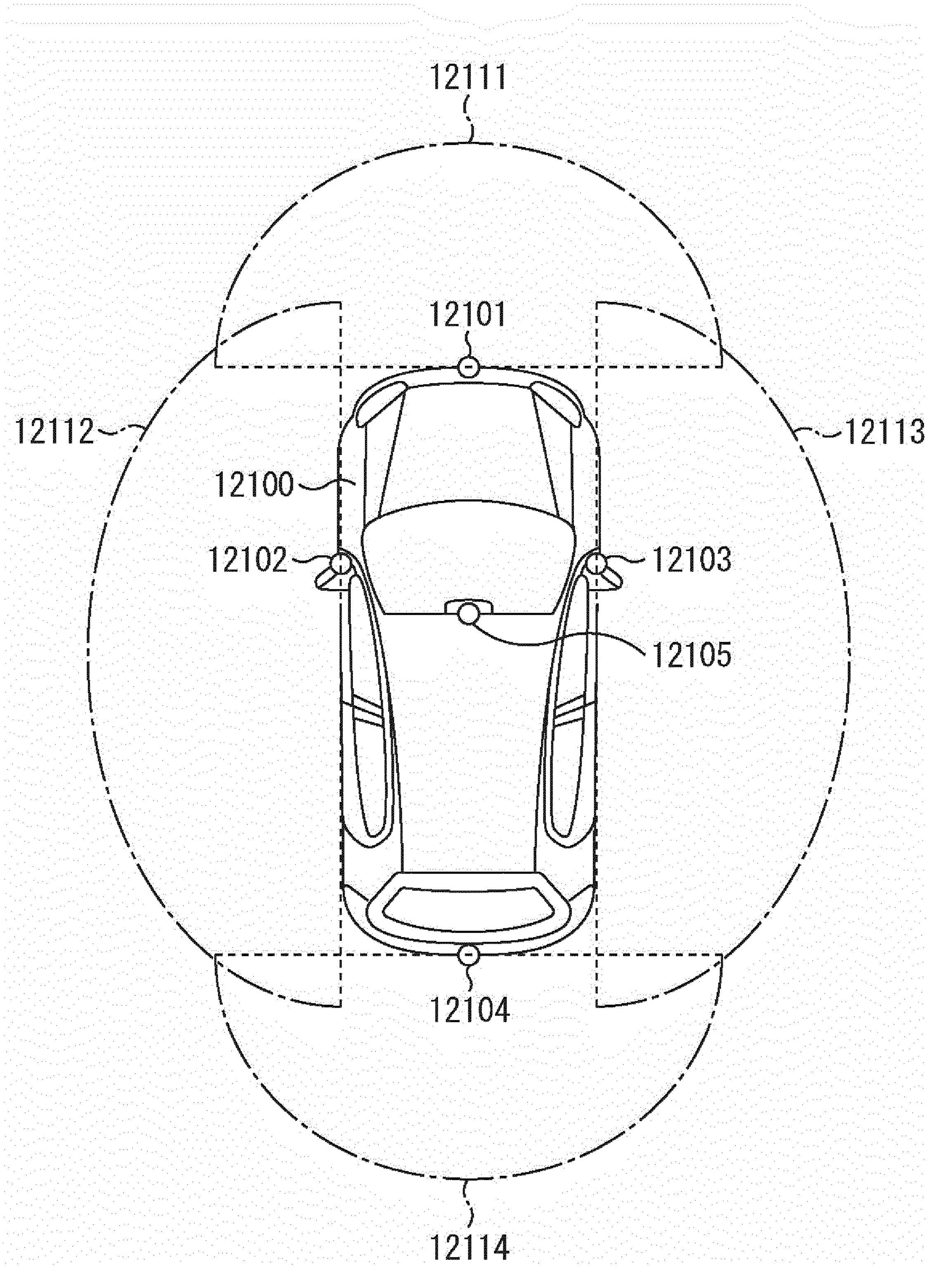
12111
12101
12112
12113
12100
12102
12103
12105
12104
12114

FIG. 19

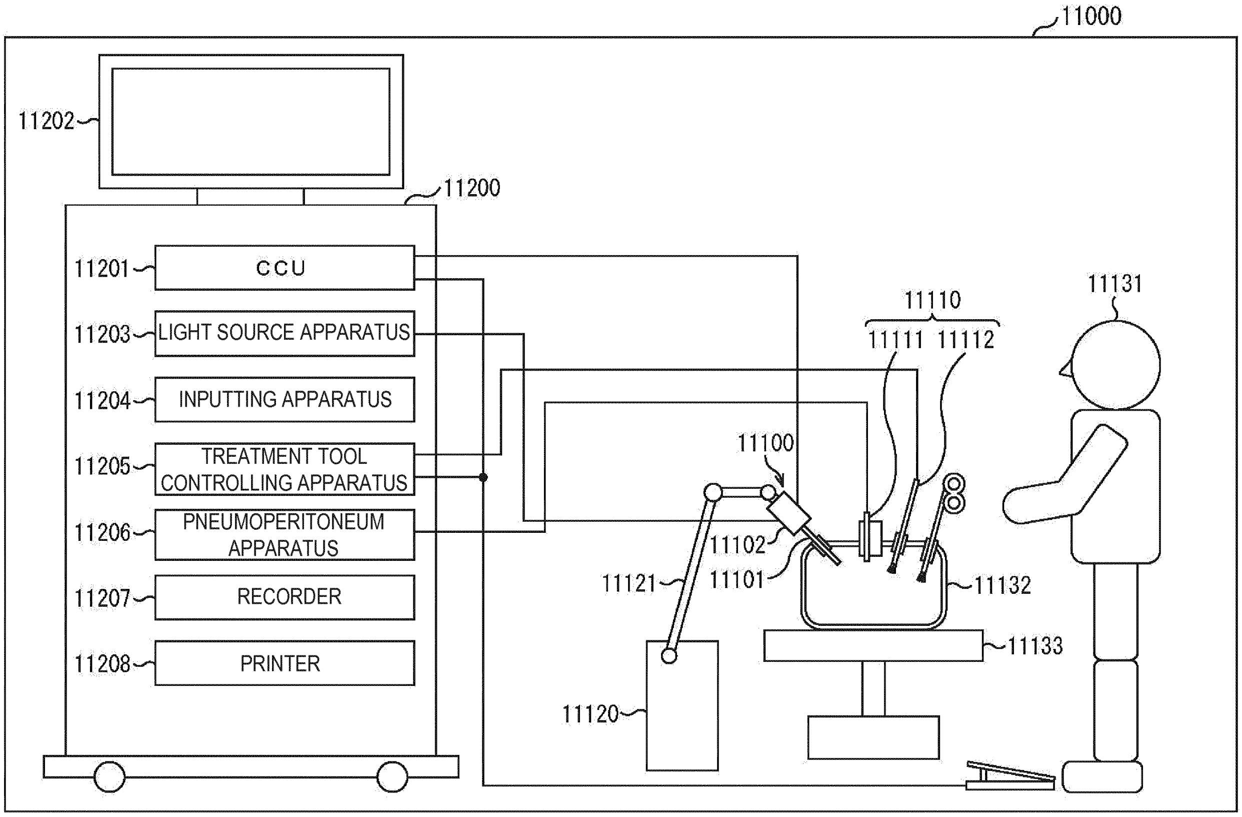
11000
11202
11200
11201
CCU
11203
LIGHT SOURCE APPARATUS
11204
INPUTTING APPARATUS
11205
TREATMENT TOOL CONTROLLING APPARATUS
11206
PNEUMOPERITONEUM APPARATUS
11207
RECORDER
11208
PRINTER
11110
11111 11112
11131
11100
11102
11101
11121
11132
11133
11120

FIG. 20

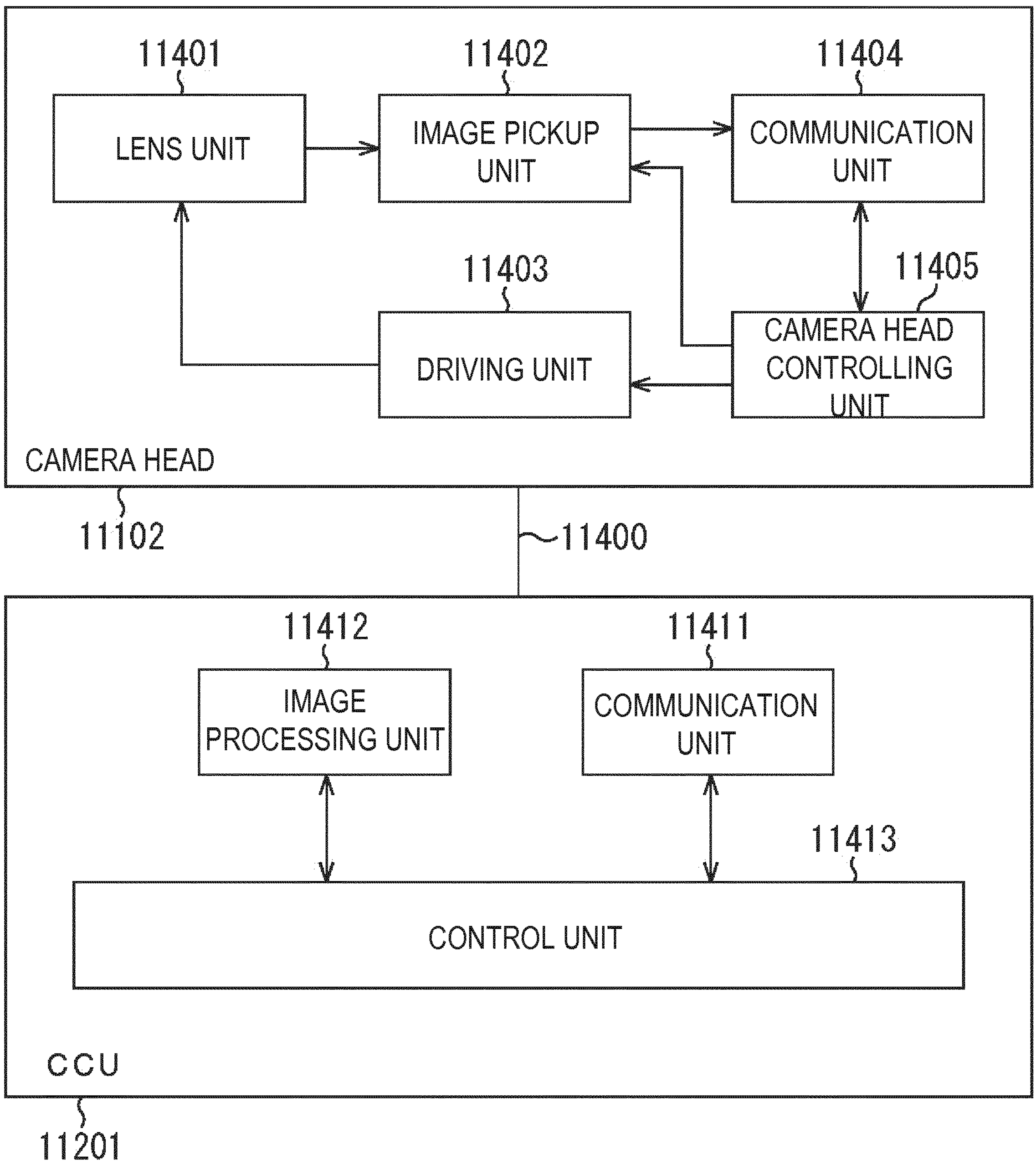
11401
LENS UNIT
11402
IMAGE PICKUP UNIT
11404
COMMUNICATION UNIT
11403
DRIVING UNIT
11405
CAMERA HEAD CONTROLLING UNIT
CAMERA HEAD
11102
11400
11412
IMAGE PROCESSING UNIT
11411
COMMUNICATION UNIT
11413
CONTROL UNIT
CCU
11201

**FIG. 21**

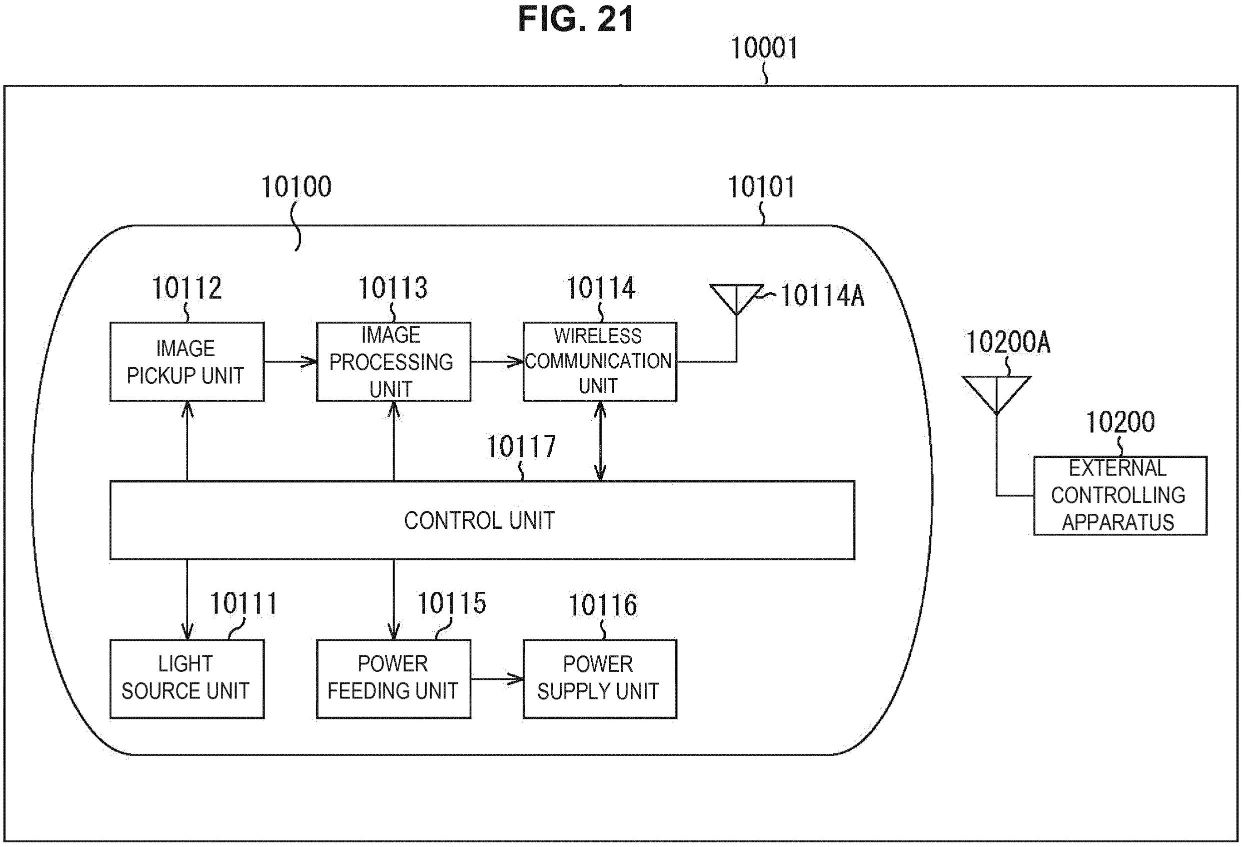
10001
10100
10101
10112
10113
10114
10114A
IMAGE PICKUP UNIT
IMAGE PROCESSING UNIT
WIRELESS COMMUNICATION UNIT
10200A
10200
10117
EXTERNAL CONTROLLING APPARATUS
CONTROL UNIT
10111
10115
10116
LIGHT SOURCE UNIT
POWER FEEDING UNIT
POWER SUPPLY UNIT

**INTERNATIONAL SEARCH REPORT**

International application No.
PCT/JP2017/023628

A. CLASSIFICATION OF SUBJECT MATTER
*H01L27/146*(2006.01)i, *H01L27/30*(2006.01)i, *H01L51/42*(2006.01)i, *H04N5/369*(2011.01)i

According to International Patent Classification (IPC) or to both national classification and IPC

B. FIELDS SEARCHED

Minimum documentation searched (classification system followed by classification symbols)
H01L27/14-148, H01L27/30, H01L51/42-48, H04N5/335-378

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2017 |
| Kokai Jitsuyo Shinan Koho | 1971-2017 | Toroku Jitsuyo Shinan Koho | 1994-2017 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y | JP 2010-67642 A (Kyoto University), 25 March 2010 (25.03.2010), paragraphs [0002] to [0004], [0016] to [0085]; fig. 1 to 17 (Family: none) | 1-2<br>3-13 |
| Y | JP 2014-154653 A (Ricoh Co., Ltd.), 25 August 2014 (25.08.2014), paragraphs [0001] to [0008], [0013] to [0156]; fig. 1 to 3 (Family: none) | 3,11-13 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 11 September 2017 (11.09.17) | 19 September 2017 (19.09.17) |

| Name and mailing address of the ISA/ | Authorized officer |
|---|---|
| Japan Patent Office<br>3-4-3,Kasumigaseki,Chiyoda-ku,<br>Tokyo 100-8915,Japan | Telephone No. |

Form PCT/ISA/210 (second sheet) (January 2015)

**INTERNATIONAL SEARCH REPORT**

International application No.
PCT/JP2017/023628

C (Continuation). DOCUMENTS CONSIDERED TO BE RELEVANT

| Category* | Citation of document, with indication, where appropriate, of the relevant passages | Relevant to claim No. |
|---|---|---|
| Y | JP 2015-103735 A (Sony Corp.), 04 June 2015 (04.06.2015), paragraphs [0022] to [0024], [0052] to [0088]; fig. 3 to 4, 9 to 11 & US 2016/0293859 A1 paragraphs [0046] to [0048], [0087] to [0126] & WO 2015/079660 A1 & TW 201521252 A & KR 10-2016-0090807 A & CN 105684149 A | 3,10-13 |
| Y | JP 2014-22525 A (Nippon Hoso Kyokai), 03 February 2014 (03.02.2014), paragraphs [0031] to [0077]; fig. 3 to 7 (Family: none) | 4-9,11-13 |

Form PCT/ISA/210 (continuation of second sheet) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2006100766 A